# EUROPEAN PATENT APPLICATION

(11) **EP 4 704 155 A1**
(43) Date of publication of application: **04.03.2026**
(21) Application number: 24796738.3
(22) Date of filing: 04.04.2024
(51) Int. Cl.: H01L 27/146

(54) **SOLID-STATE IMAGING DEVICE AND ELECTRONIC APPARATUS**

(30) Priority: 28.04.2023 JP 2023075177
(71) Applicant: Sony Semiconductor Solutions Corporation, Atsugi-shi, Kanagawa 243-0014 (JP)
(72) Inventor: KOBAYASHI, Hideki, Atsugi-shi, Kanagawa 243-0014 (JP); NITTA, Yosuke, Atsugi-shi, Kanagawa 243-0014 (JP); SAITO, Suguru, Atsugi-shi, Kanagawa 243-0014 (JP); FUJII, Nobutoshi, Atsugi-shi, Kanagawa 243-0014 (JP); ZAIZEN, Yoshifumi, Atsugi-shi, Kanagawa 243-0014 (JP); URATA, Akihiro, Atsugi-shi, Kanagawa 243-0014 (JP); FURUSE, Shunsuke, Atsugi-shi, Kanagawa 243-0014 (JP); SATO, Naoyuki, Atsugi-shi, Kanagawa 243-0014 (JP)
(74) Representative: Müller Hoffmann & Partner
(86) International application number: PCT/JP2024/013936
(87) International publication number: WO 2024/224980

(57) **Abstract**

To more appropriately receive light in an infrared light band.

A solid-state imaging device includes a first pixel, a second pixel, a wiring layer, and an infrared light transmission filter. The first pixel receives light in a visible light band and generates a pixel signal in a visible light band. The second pixel is formed by being stacked with the first pixel, and receives light in an infrared light band transmitted through the first pixel and generates a pixel signal in an infrared light band. The wiring layer is formed between the first pixel and the second pixel and includes a wiring that propagates a signal output from the first pixel. The infrared light transmission filter includes an infrared light transmission filter on a light incident surface of the second pixel.

## Description

### TECHNICAL FIELD

The present disclosure relates to a solid-state imaging device and an electronic apparatus.

### BACKGROUND ART

In the field of image sensors, in addition to the RGB wavelength band of visible light, a technique of acquiring information in an infrared light band, particularly a short wavelength infrared (SWIR) band, at the same timing has been researched and developed. As an example of a configuration of an image sensor that acquires information of the visible light band and the infrared light band, there is a configuration in which information of light in the infrared light band is acquired by a photoelectric conversion unit formed by being stacked on a side opposite to an incident surface of a photoelectric conversion unit that acquires the visible light band.

In this configuration, there is a problem that the light incident on a lower sensor decreases due to the density of wirings for an upper sensor (incident surface side). On the other hand, it is conceivable that the wiring of a pixel that receives visible light includes a material, which transmits light in an infrared band, such as polysilicon, but such a material is more likely to transmit light other than infrared light than a metal wiring.

### CITATION LIST

### PATENT DOCUMENT

Patent Document 1: Japanese Patent Application Laid-Open No. 2013-070030

### SUMMARY OF THE INVENTION

### PROBLEMS TO BE SOLVED BY THE INVENTION

In this regard, one of the non-limiting problems to be solved by the embodiments of the present disclosure is to appropriately receive light in an infrared light band by a pixel that receives infrared light and is formed by being stacked on a pixel that receives visible light. The problem to be solved by the embodiments of the present disclosure can be a problem corresponding to the effects described in the embodiments as some non-limiting examples. That is, the problem corresponding to at least one of the effects described in the description of the embodiments of the present disclosure can be solved in the present disclosure.

### SOLUTIONS TO PROBLEMS

According to one embodiment, a solid-state imaging device includes a first pixel, a second pixel, a wiring layer, and an infrared light transmission filter.

The first pixel receives light in a visible light band and generates a pixel signal in a visible light band.

The second pixel is formed by being stacked with the first pixel, and receives light in an infrared light band transmitted through the first pixel and generates a pixel signal in an infrared light band.

The wiring layer is formed between the first pixel and the second pixel and includes a wiring that propagates a signal output from the first pixel.

The infrared light transmission filter is provided on a light incident surface of the second pixel.

The infrared light transmission filter may be formed between a bonding surface between the wiring layer and the second pixel.

The infrared light transmission filter may be formed in the wiring layer.

The infrared light transmission filter may be formed between a bonding surface between the first pixel and the wiring layer.

The infrared light transmission filter may include a combination of a material having a characteristic of absorbing or reflecting light in a visible light band depending on a wavelength or a material having a characteristic of reflecting the light in the visible light band.

The infrared light transmission filter may be formed by alternately stacking amorphous silicon and silicon dioxide one or more times.

The infrared light transmission filter may include a material having a characteristic of absorbing light in a visible light band.

The infrared light transmission filter may include indium phosphorus.

The infrared light transmission filter may include a transition metal dichalcogenide material.

The infrared light transmission filter may have a thickness of 1 [nm] or more and 200 [nm] or less.

A chalcogenide layer including a transition metal dichalcogenide material may be provided on a light incident surface side of the infrared light transmission filter.

The chalcogenide layer may have a thickness of 1 [nm] or more and 200 [nm] or less.

The transition metal dichalcogenide material may be molybdenum diselenide.

The above-described solid-state imaging device can be manufactured by the following manufacturing method.

A solid-state imaging device is manufactured by a method including a process in which
in a first substrate,
a first pixel that receives visible light is formed, and
a wiring layer including a wiring that propagates a signal of the first pixel is formed on an upper surface of the first pixel,
in a second substrate,
a second pixel that receives infrared light is formed, and
an infrared light transmission filter that transmits infrared light is formed on an upper surface of the second pixel, and
the first substrate and the second substrate are stacked by bonding an upper surface of the wiring layer and an upper surface of the infrared light transmission filter.

Furthermore, according to another example, a solid-state imaging device is manufactured by a method including a process in which
in a first substrate,
a first pixel that receives visible light is formed,
a wiring layer including a wiring that propagates a signal of the first pixel is formed on an upper surface of the first pixel, and
an infrared light transmission filter that transmits infrared light is formed on an upper surface of the wiring layer,
in a second substrate,
a second pixel that receives infrared light is formed, and
the first substrate and the second substrate are stacked by bonding an upper surface of the infrared light transmission filter and an upper surface of the second pixel.

Furthermore, according to another example, a solid-state imaging device is manufactured by a method including a process in which
in a first substrate,
a first pixel that receives visible light is formed,
a wiring layer including a wiring that propagates a signal of the first pixel is formed on an upper surface of the first pixel, and
a first infrared light transmission filter that transmits infrared light is formed on an upper surface of the wiring layer,
in a second substrate,
a second pixel that receives infrared light is formed, and
a second infrared light transmission filter that transmits infrared light is formed on an upper surface of the second pixel, and
the first substrate and the second substrate are stacked by bonding an upper surface of the first infrared light transmission filter and an upper surface of the second infrared light transmission filter.

Furthermore, according to another example, a solid-state imaging device is manufactured by a method including a process in which
in a first substrate,
a first pixel that receives visible light is formed,
a first wiring layer including a wiring that propagates a signal of the first pixel is formed on an upper surface of the first pixel,
an infrared light transmission filter that transmits infrared light is formed on an upper surface of the first wiring layer, and
a second wiring layer that is connected to a wiring of the first wiring layer is formed on an upper surface of the infrared light transmission filter,
in a second substrate,
a second pixel that receives infrared light is formed, and
the first substrate and the second substrate are stacked by bonding an upper surface of the second wiring layer and an upper surface of the second pixel.

Furthermore, according to another example, a solid-state imaging device is manufactured by a method including a process in which
in a first substrate,
a first pixel that receives visible light is formed,
an infrared light transmission filter that transmits infrared light is formed on an upper surface of the first pixel, and
a wiring layer including a wiring that propagates a signal of the first pixel is formed on an upper surface of the infrared light transmission filter,
in a second substrate,
a second pixel that receives infrared light is formed, and
the first substrate and the second substrate are stacked by bonding an upper surface of the wiring layer and an upper surface of the second pixel.

The infrared light transmission filter may be formed by stacking amorphous silicon and silicon dioxide one or more times.

Furthermore, according to another example, a solid-state imaging device is manufactured by a method including a process in which
in a first substrate,
a first pixel that receives visible light is formed, and
a wiring layer including a wiring that propagates a signal of the first pixel is formed on an upper surface of the first pixel,
in a second substrate,
a second pixel that receives infrared light is formed, and
an infrared light transmission filter that transmits infrared light is formed on an upper surface of the second pixel by epitaxial growth, and
the first substrate and the second substrate are stacked by bonding an upper surface of the wiring layer and an upper surface of the infrared light transmission filter.

The infrared light transmission filter may include indium phosphorus.

In the second pixel, a shape of a light receiving region may be formed before the first substrate and the second substrate are stacked.

In the second pixel, a shape of the light receiving region may be formed after the first substrate and the second substrate are stacked.

Furthermore, according to another example, a solid-state imaging device is manufactured by a method including a process in which
in a first substrate,
a first pixel that receives visible light is formed,
in a second substrate,
a second pixel that receives infrared light is formed,
an infrared light transmission filter that transmits infrared light is formed on an upper surface of the second pixel,
a trench is selectively formed in at least the infrared light transmission filter,
an insulating film is formed on a side surface of the infrared light transmission filter of the trench,
a contact is formed inside the insulating film, and
a wiring layer including a wiring that is connected to the contact is formed on an upper surface of the infrared light transmission filter, and
the first substrate and the second substrate are stacked by bonding an upper surface of the first pixel and the wiring layer.

The infrared light transmission filter may include a transition metal chalcogenide material.

The infrared light transmission filter may be formed to have a thickness of 1 [nm] or more and 200 [nm] or less.

Furthermore, according to another example, a solid-state imaging device is manufactured by a method including a process in which
in a first substrate,
a first pixel that receives visible light is formed,
in a second substrate,
a second pixel that receives infrared light is formed,
an infrared light transmission filter that transmits infrared light is formed on an upper surface of the second pixel,
a chalcogenide layer including a transition metal chalcogenide material is formed on an upper surface of the infrared light transmission filter,
a trench selectively is formed at least in the chalcogenide layer,
an insulating film is formed on a side surface of the chalcogenide layer of the trench,
a contact is formed inside the insulating film, and
a wiring layer including a wiring line that is connected to the contact is formed on an upper surface of the chalcogenide layer, and
the first substrate and the second substrate are stacked by bonding an upper surface of the first pixel and the wiring layer.

The infrared light transmission filter may be formed by stacking amorphous silicon and silicon dioxide one or more times.

The infrared light transmission filter may include indium phosphorus.

The chalcogenide layer may be formed to have a thickness of 1 [nm] or more and 200 [nm] or less.

The chalcogenide layer may include a thin film of molybdenum diselenide.

Furthermore, the device according to the embodiment of the present disclosure may have the following form as another aspect.

A solid-state imaging device includes a first pixel, a second pixel, a wiring layer, and an infrared light shielding film.

The first pixel receives light in a visible light band and generates a pixel signal in a visible light band.

The second pixel is formed by being stacked with the first pixel, and receives light in an infrared light band transmitted through the first pixel and generates a pixel signal in an infrared light band.

The wiring layer is formed between the first pixel and the second pixel and includes a wiring that propagates a signal output from the first pixel.

The infrared light shielding film is provided on at least one side surface of the second pixel.

The infrared light shielding film may be formed on a side surface of the photoelectric conversion region of the second pixel via an insulating film.

The infrared light shielding film may include the same material as the contact electrode.

The infrared light shielding film may be formed on the same surface side as the incident surface of the second pixel between the adjacent second pixels.

The infrared light shielding film may be formed on a surface of the photoelectric conversion region of the second pixel on a side opposite to the incident surface of the second pixel.

The second pixels may be formed such that at least two of the second pixels are adjacent to each other, and may include the infrared light shielding film on adjacent side surfaces.

The second pixel may receive a voltage on an incident surface side from a transparent electrode connected to a photoelectric conversion film region of the second pixel, and the transparent electrode may be electrically connected to a contact electrode at a position away from the second pixel.

The second pixel may receive a voltage on an incident surface side from a transparent electrode connected to a photoelectric conversion film region of the second pixel, and the transparent electrode may be electrically connected to a contact electrode at a position in contact with a plurality of the adjacent second pixels via the infrared light shielding film.

The contact electrode may include a material having a light shielding property.

The contact electrode may be copper, titanium, aluminum, or tungsten.

The contact electrode may be shared and used by a plurality of second pixels.

At least one of the infrared light shielding films including the same material as that of the contact electrode may be in an electrically floating state.

At least one of the infrared light shielding films including the same material as that of the contact electrode may be grounded.

In this aspect, at least one of the infrared light transmission filter or the chalcogenide layer described above may be further included.

The above-described solid-state imaging device can be manufactured by the following manufacturing method.

A manufacturing method of a solid-state imaging device including
a first pixel that receives light in a visible light band and generates a pixel signal in a visible light band, and
a second pixel that is formed by being stacked with the first pixel, and receives light in an infrared light band transmitted through the first pixel and generates a pixel signal in an infrared light band, in which
the solid-state imaging device is manufactured by the manufacturing method including a process in which
after a photoelectric conversion region of the second pixel is formed,
a sidewall of the photoelectric conversion region is formed, and
an infrared light shielding film is formed on a side surface of the sidewall of the photoelectric conversion region.

The manufacturing method may include a process in which
after the photoelectric conversion region of the second pixel is formed,
an insulating film is formed on an upper surface and a side surface of the photoelectric conversion region,
an electrode electrically connected to the photoelectric conversion region is formed on the upper surface of the photoelectric conversion region, and a first infrared light shielding film is formed on a side surface of the insulating film on the side surface,
an insulating film is formed on an upper surface of the electrode electrically connected to the photoelectric conversion region and a side surface of the first infrared light shielding film, and
the upper surface and a sidewall of the photoelectric conversion region are formed.

The manufacturing method may include a process in which
after a sidewall of the photoelectric conversion region is formed,
a metal film is formed as a second infrared light shielding film adjacent to the sidewall of the photoelectric conversion region.

The two-infrared light shielding film may be formed at the same timing as formation of an electrode that supplies power to the first pixel or the second pixel.

The manufacturing method may include a process in which
after a sidewall of the photoelectric conversion region is formed,
a metal film is formed as a second infrared light shielding film in a region away from the sidewall of the photoelectric conversion region by a predetermined distance.

The manufacturing method may include a process in which
in a process in which the sidewall of the photoelectric conversion region is formed,
an insulating film is formed on a plane of an incident surface of the photoelectric conversion region,
a first infrared light shielding film is formed on an upper surface of the insulating film on the plane, and
an insulating film is formed on an upper surface of the first infrared light shielding film.

The manufacturing method may include a process in which
at least two of the second pixels are formed adjacent to each other, and
the first infrared light shielding film is formed between the second pixels adjacent to each other.

The manufacturing method may include a process in which
at least two of the second pixels are formed adjacent to each other, and
the second infrared light shielding film is formed between the second pixels adjacent to each other.

The manufacturing method may include a process in which
after sidewalls of the photoelectric conversion region and the photoelectric conversion region are formed,
an insulating film is formed on a surface opposite to an incident surface of the photoelectric conversion region, and
the first infrared light shielding film is formed on an upper surface of the insulating film.

The solid-state imaging device may be manufactured by the method including a process in which at least one of the infrared light transmission filter or the chalcogenide layer described above is formed.

Furthermore, the device according to the embodiment of the present disclosure may have the following form as another aspect.

A solid-state imaging device includes a first pixel, a second pixel, and a wiring layer.

The first pixel has a first photoelectric conversion region that receives light in a visible light band and generates a pixel signal in a visible light band.

The second pixel is formed by being stacked with the first pixel, and includes a second photoelectric conversion region that receives light in an infrared light band transmitted through the first pixel and generates a pixel signal in an infrared light band.

The wiring layer is formed between the first pixel and the second pixel and includes a wiring that propagates a signal output from the first pixel.

The wiring layer includes
for the first pixel and second pixel that are stacked, the wiring in a region not between the first photoelectric conversion region and the second photoelectric conversion region.

The wiring may be metal.

The wiring layer may not include, for the first pixel and the second pixel that are stacked, the wiring between the first photoelectric conversion region and the second photoelectric conversion region.

The wiring layer may include, for the first pixel and the second pixel that are stacked, a hole that transmits light in an infrared light band transmitted through the first pixel between the first photoelectric conversion region and the second photoelectric conversion region.

The hole may have an antireflection film.

The hole may have a film different from an insulating film filling the wiring layer.

The film of the hole which is different from the insulating film filling the wiring layer may be a semiconductor film.

The hole may totally reflect infrared light at a boundary with the insulating film filling the wiring layer.

The hole may have a rectangular shape in a cross section.

The hole may have an elliptical shape or a rounded rectangular shape in a cross section.

The hole may have a rectangular shape having a taper in a cross section.

In the wiring layer, an uneven shape may be further formed by an insulating film of a different material.

The solid-state imaging device may further include at least one of at least one of the infrared light transmission filter or the chalcogenide layer according to any one of the above, or the infrared light transmission film according to any one of the above.

The above-described solid-state imaging device can be manufactured by the following manufacturing method.

A manufacturing method of a solid-state imaging device including
a first pixel that receives light in a visible light band and generate a pixel signal in a visible light band,
a second pixel that is formed by being stacked with the first pixel, and receives light in an infrared light band transmitted through the first pixel and generates a pixel signal in an infrared light band, in which
the solid-state imaging device is manufactured by the manufacturing method including a process in which
in a wiring layer that is arranged between the first pixel and the second pixel,
a wiring that propagates a signal from the first pixel is formed so as not to overlap with an incident surface of a photoelectric conversion region of the second pixel.

The manufacturing method may include a process in which
in the wiring layer,
a hole is formed so as to overlap with the incident surface of the photoelectric conversion region of the second pixel.

The manufacturing method may include a process in which
in the wiring layer,
a metal wiring is formed in a region where the wiring is to be formed, and a dummy metal wiring is formed in a region where the hole is to be formed,
an insulating film is formed on upper surfaces of the region where the wiring is to be formed and the region where the hole is to be formed, and
the dummy metal wiring is selectively removed.

The selective removal may include a process in which
the insulating film that is formed on the upper surfaces of the region where the wiring is to be formed and the region where the hole is to be formed is selectively removed in at least a partial region of the region where the hole is to be formed, and
the dummy metal wiring that is formed in the region where the hole is to be formed is removed by performing etching processing from a region where the insulating film is selectively removed.

The region where the wiring is to be formed may be formed so as not to be connected to the at least partial region, and the region where the hole is to be formed may be formed so as to be connected to the at least partial region.

The manufacturing method may include a process in which
the wiring is formed by
selectively removing an insulating film in a region where the wiring is to be formed,
forming a barrier metal in a region of the removed insulating film, and
forming the metal wiring in the region of the removed insulating film via the barrier metal.

The manufacturing method may include a process in which
the hole is formed by
selectively removing an insulating film in a region where the hole is to be formed, in the process of forming the wiring,
forming the barrier metal in a region of the removed insulating film,
forming the dummy metal wiring in a region of the removed insulating film via the barrier metal, and
removing the dummy metal wiring, and
the barrier metal may be an antireflection film.

The manufacturing method may include a process in which
the hole is formed by
selectively removing an insulating film in a region where the hole is to be formed, in the process of forming the wiring,
forming the barrier metal in a region of the removed insulating film,
forming the dummy metal wiring in a region of the removed insulating film via the barrier metal, and
removing the dummy metal wiring and the barrier metal.

The manufacturing method may include a process in which
an antireflection film is formed in the formed hole.

The manufacturing method may include a process in which
an insulating film of an insulating material different from that of the insulating film forming the wiring layer is formed in the hole.

The wiring and the hole may be formed over a plurality of stages.

The manufacturing method may include a process in which
the hole
is removed at the same timing over a plurality of stages.

The manufacturing method may include a process in which
the hole
is removed at every stage.

The manufacturing method may include a process in which
in at least an uppermost portion in the hole formed in a plurality of stages,
an insulating film of a material different from the insulating film filling the wiring layer is formed.

The hole may have a rectangular shape in a cross section.

The hole may have an elliptical shape or a rounded rectangular shape in a cross section.

The hole may have a rectangular shape having a taper in a cross section.

The solid-state imaging device may be manufactured by the method including a process in which at least one of at least one of the infrared light transmission filter or the chalcogenide layer according to any one of the above, or the infrared light transmission film according to any one of the above is manufactured.

Furthermore, the device according to the embodiment of the present disclosure may have the following form as another aspect.

A solid-state imaging device includes a first pixel, a second pixel, and a wiring layer.

The first pixel receives light in a visible light band and generates a pixel signal in a visible light band.

The second pixel is formed by being stacked with the first pixel, and receives light in an infrared light band transmitted through the first pixel and generates a pixel signal in an infrared light band.

The wiring layer is formed between the first pixel and the second pixel and includes a wiring that propagates a signal output from the first pixel.

The second pixel includes
a first electrode that is located on an incident surface side of the photoelectric conversion region, and
a second electrode that is located on a surface opposite to the incident surface of the photoelectric conversion region.

The first electrode may be a transparent electrode.

The first electrode may be a semiconductor film.

The first electrode may be a metal electrode.

A first contact that is connected to the first pixel, supplies power to the first pixel, or acquires a signal from the first pixel may be further included, and the first contact may be formed in an element isolation portion between the second photoelectric conversion regions.

A second contact that is connected to the first electrode may be further included, and the second contact may be formed in an element isolation portion between the second photoelectric conversion regions.

Each of the second pixels may include the separate second photoelectric conversion region.

A plurality of the second pixels may share the second photoelectric conversion region, or may be formed in an element isolation portion between the second photoelectric conversion regions.

The solid-state imaging device may further include at least one of at least one of the infrared light transmission filter or the chalcogenide layer according to any one of the above, the infrared light transmission film according to any one of the above, or a configuration of the wiring layer according to any one of the above.

The above-described solid-state imaging device can be manufactured by the following manufacturing method.

A manufacturing method of a solid-state imaging device including
a first pixel that receives light in a visible light band and generate a pixel signal in a visible light band,
a second pixel that is formed by being stacked with the first pixel, and receives light in an infrared light band transmitted through the first pixel and generates a pixel signal in an infrared light band, in which
the solid-state imaging device is manufactured by the manufacturing method including a process in which
after a photoelectric conversion region in the second pixel is formed,
a first electrode is formed on an upper surface of the photoelectric conversion region,
an insulating film is formed on an upper surface of the first electrode,
a vertical inversion is performed such that the insulating film faces downward,
the photoelectric conversion region is selectively removed,
the first electrode is selectively removed in a region from which the photoelectric conversion region has been selectively removed,
an insulator layer is formed in the photoelectric conversion region selectively removed and a region of the first electrode selectively removed, and
a contact electrically connected to the first electrode is formed in the insulator layer.

As another example,
a manufacturing method of a solid-state imaging device including
a first pixel that receives light in a visible light band and generate a pixel signal in a visible light band,
a second pixel that is formed by being stacked with the first pixel, and receives light in an infrared light band transmitted through the first pixel and generates a pixel signal in an infrared light band, in which
the solid-state imaging device is manufactured by the manufacturing method including a process in which
after a photoelectric conversion region in the second pixel is formed,
a first electrode is formed on an upper surface of the photoelectric conversion region,
an insulating film is formed on an upper surface of the first electrode,
a vertical inversion is performed such that the insulating film faces downward,
the photoelectric conversion region and the first electrode are selectively removed,
an insulator layer is formed in a region selectively removed,
a contact is formed in the insulator layer,
a vertical inversion is performed again such that the insulating film faces upward, and
a third electrode electrically connected to the contact and the first electrode is formed.

The manufacturing method may include a process in which
after the vertical inversion is performed such that the insulating film faces downward,
a second electrode is selectively formed on the upper surface of the photoelectric conversion region.

The first electrode may be a transparent electrode.

The transparent electrode may be a semiconductor film.

The transparent electrode may be a metal electrode.

The solid-state imaging device may be manufactured by the method including a process of manufacturing at least one of at least one of the infrared light transmission filter or the chalcogenide layer according to any one of the above, the infrared light transmission film according to any one of the above, or the wiring layer formed between the first pixel and the second pixel according to any one of the above.

Furthermore, the device according to the embodiment of the present disclosure may have the following form as another aspect.

A solid-state imaging device includes a first pixel, a second pixel, and a wiring layer.

The first pixel has a first photoelectric conversion region that receives light in a visible light band and generates a pixel signal in a visible light band.

The second pixel is formed by being stacked with the first pixel, and includes a second photoelectric conversion region that receives light in an infrared light band transmitted through the first pixel and generates a pixel signal in an infrared light band.

The wiring layer is formed between the first pixel and the second pixel and includes a wiring that propagates a signal output from the first pixel.

The wiring layer includes
for the first pixel and second pixel which are stacked, the wiring below the element isolation portion of the first pixel.

The wiring that propagates the signal from the first pixel may be formed above the pixel isolation portion of the second pixel.

The wiring that propagates the signal from the first pixel may be output via a contact formed at an end portion of a region where the second pixel is arranged.

The wiring that propagates the signal from the first pixel may be output via a contact formed in the pixel isolation of the second pixel.

The element isolation portion of the first pixel may be RDTI.

The element isolation portion of the first pixel may be RDTI in which metal is embedded.

The number of the first pixels stacked on one of the second pixel may be plural.

The solid-state imaging device may further include at least one of at least one of the infrared light transmission filter or the chalcogenide layer according to any one of the above, the infrared light transmission film according to any one of the above, a configuration of the wiring layer according to any one of the above, or the first electrode and the second electrode according to any one of the above.

The above-described solid-state imaging device can be manufactured by the following manufacturing method.

A manufacturing method of a solid-state imaging device including
a first pixel that receives light in a visible light band and generate a pixel signal in a visible light band,
a second pixel that is formed by being stacked with the first pixel, and receives light in an infrared light band transmitted through the first pixel and generates a pixel signal in an infrared light band, in which
the solid-state imaging device is manufactured by the manufacturing method including a process in which
in a wiring layer that is arranged between the first pixel and the second pixel,
a wiring that propagates a signal from the first pixel is formed so as to overlap with an element isolation portion of the first pixel.

The solid-state imaging device may be manufactured by the method including a process of manufacturing at least one of at least one of the infrared light transmission filter or the chalcogenide layer according to any one of the above, the infrared light transmission film according to any one of the above, the wiring layer formed between the first pixel and the second pixel according to any one of the above, or the first electrode and the second electrode according to any one of the above.

### BRIEF DESCRIPTION OF DRAWINGS

Fig. 1 is a block diagram schematically illustrating an example of a solid-state imaging device according to one embodiment.
Fig. 2 is a diagram schematically illustrating an example of a sensor unit according to one embodiment.
Fig. 3 is a diagram illustrating an example of a cross section of the sensor unit according to one embodiment.
Fig. 4 is a diagram illustrating an example of the cross section of the sensor unit according to one embodiment.
Fig. 5 is a diagram illustrating an example of the cross section of the sensor unit according to one embodiment.
Fig. 6 is a diagram illustrating an example of the cross section of the sensor unit according to one embodiment.
Fig. 7 is a diagram illustrating an example of the cross section of the sensor unit according to one embodiment.
Fig. 8 is a diagram illustrating an example of a manufacturing process of the sensor unit according to one embodiment.
Fig. 9 is a diagram illustrating an example of the manufacturing process of the sensor unit according to one embodiment.
Fig. 10 is a diagram illustrating an example of the manufacturing process of the sensor unit according to one embodiment.
Fig. 11 is a diagram illustrating an example of the manufacturing process of the sensor unit according to one embodiment.
Fig. 12 is a diagram illustrating an example of the manufacturing process of the sensor unit according to one embodiment.
Fig. 13 is a diagram illustrating an example of the manufacturing process of the sensor unit according to one embodiment.
Fig. 14 is a diagram illustrating an example of the manufacturing process of the sensor unit according to one embodiment.
Fig. 15 is a diagram illustrating an example of the manufacturing process of the sensor unit according to one embodiment.
Fig. 16 is a diagram illustrating an example of the manufacturing process of the sensor unit according to one embodiment.
Fig. 17 is a diagram illustrating an example of the manufacturing process of the sensor unit according to one embodiment.
Fig. 18 is a diagram illustrating an example of the manufacturing process of the sensor unit according to one embodiment.
Fig. 19 is a diagram illustrating an example of the manufacturing process of the sensor unit according to one embodiment.
Fig. 20 is a diagram illustrating an example of the manufacturing process of the sensor unit according to one embodiment.
Fig. 21 is a diagram illustrating an example of the manufacturing process of the sensor unit according to one embodiment.
Fig. 22 is a diagram illustrating an example of the manufacturing process of the sensor unit according to one embodiment.
Fig. 23 is a diagram illustrating an example of the manufacturing process of the sensor unit according to one embodiment.
Fig. 24 is a diagram illustrating an example of the manufacturing process of the sensor unit according to one embodiment.
Fig. 25 is a diagram illustrating an example of the manufacturing process of the sensor unit according to one embodiment.
Fig. 26 is a diagram illustrating an example of the manufacturing process of the sensor unit according to one embodiment.
Fig. 27 is a diagram illustrating an example of the manufacturing process of the sensor unit according to one embodiment.
Fig. 28 is a diagram illustrating an example of a top view of the sensor unit according to one embodiment.
Fig. 29 is a diagram illustrating an example of the cross section of the sensor unit according to one embodiment.
Fig. 30 is a diagram illustrating an example of the cross section of the sensor unit according to one embodiment.
Fig. 31 is a diagram illustrating an example of the cross section of the sensor unit according to one embodiment.
Fig. 32 is a diagram illustrating an example of the manufacturing process of the sensor unit according to one embodiment.
Fig. 33 is a diagram illustrating an example of the manufacturing process of the sensor unit according to one embodiment.
Fig. 34 is a diagram illustrating an example of the manufacturing process of the sensor unit according to one embodiment.
Fig. 35 is a diagram illustrating an example of the manufacturing process of the sensor unit according to one embodiment.
Fig. 36 is a diagram illustrating an example of the cross section of the sensor unit according to one embodiment.
Fig. 37 is a diagram illustrating an example of the cross section of the sensor unit according to one embodiment.
Fig. 38 is a diagram illustrating an example of the cross section of the sensor unit according to one embodiment.
Fig. 39 is a diagram illustrating an example of the cross section of the sensor unit according to one embodiment.
Fig. 40 is a diagram illustrating an example of the cross section of the sensor unit according to one embodiment.
Fig. 41 is a diagram illustrating an example of the cross section of the sensor unit according to one embodiment.
Fig. 42 is a diagram illustrating an example of the cross section of the sensor unit according to one embodiment.
Fig. 43 is a diagram illustrating an example of the cross section of the sensor unit according to one embodiment.
Fig. 44 is a diagram illustrating an example of the top view of the sensor unit according to one embodiment.
Fig. 45 is a diagram illustrating an example of the top view of the sensor unit according to one embodiment.
Fig. 46 is a diagram illustrating an example of the cross section of the sensor unit according to one embodiment.
Fig. 47 is a diagram illustrating an example of the cross section of the sensor unit according to one embodiment.
Fig. 48 is a diagram illustrating an example of the cross section of the sensor unit according to one embodiment.
Fig. 49 is a diagram illustrating an example of the cross section of the sensor unit according to one embodiment.
Fig. 50 is a diagram illustrating an example of the cross section of the sensor unit according to one embodiment.
Fig. 51 is a diagram illustrating an example of the cross section of the sensor unit according to one embodiment.
Fig. 52 is a diagram illustrating an example of the cross section of the sensor unit according to one embodiment.
Fig. 53 is a diagram illustrating an example of the cross section of the sensor unit according to one embodiment.
Fig. 54 is a diagram illustrating an example of the cross section of the sensor unit according to one embodiment.
Fig. 55 is a diagram illustrating an example of the cross section of the sensor unit according to one embodiment.
Fig. 56 is a diagram illustrating an example of the cross section of the sensor unit according to one embodiment.
Fig. 57 is a diagram illustrating an example of the manufacturing process of the sensor unit according to one embodiment.
Fig. 58 is a diagram illustrating an example of the manufacturing process of the sensor unit according to one embodiment.
Fig. 59 is a diagram illustrating an example of the manufacturing process of the sensor unit according to one embodiment.
Fig. 60 is a diagram illustrating an example of the manufacturing process of the sensor unit according to one embodiment.
Fig. 61 is a diagram illustrating an example of the manufacturing process of the sensor unit according to one embodiment.
Fig. 62 is a diagram illustrating an example of the manufacturing process of the sensor unit according to one embodiment.
Fig. 63 is a diagram illustrating an example of the manufacturing process of the sensor unit according to one embodiment.
Fig. 64 is a diagram illustrating an example of the manufacturing process of the sensor unit according to one embodiment.
Fig. 65 is a diagram illustrating an example of the manufacturing process of the sensor unit according to one embodiment.
Fig. 66 is a diagram illustrating an example of the manufacturing process of the sensor unit according to one embodiment.
Fig. 67 is a diagram illustrating an example of the manufacturing process of the sensor unit according to one embodiment.
Fig. 68 is a diagram illustrating an example of the manufacturing process of the sensor unit according to one embodiment.
Fig. 69 is a diagram illustrating an example of the manufacturing process of the sensor unit according to one embodiment.
Fig. 70 is a diagram illustrating an example of the cross section of the sensor unit according to one embodiment.
Fig. 71 is a diagram illustrating an example of the cross section of the sensor unit according to one embodiment.
Fig. 72 is a diagram illustrating an example of the cross section of the sensor unit according to one embodiment.
Fig. 73 is a diagram illustrating an example of the cross section of the sensor unit according to one embodiment.
Fig. 74 is a diagram illustrating an example of the cross section of the sensor unit according to one embodiment.
Fig. 75 is a diagram illustrating an example of the manufacturing process of the sensor unit according to one embodiment.
Fig. 76 is a diagram illustrating an example of the manufacturing process of the sensor unit according to one embodiment.
Fig. 77 is a diagram illustrating an example of the manufacturing process of the sensor unit according to one embodiment.
Fig. 78 is a diagram illustrating an example of the manufacturing process of the sensor unit according to one embodiment.
Fig. 79 is a diagram illustrating an example of the manufacturing process of the sensor unit according to one embodiment.
Fig. 80 is a diagram illustrating an example of the manufacturing process of the sensor unit according to one embodiment.
Fig. 81 is a diagram illustrating an example of the manufacturing process of the sensor unit according to one embodiment.
Fig. 82 is a diagram illustrating an example of the manufacturing process of the sensor unit according to one embodiment.
Fig. 83 is a diagram illustrating an example of the manufacturing process of the sensor unit according to one embodiment.
Fig. 84 is a diagram illustrating an example of the manufacturing process of the sensor unit according to one embodiment.
Fig. 85 is a diagram illustrating an example of the manufacturing process of the sensor unit according to one embodiment.
Fig. 86 is a diagram illustrating an example of the manufacturing process of the sensor unit according to one embodiment.
Fig. 87 is a diagram illustrating an example of the manufacturing process of the sensor unit according to one embodiment.
Fig. 88 is a diagram illustrating an example of the manufacturing process of the sensor unit according to one embodiment.
Fig. 89 is a diagram illustrating an example of the manufacturing process of the sensor unit according to one embodiment.
Fig. 90 is a diagram illustrating an example of the manufacturing process of the sensor unit according to one embodiment.
Fig. 91 is a diagram illustrating an example of the cross section of the sensor unit according to one embodiment.
Fig. 92 is a diagram illustrating an example of the cross section of the sensor unit according to one embodiment.
Fig. 93 is a diagram illustrating an example of the cross section of the sensor unit according to one embodiment.
Fig. 94 is a diagram illustrating an example of the cross section of the sensor unit according to one embodiment.
Fig. 95 is a diagram illustrating an example of the top view of the sensor unit according to one embodiment.

### MODE FOR CARRYING OUT THE INVENTION

The following is a description of embodiments of the present disclosure, with reference to the drawings. The drawings are used for description, and the shape and size of the configuration of each unit in the actual device, the ratio of the size to other configurations, and the like are not necessarily as illustrated in the drawings. For example, the ratio of the thickness of each semiconductor layer, the ratio of the width and the length of a wiring and the like in the drawings are changed to ratios that are easy to understand for the sake of description. Furthermore, since the drawings are illustrated in a simplified manner, configurations necessary for implementation other than those illustrated in the drawings are appropriately provided.

For example, in the present disclosure, various diffusion layers, insulating films, semiconductor films, conductor films, and the like are not illustrated in the drawings and the description in a photoelectric conversion region (light receiving region, photo diode) including a material such as silicon or indium gallium arsenide of light receiving pixels. However, it is assumed that the light receiving pixels of the image sensor appropriately include such necessary configurations or are provided with configurations through with appropriate manufacturing processes.

The present disclosure will be described with the following configuration.
1. Basic configuration of solid-state imaging device
2. First embodiment: configuration in which sensor unit includes infrared light transmission filter
3. Modification: another example of position of infrared light transmission filter
4. Manufacturing process of sensor provided with infrared light transmission filter
5. Second embodiment: configuration in which sensor unit includes chalcogenide material
6. Manufacturing process of sensor including chalcogenide material
7. Third embodiment: configuration of light shielding wall of pixel for receiving infrared light
8. Modification: another example of light shielding wall
9. Manufacturing process of sensor including light shielding wall
10. Fourth embodiment: configuration of sensor including hole in wiring layer
11. Modification: another example of hole
12. Manufacturing process of sensor including hole
13. Fifth embodiment: configuration of electrode arrangement in second pixel
14. Modification: another example of electrode arrangement
15. Manufacturing process of electrode in second pixel
16. Sixth embodiment: configuration of arrangement of first pixel and wiring
17. Modification
18. Manufacturing process of first pixel and wiring

### <1. Basic configuration of solid-state imaging device>

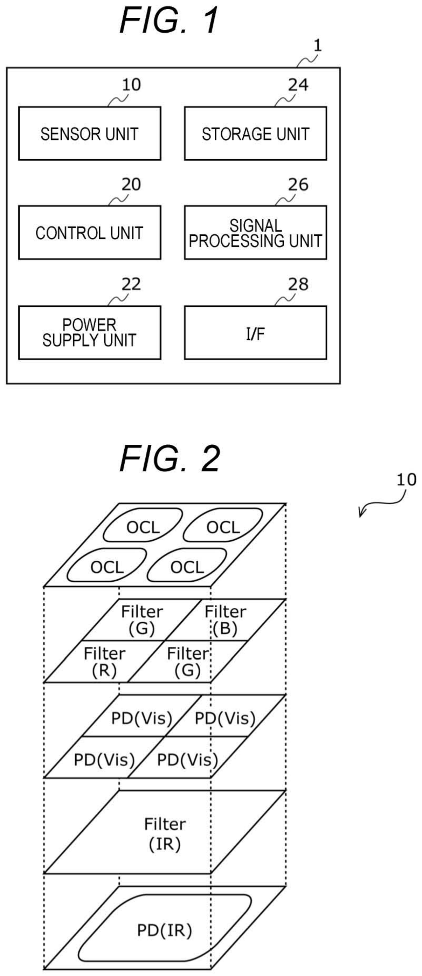

Fig. 1 is a block diagram schematically illustrating a solid-state imaging device according to one embodiment. A solid-state imaging device 1 includes, for example, a sensor unit 10, a control unit 20, a power supply unit 22, a storage unit 24, a signal processing unit 26, and an interface (hereinafter, referred to as an I/F 28). In addition, the solid-state imaging device 1 can appropriately include other components necessary for its own operation. The solid-state imaging device 1 is a device that performs imaging in a visible light band and imaging in an infrared light band, particularly in a short-wave infrared light band, at the same timing.

The sensor unit 10 includes a first pixel including a photoelectric conversion element that receives light in the visible light band and outputs a signal, and a second pixel including a photoelectric conversion element that receives light in an infrared light band and outputs a signal. The configuration of each pixel is not limited. Furthermore, the exposure method of the pixel is not particularly limited. Furthermore, other configurations such as a configuration of a lens associated with the pixel are not limited within a range not technically contradictory to the present disclosure.

The first pixel outputs, for example, a signal based on the intensity of light with respect to visible light of each color incident via an RGB color filter (the configuration of other color filters is not excluded). The first pixel includes, for example, a photo diode (PD) that receives light in the visible light band as the photoelectric conversion element.

As another example, the first pixel may not include the color filter and the photo diode, but may include an organic photoelectric conversion film corresponding to each color.

The second pixel outputs a signal based on the intensity of the incident light in the infrared band. The second pixel includes, for example, a photo diode that receives light in the infrared band as the photoelectric conversion element.

The first pixel and the second pixel are formed by stacking. That is, the second pixel receives the infrared light transmitted through the wiring layer for the first pixel and the first pixel, and outputs a signal corresponding to the intensity of the received infrared light.

The sensor unit 10 appropriately outputs the signal corresponding to the acquired visible light and the signal corresponding to acquired infrared light to the storage unit 24 or the signal processing unit 26.

The control unit 20 controls each component of the solid-state imaging device 1.

The power supply unit 22 supplies necessary power to each component of the solid-state imaging device 1.

The storage unit 24 stores data such as the data acquired by the sensor unit 10, data subjected to signal processing by the signal processing unit 26, or data required for processing by the signal processing unit 26. The storage unit 24 may include, for example, an arbitrary storage medium such as a memory, a storage, a hard disk, a solid-state drive (SSD), or a storage medium using another flash memory.

The signal processing unit 26 executes appropriate processing on the signal output from the sensor unit 10. For example, the signal processing unit 26 can perform signal processing on the signal itself output from the sensor unit 10, convert the signal output from the sensor unit 10 into an image signal and perform image processing on the image signal, or perform various types of processing on image data.

The processing of the signal processing unit 26 may be processing in which information processing by software is specifically realized using hardware resources. In this case, the data related to the software can be stored in the storage unit 24.

The I/F 28 is an interface that connects the inside and the outside of the solid-state imaging device 1. The I/F 28 may include, for example, an arbitrary input/output interface such as a network interface or a universal serial bus (USB) that outputs data in the solid-state imaging device 1 to the outside or inputs a request from the outside as a signal.

Furthermore, the I/F 28 may include a button that directly accepts a request from a user, an input user interface such as a touch panel, a microphone, a keyboard, a mouse, or a trackball, or an output user interface such as a display or a speaker.

Next, the sensor unit 10 will be described in more detail.

Fig. 2 is a diagram schematically illustrating a non-limiting example of the sensor unit according to one embodiment. The sensor unit 10 includes, for example, an on-chip lens (OCL), a color filter (filter (G)/(B)/(R)), a visible light photoelectric conversion element (PD (Vis)), an infrared light transmission filter (filter (IR)), and an infrared light photoelectric conversion element (PD (IR)).

The on-chip lens collects light appropriately incident on a visible light filter forming the first pixel and a visible light receiving element.

The first pixel includes the visible light filter and a photoelectric conversion element for visible light. The first pixel outputs, by photoelectric conversion, a signal corresponding to the intensity of light received by the photoelectric conversion element via the visible light filter corresponding to a wavelength of each color.

The second pixel includes a photoelectric conversion element for infrared light. The second pixel outputs, by photoelectric conversion, a signal corresponding to the intensity of light received by the photoelectric conversion element via the infrared light transmission filter corresponding to a wavelength of infrared light.

The signals acquired by the stacked first pixel and second pixel are not shifted in planar position. Therefore, it is possible to acquire the visible light image and the infrared light image with less coordinate shift between the first pixel and the second pixel.

Note that Fig. 2 is illustrated as a non-limiting example, and other configurations are not excluded. According to Fig. 2, the sensor unit 10 includes the second pixels for every 2×2 first pixels, but the number of first pixels with respect to the second pixel is not limited, and may be, for example, one first pixel for 3×3 second pixels, or 2×3 first pixels for the second pixel. Furthermore, according to Fig. 2, the sensor unit 10 includes one on-chip lens for one first pixel, but the ratio of the number of on-chip lenses is not limited to 1:1.

### <2. First embodiment: configuration in which sensor unit includes infrared light transmission filter>

The first pixel, the infrared light transmission filter, and the second pixel described above will be described in detail with reference to the drawings.

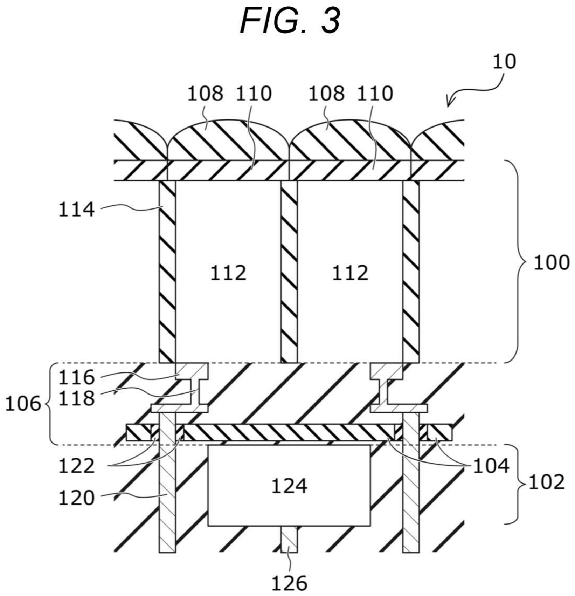

Fig. 3 is a diagram illustrating an example of a cross section of the sensor unit according to one embodiment. The sensor unit 10 includes a first pixel 100, a second pixel 102, an infrared light transmission filter 104, and a wiring layer 106 as layers, and is formed by stacking the first pixel 100, the second pixel 102, the infrared light transmission filter 104, and the wiring layer 106. A dotted line indicates an interface (bonding surface) between the first pixel 100 and the wiring layer 106 or an interface (bonding surface) between the wiring layer 106 and the second pixel 102.

The first pixel 100 includes a color filter 110 and a first photoelectric conversion region 112. The first pixel 100 acquires information on the intensity of light based on the color of the wavelength transmitted by the color filter 110. In the drawings, a pixel transistor 116 is not included in the first pixel 100, but the pixel transistor 116 may be considered as a component of the first pixel 100.

The first photoelectric conversion region 112 is formed, as necessary, via an insulating film 122 or a reflecting film between adjacent first photoelectric conversion regions 112 to prevent color mixing. The on-chip lens 108 appropriately condenses the incident light to the first photoelectric conversion region 112 via the color filter 110.

The first photoelectric conversion region 112 outputs a signal according to the intensity of the incident light. The signal is appropriately output to the storage unit 24, the signal processing unit 26, and the like via a wiring 118 formed in the wiring layer 106 at an appropriate timing via the pixel transistor 116 belonging to the first pixel 100 and a contact 120 passing through a region where the second pixel is formed from the wiring layer 106.

Note that in the following, the term "contact" refers to a conductor such as metal that supplies power to an electrically connected electrode or an electrode including a semiconductor material. Furthermore, in the case of being described as the contact, although not illustrated in the drawings, an insulating film may be formed such that the contact and the surroundings are not electrically connected at a portion that is not electrically connected as necessary.

A light shielding film 114 is appropriately arranged as necessary such that light does not leak from the first photoelectric conversion region 112 to another first photoelectric conversion region 112 in the first pixel 100. The light shielding film 114 may be an absorption film that absorbs light, a reflecting film that reflects light, or a combination thereof.

As an example, polysilicon (Poly-Si) that transmits light in a relatively infrared light band may be used as the wiring 118.

The infrared light transmission filter 104 is provided on a bonding surface between the wiring layer 106 and the second pixel 102. The infrared light transmission filter 104 transmits light in the infrared light band among the light transmitted by the first pixel 100, and causes the light to be incident on a second photoelectric conversion region 124 of the second pixel 102.

The infrared light transmission filter 104 includes a material having a characteristic of absorbing or reflecting light having a wavelength in the visible light band depending on a wavelength band, or a combination of materials.

In the second pixel 102, light incident on the second photoelectric conversion region 124 via the infrared light transmission filter 104 is converted into a signal by photoelectric conversion and output via the contact 126. An oxide film (not illustrated) is provided on the upper surface and the lower surface of the second pixel 102 as necessary. The oxide film may be a tetra ethoxy silane (TEOS) film.

The first photoelectric conversion region 112 is formed using silicon, for example. The second photoelectric conversion region 124 is formed using indium gallium arsenide (InGaAs), for example.

The infrared light transmission filter 104 may be formed, for example, by stacking, one or more times, an amorphous silicon (a-Si) film that is a film having a relatively high refractive index and a silicon dioxide (SiO₂) film that is a film having a refractive index lower than that of the amorphous silicon (a-Si) film. The infrared light transmission filter 104 is formed, for example, by alternately stacking a plurality of a-Si layers and a plurality of SiO₂ layers a plurality of times.

As another example, in the infrared light transmission filter 104, a film having a high refractive index may be formed using a material such as Poly-Si, titanium dioxide (TiO₂), niobium oxide (Nb₂O₃), zirconium dioxide (ZrO₂), or aluminum nitride (AlN). Furthermore, in the infrared light transmission filter 104, a film having a low refractive index may be formed using a material such as silicon nitride (Si₃N₄), aluminum oxide (Al₂O₃), or magnesium oxide (MgO).

This stacked film functions as a filter having a high reflectance in the visible light band and a low transmittance in the infrared light band. Therefore, in addition to a function of blocking light outside the infrared light band in the second pixel 102, a function of causing the reflected light in the visible light band to re-enter the first photoelectric conversion region 112 is provided.

As still another example, the infrared light transmission filter 104 may include an indium phosphorus (InP) film. In the case of using InP, the infrared light transmission filter 104 has a high light absorption rate in the visible light band and a high light transmittance in the infrared light band. Therefore, the second pixel 102 has a function of appropriately blocking light outside the infrared light band. The transmittances in the visible light band and the infrared light band can be appropriately selected depending on the film thickness of InP.

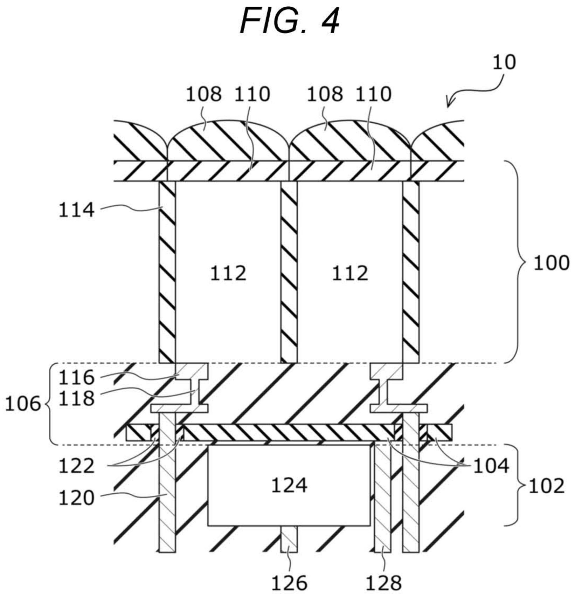

Fig. 4 is a diagram illustrating an example of a case where InP is used for the infrared light transmission filter 104. InP, due to its characteristics, causes photoelectric conversion by incident light. Therefore, in a case where InP is used, it is desirable to appropriately release the voltage generated by photoelectric conversion. Therefore, for example, as illustrated in Fig. 4, it is desirable to form a contact 128 connected to the infrared light transmission filter 104 and appropriately remove the charge generated in InP.

In either case, the infrared light transmission filter 104 may conduct electricity. Therefore, the insulating film 122 is formed at the interface between the infrared light transmission filter 104 and the contact 120.

As described above, the sensor unit 10 includes the first pixel 100 that receives light in the visible light band and generates a pixel signal in the visible light band, and the second pixel 102 that is formed by being stacked with the first pixel 100. The second pixel 102 receives the light in the infrared light band transmitted through the first pixel 100 and generates a pixel signal in the infrared light band. Between the first pixel 100 and the second pixel 102, the wiring layer 106 provided with wiring for supplying the signal output from the first pixel 100 to a subsequent circuit is provided. Then, on the incident surface side of the second pixel 102, an infrared light transmission filter for efficiently causing light in the infrared light band to enter a second photoelectric conversion region is provided.

With the above configuration, according to the solid-state imaging device 1 according to the present embodiment, by using the filter that transmits the infrared light band while removing the light in the visible light band transmitted through the first pixel, it is possible to form an image sensor which can efficiently operate even in a configuration including the first pixel and the second pixel that are stacked, and can reduce the influence of visible light.

As a result, the solid-state imaging device 1 can reduce the influence of color mixing, and by using the infrared light transmission filter, for example, including an a-Si film and an SiO₂ film, can also promote re-entry of visible light to the first pixel by reflection. Furthermore, in the case of using the infrared light transmission filter, for example, including the a-Si film and the SiO₂ film, the infrared light transmission filter can be further used as a bonding surface of a heterostructure.

The infrared light transmission filter 104 as illustrated in Fig. 3 is easily formed in a semiconductor manufacturing process.

### <3. Modification: another example of position of infrared light transmission filter>

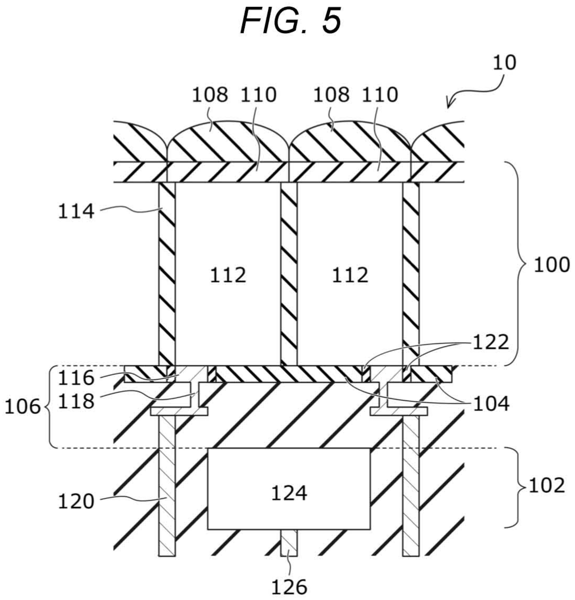

Fig. 5 is a diagram illustrating a modification of the first embodiment. As illustrated in Fig. 5, the infrared light transmission filter 104 may be provided at an interface (bonding surface) between the first photoelectric conversion region 112 (first pixel 100) and the wiring layer 106.

Between the infrared light transmission filter 104 and the layer in which the pixel transistor 116 is provided, the insulating film 122 is appropriately provided in accordance with a conductive or insulating state of a wiring or the like.

In a case where the infrared light transmission filter 104 is formed as a stack of materials having different refractive indexes such as the a-Si film and the SiO₂ film, as described above, the infrared light transmission filter 104 has a reflection characteristic for light in the visible light band. Therefore, with the arrangement as illustrated in Fig. 5, the first pixel 100 can achieve higher conversion efficiency in the first photoelectric conversion region 112 for the light reflected from the infrared light transmission filter 104, compared to that in Fig. 3, and furthermore, can reduce the possibility that color mixing occurs in the first pixel 100.

Note that, in Fig. 5, the thickness of the infrared light transmission filter 104 is equivalent to the thickness of the pixel transistor 116, but this diagram is for illustrative purposes, and the present invention is not limited to this diagram.

The infrared light transmission filter 104 may have a thickness thinner than that of the pixel transistor 116, that is, have a form in which at least a part of the pixel transistor 116 protrudes from the infrared light transmission filter 104, or may have a thickness thicker than that of the pixel transistor 116, that is, have a form in which the pixel transistor 116 is completely included in the region of the infrared light transmission filter 104.

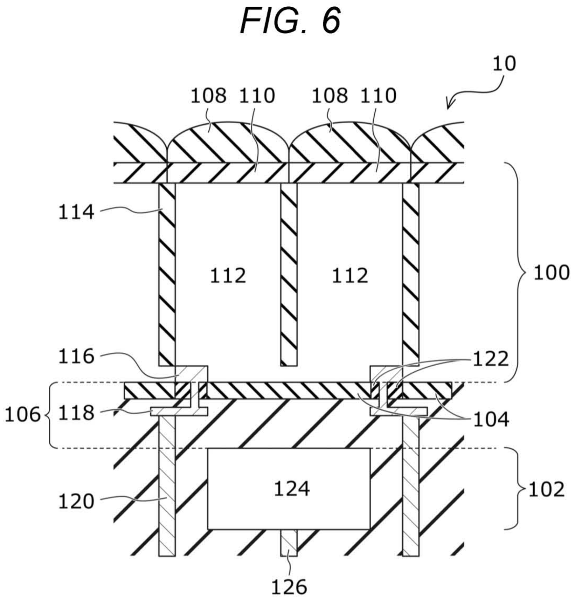

Fig. 6 is a modification of Fig. 5. As described above, the first pixel 100 can also be regarded as a configuration including up to the pixel transistor 116. Therefore, the first pixel 100 can be defined to include the region of the pixel transistor 116, and the infrared light transmission filter 104 can be arranged at the interface between the pixel transistor 116 and the wiring layer.

Between the infrared light transmission filter 104 and the layer in which the pixel transistor 116 is provided and the wiring 118, the insulating film 122 is appropriately provided in accordance with the conductive or insulating state of the wiring or the like.

As described above, depending on the situation of the manufacturing process of forming the first pixel 100, the infrared light transmission filter 104 can also be arranged on the lower side in the drawing of the pixel transistor 116.

Note that, in the case of the form of Fig. 5 or Fig. 6, the infrared light transmission filter 104 may not be arranged in a region where light is not directly transmitted, such as a region immediately below the light shielding film 114. In other words, the infrared light transmission filter 104 may selectively have an opening.

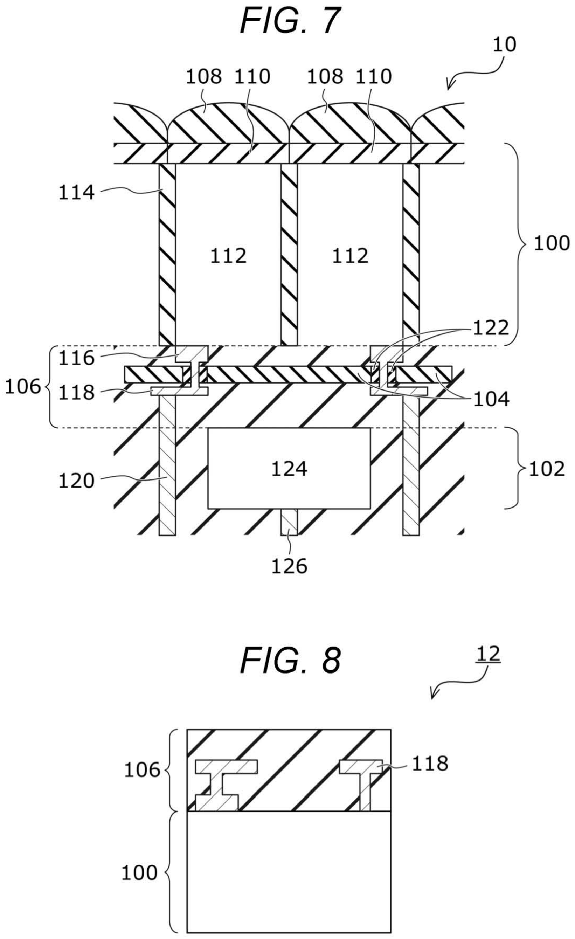

Fig. 7 is a diagram illustrating a modification of the first embodiment. As illustrated in this drawing, the infrared light transmission filter 104 may be arranged inside the wiring layer 106. In this case, it is necessary to appropriately arrange the insulating film 122 such that the wiring 118 and the infrared light transmission filter 104 are not electrically connected.

Furthermore, Poly-Si forming the wiring 118 can also be used as a part of the infrared light transmission filter 104.

### <4. Manufacturing process of sensor including infrared light transmission filter>

Next, a manufacturing process of the pixel and the filter described above will be described. First, a manufacturing process of the sensor unit 10 according to Fig. 3 or 4 will be described.

Figs. 8 to 15 are diagrams illustrating an example of the manufacturing process of the sensor unit 10 according to one embodiment. This manufacturing process is typically a manufacturing process related to a configuration including the infrared light transmission filter 104 in which materials having different refractive indexes are stacked.

As illustrated in Fig. 8, a first substrate 12 is formed as a pre-process. In the first substrate 12, for example, the first pixel 100 is formed on a silicon substrate, and the wiring layer 106 is formed on the upper surface thereof. The wiring layer 106 includes, for example, the wiring 118 of a Poly-Si.

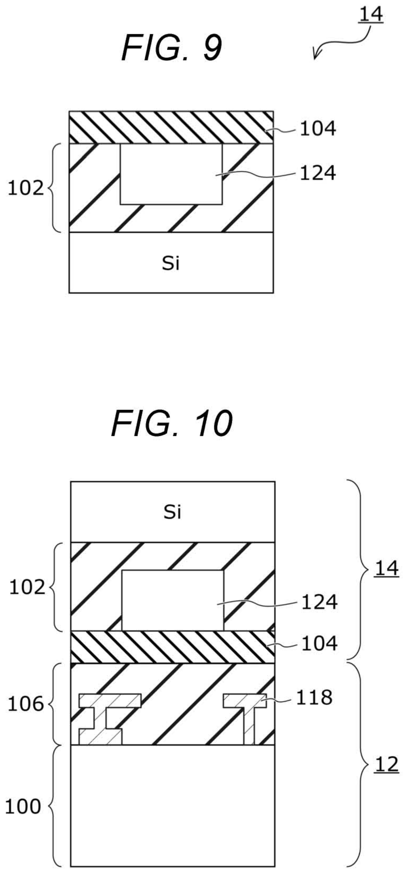

As illustrated in Fig. 9, a second substrate 14 is formed. In the second substrate 14, for example, the second pixel 102 formed to a pixel shape is formed. The second substrate 14 is formed by forming the infrared light transmission filter 104 on the upper surface of the layer including the second pixel 102.

Although an insulating film is appropriately formed on the upper surface of the first photoelectric conversion region 112 of the first pixel 100 in Fig. 8 and the upper surface of the second photoelectric conversion region 124 of the second pixel 102 in Fig. 9, it should be noted that illustration is omitted.

As illustrated in Fig. 10, the upper surface of the second substrate 14 in Fig. 9 is bonded to the upper surface of the first substrate 12 in Fig. 8, and the first substrate 12 and the second substrate 14 are stacked. By this bonding, the first pixel 100 and the second pixel 102 which are stacked are formed.

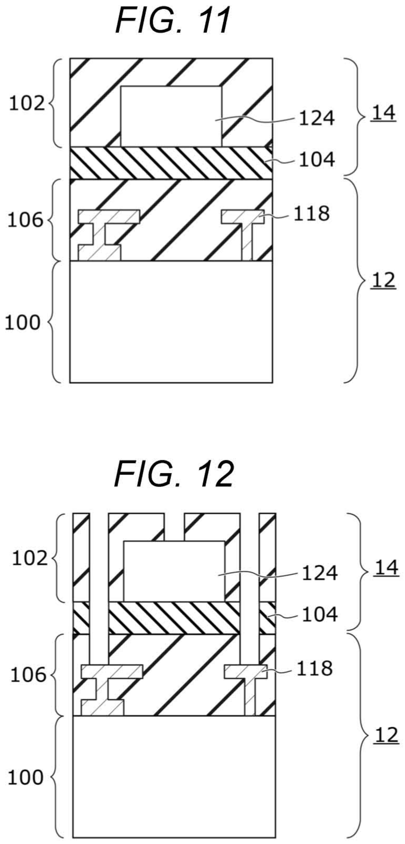

As illustrated in Fig. 11, the silicon substrate on the upper surface of Fig. 10 is removed.

As illustrated in Fig. 12, a trench is selectively formed from the upper surface of Fig. 11 to the wiring 118 so as to avoid the second pixel 102. The trench is formed by an arbitrary method such as shallow trench isolation (STI), for example. Furthermore, the trench is formed so as to selectively reach the second photoelectric conversion region 124 at the same timing or at different timings.

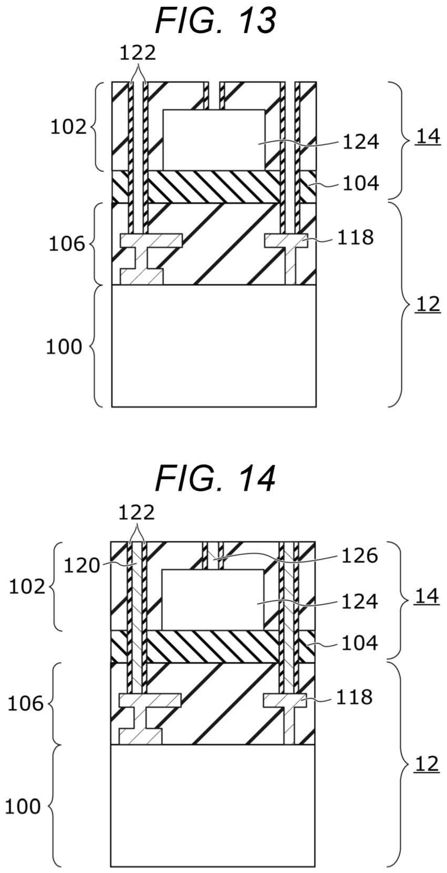

As illustrated in Fig. 13, the insulating film 122 is formed on the sidewall of the trench. The formation of the insulating film 122 can be realized by an arbitrary method.

As illustrated in Fig. 14, a conductor, for example, metal such as copper (Cu), tungsten (W), titanium (Ti), or aluminum (Al) is formed in the trench to form a contact electrode. Through this process, the contacts 120 and 126 are formed.

Note that, in the processes of Figs. 12 to 14, a pixel transistor and the like related to the second pixel 102 may be formed, or the pixel transistor and the like related to the second pixel 102 may be formed in advance, and the contact 126 may be formed on an electrode such as a gate electrode of these transistors.

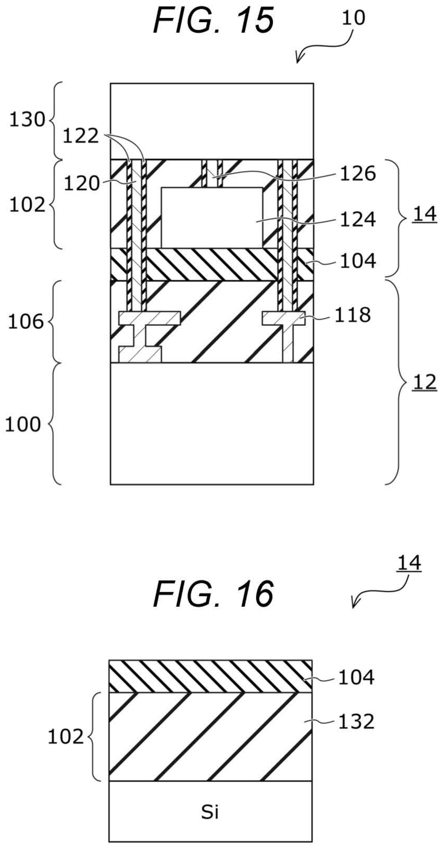

Thereafter, as illustrated in Fig. 15, the sensor unit 10 is formed by forming a metal wiring layer 130 having an appropriate wiring.

Modifications will be described with reference to Figs. 16 to 18.

As illustrated in Fig. 16, the shape of the second pixel 102 may not be formed at the timing of forming the second substrate 14. For example, in the second substrate 14, an InGaAs layer 132 for forming the second photoelectric conversion region 124 is formed on the silicon substrate. The infrared light transmission filter 104 is formed on the upper surface of the InGaAs layer 132.

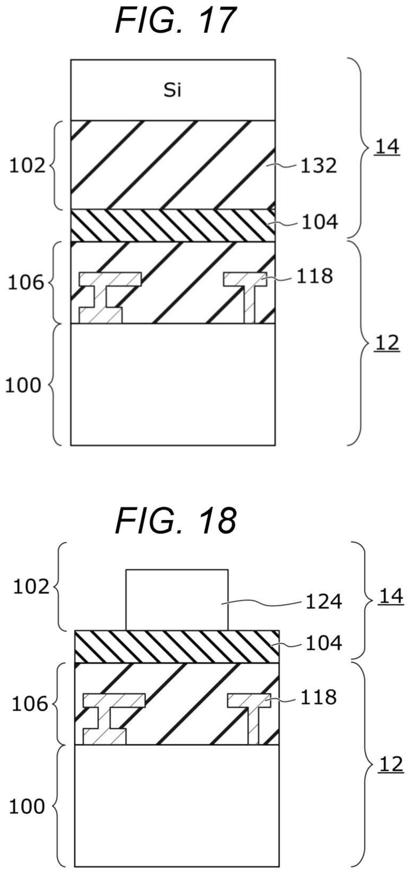

As illustrated in Fig. 17, the upper surface of the second substrate 14 is bonded to the upper surface of the first substrate 12 to be stacked.

As illustrated in Fig. 18, the second photoelectric conversion region 124 is formed by selectively removing the InGaAs layer 132, and then the second pixel 102 is formed. The subsequent processes are similar to those in and after Fig. 11.

As described above, the second pixel 102 may be formed and then stacked, or the second pixel 102 may be formed after the first substrate 12 and the second substrate 14 are bonded.

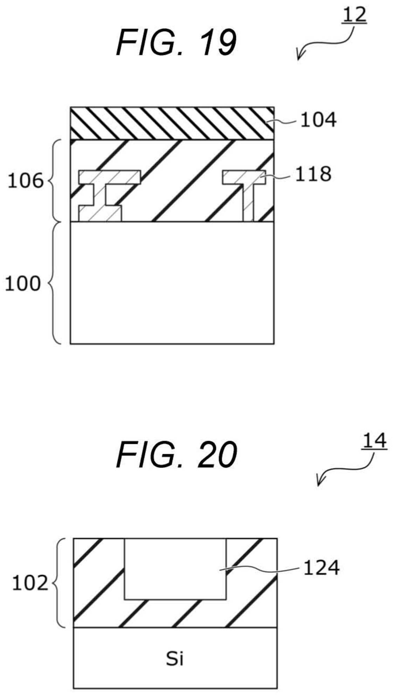

Next, an example in which the infrared light transmission filter 104 is formed on the first substrate 12 side will be described with reference to Figs. 19 to 21.

As illustrated in Fig. 19, in the first substrate 12, the infrared light transmission filter 104 is formed on the upper surface of the wiring layer 106.

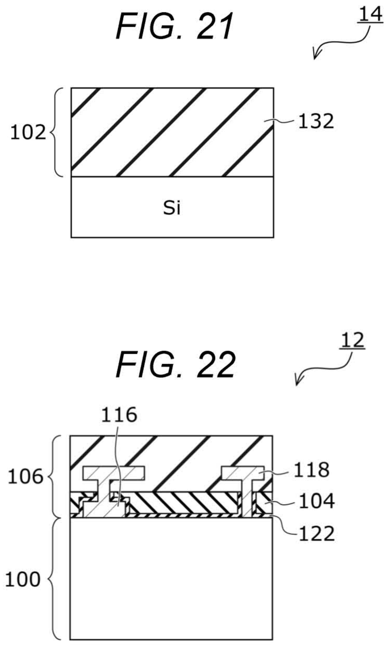

In the second substrate 14, as described above, the second pixel 102 may be formed as illustrated in Fig. 20, or the InGaAs layer 132 may be formed as illustrated in Fig. 21.

By bonding and stacking the upper surface of the second substrate 14 illustrated in Fig. 20 to the upper surface of the first substrate 12 illustrated in Fig. 19, the sensor unit 10 can be formed through the manufacturing process from Fig. 10.

Furthermore, by bonding and stacking the upper surface of the second substrate 14 illustrated in Fig. 21 to the upper surface of the first substrate 12 illustrated in Fig. 19, the sensor unit 10 can be formed through the manufacturing process from Fig. 17.

As described above, the first substrate 12 and the second substrate 14 can be bonded after the infrared light transmission filter 104 is formed on the first substrate 12 side.

Furthermore, it is also possible to form the infrared light transmission filter 104 on each of the upper surface of the first substrate 12 and the upper surface of the second substrate 14 and bond the infrared light transmission filters 104 to each other. For example, by bonding the upper surface of the second substrate 14 illustrated in Fig. 9 to the upper surface of the first substrate 12 illustrated in Fig. 19, the manufacturing process after Fig. 10 can be performed. Furthermore, by bonding the upper surface of the second substrate 14 illustrated in Fig. 16 to the upper surface of the first substrate 12 illustrated in Fig. 19, the manufacturing process after Fig. 17 can be performed.

In a case where the infrared light transmission filter 104 is formed on both the substrates, for example, the upper surface of the first substrate 12 and the upper surface of the second substrate 14 can be easily bonded by being activated with oxygen plasma.

Furthermore, the stacked infrared light transmission filters 104 includes different materials (for example, a-Si and SiO₂), but the material of the upper surface of the first substrate 12 and the material of the second substrate 14 may be different materials (a-Si and SiO₂) or may be the same material (for example, both s-Si or both SiO₂). The bonding method can be changed between the case of the upper surfaces of the different materials and the case of the upper surfaces of the same material. Therefore, it is possible to select an appropriate method in the environment of the manufacturing process or the like.

Next, a configuration in the case of Fig. 5 or 6 will be described.

As illustrated in Fig. 22, in the first substrate 12, after the first pixel 100 is formed, the pixel transistor 116 and the like are formed. The infrared light transmission filter 104 is formed on the upper surface. If necessary, an insulating film is formed at the interface between the pixel transistor 116 and the like and the infrared light transmission filter 104 and the interface with the first pixel 100, and then the infrared light transmission filter 104 is formed.

In the infrared light transmission filter 104, a region for forming a wiring connected to the pixel transistor 116 and the like is selectively removed. Then, after a connection wiring with the pixel transistor 116 and the like is formed, the wiring layer 106 is formed.

Subsequently, the upper surface of the first substrate 12 illustrated in Fig. 22 and the upper surface of the second substrate 14 illustrated in Figs. 20, 21, and the like are bonded to each other, and a process similar to the process from Fig. 10 (except for the process of forming a contact that penetrates the infrared light transmission filter 104; it should be noted that this process of forming a through contact may be included if necessary) is performed, whereby the sensor unit 10 illustrated in Fig. 5 and the like can be formed. The same applies to the case of Fig. 6, and in this case, the infrared light transmission filter 104 is formed after the insulating film 122 is formed at the interface with the first pixel 100 including the pixel transistor 116. The subsequent processing is similar to that described above.

Next, a configuration in the case of Fig. 7 will be described.

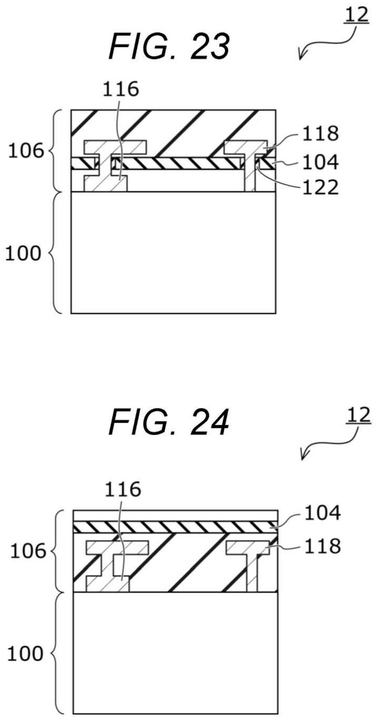

As illustrated in Fig. 23, in the first substrate 12, the infrared light transmission filter 104 can be formed while the wiring layer is formed. For example, after the first pixel 100 and the pixel transistor 116 are formed, the material of the wiring layer 106 and the material of the infrared light transmission filter 104 are stacked to form the wiring 118. The insulating film 122 is appropriately formed between the infrared light transmission filter 104 and the wiring 118.

Subsequently, the upper surface of the first substrate 12 illustrated in Fig. 23 and the upper surface of the second substrate illustrated in Figs. 20, 21, and the like are bonded to each other, and a process similar to the process from Fig. 10 (except for the process of forming a contact that penetrates the infrared light transmission filter 104; it should be noted that this process of forming a through contact may be included if necessary) is performed, whereby the sensor unit 10 illustrated in Fig. 7 can be formed.

Note that in a case where the infrared light transmission filter 104 is formed in the wiring layer 106, in addition to the above, the infrared light transmission filter 104 may be formed in a layer different from the wiring 118 as illustrated in Fig. 24. In this case, similarly to the examples of Figs. 12 to 14, the contact 120 to the wiring 118 and the like is formed so as to penetrate the infrared light transmission filter 104.

Next, a case where the infrared light transmission filter 104 using InP and the like is formed will be described.

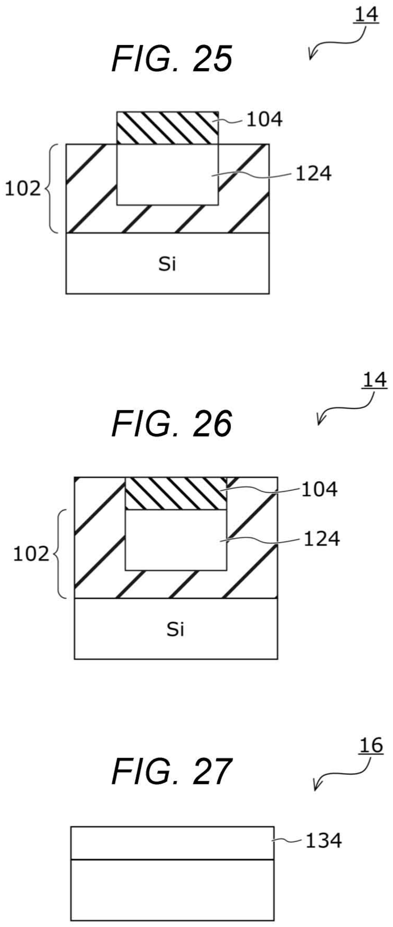

First, as illustrated in Fig. 20, InGaAs is molded to form the second photoelectric conversion region 124. Then, as illustrated in Fig. 25, InP is formed on the upper surface of the second photoelectric conversion region 124 by epitaxial growth.

Subsequently, the second substrate 14 in Fig. 26 is formed through processes such as formation of an insulating film (for example, a TEOS film) and polishing/etching. In the subsequent processing, the sensor unit 10 is formed through a process similar to a case where the infrared light transmission filter 104 is arranged in contact with the second substrate 14 described above.

Furthermore, as illustrated in Fig. 21, it is possible to defer the formation of the shape of the second pixel 102 to a process after the bonding. In this case, the second substrate 14 illustrated in Fig. 16 is formed by forming InP on the upper surface of the second substrate 14 in the state of Fig. 21 by epitaxial growth. The subsequent processes are similar to those from Fig. 16.

As described above, in a case where InP is used, the infrared light transmission filter 104 can be formed by epitaxial growth.

Note that the manufacturing processes in Figs. 25 to 26 can be applied not only to InP but also to the stacked infrared light transmission filter 104 such as a stacked film of a-Si and SiO2. The stacked film can be realized by selectively forming a stacked film on the upper surface of the InGaAs region of the second pixel 102 and forming an insulating film in another region. As described above, the infrared light transmission filter 104 using the stacked film can also be selectively formed on the upper surface of the second photoelectric conversion region 124 of the second pixel 102.

Note that in a case where the infrared light transmission filter 104 is formed using InP, the contact 128 is required as illustrated in Fig. 4. In any manufacturing process, a process of forming the contact 128 insulated from InGaAs and electrically connected to the infrared light transmission filter 104 is added. In the case of Fig. 26 and the like, a wiring or the like for electrically connecting the infrared light transmission filter 104 and the contact 128 may be formed in advance.

Furthermore, InP can also be formed through another process.

As illustrated in Fig. 27, another substrate on which an InP layer 134 is formed can also be used as a transfer substrate 16. The transfer substrate 16 forms the InP layer 134 by an arbitrary method.

For example, the upper surface of the transfer substrate 16 illustrated in Fig. 27 is bonded to the upper surface of the second substrate 14 in which the upper surface of the InGaAs layer 132 illustrated in Fig. 20 selectively exists, and the portion of the transfer substrate 16 other than the InP layer 134 is removed, whereby the second substrate 14 similar to Fig. 9 can be formed.

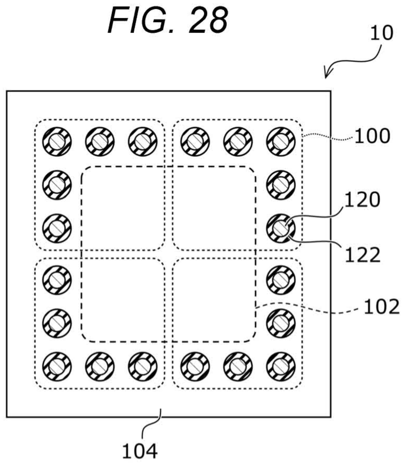

Fig. 28 is a top view schematically illustrating a region for one pixel of the second pixel 102 of the sensor unit 10. Note that this drawing does not illustrate all the configurations, and is a diagram illustrating a representative configuration in a transparent manner. Furthermore, for the relationship in the depth direction of the configuration, refer to Figs. 3 to 7, and the like.

A dotted line indicates the first pixel 100, and a broken line indicates the second pixel 102. For the second pixel 102, the first pixel 100 is formed by being stacked as illustrated in the drawing.

The contact 120 including the electrode connected to the first pixel 100 and the insulating film 122 around the contact 120 are arranged around the second pixel 102 so as not to contact the second pixel 102. A signal or the like is output from the first pixel 100 via the contact 120, and a control signal or the like is supplied to the first pixel 100.

As described above, according to the present embodiment, in the configuration in which the visible light pixel that acquires the visible light image and the infrared light pixel that acquires the infrared light image are stacked, the infrared light transmission filter is arranged between the visible light pixel and the infrared light pixel, whereby the infrared light transmitted through the visible light pixel can be appropriately supplied to the infrared light pixel. According to this configuration, a highly accurate visible light image can be generated by reflection of visible light to a visible light pixel. Furthermore, according to this configuration, it is possible to suppress a reduction in the intensity of the infrared light and to suppress an influence of color mixing or the like caused by the visible light transmitted through the infrared light pixel.

### <5. Second embodiment: configuration in which sensor unit includes chalcogenide material>

In the second pixel 102 that acquires short-wave infrared, for example, it is desirable to set the transmittance at a wavelength of 700 [nm] to 5% and to increase the transmittance at a wavelength of 1000 [nm] to 2500 [nm] as much as possible. In addition to the infrared light transmission filter 104 in the above-described embodiment, or instead of the infrared light transmission filter 104 in the above-described embodiment, a chalcogenide material can be arranged.

Transition metal dichalcogenide (TMD) has a considerably high extinction coefficient of light in a visible light band. The TMD material can be arranged as the infrared light transmission filter 104, or the infrared light transmission filter 104 can undergo thin-film section by providing a film of the TMD material.

As a non-limiting example, the infrared light transmission filter 104 in Figs. 3 to 7 may include a TMD film (chalcogenide layer). As described above, in a non-limiting embodiment, the sensor unit 10 can use a layer including the TMD film as the infrared light transmission filter 104.

Molybdenum diselenide (MoSe₂) can be used as TMD. In the case of using MoSe2, when the film pressure of the TMD film exceeds 200 [nm], the transmittance of light in the visible light band and the infrared light band described above can be almost achieved. Furthermore, visible light is also absorbed in Si contained in another layer (for example, a layer in which the first pixel 100 or the second pixel 102 is formed, or the wiring layer 106).

Therefore, it is desirable that the TMD film has a film pressure within a range not exceeding 200 [nm], for example, between 1 [nm] and 200 [nm] in order to reduce the size of the sensor unit 10. That is, in a case where the infrared light transmission filter 104 includes the TMD film, it is desirable to form the infrared light transmission filter 104 at 1 [nm] to 200 [nm].

As the TMD material, in addition to MoSe2, materials such as molybdenum disulfide (MoS2) and tungsten diselenide (Wse2) can be used. The transmission wavelengths thereof are about 730 [nm] and above and about 950 [nm] and above, respectively, so that it is also possible to select an appropriate TMD material according to the acquired infrared wavelength. Of course, the above-described materials are given as non-limiting examples, and other TMD materials can also be used.

Next, a case where the TMD film (chalcogenide layer) is used in combination with the infrared light transmission filter 104 described in the first embodiment described above will be described.

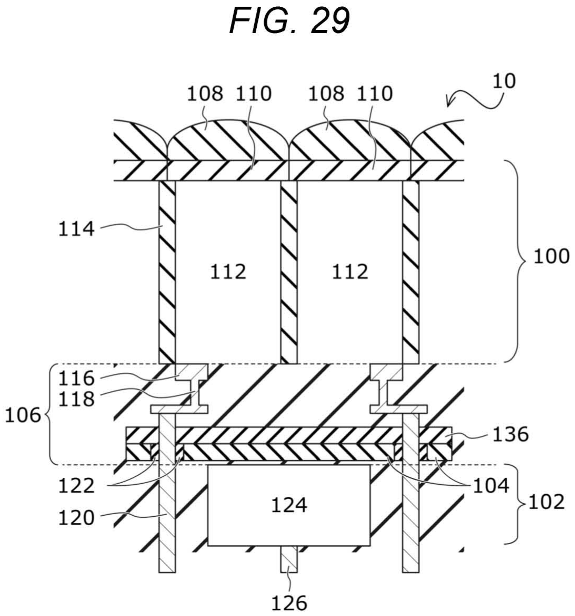

Fig. 29 is a diagram illustrating an example of a cross section of the sensor unit 10 according to one embodiment. As illustrated in Fig. 29, the sensor unit 10 may include the infrared light transmission filter 104 on the upper surface of the second pixel 102 and a TMD film 136 on the upper surface of the infrared light transmission filter 104. In a case where it is necessary to remove charges in the infrared light transmission filter 104, as with InP, the contact 128 can be included in the configuration of Fig. 29 as illustrated in Fig. 4.

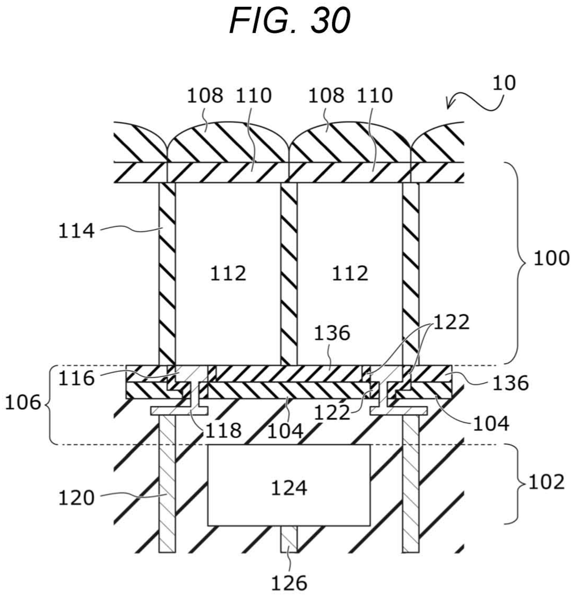

Fig. 30 is a diagram illustrating an example of the cross section of the sensor unit 10 according to one embodiment. As illustrated in Fig. 30, the sensor unit 10 may include the TMD film 136 on the lower surface of the first pixel 100 and the infrared light transmission filter 104 on the lower surface of the TMD film 136. The insulating film 122 and the like are appropriately arranged according to the situation.

Of course, as illustrated in Fig. 6, it is possible to form on the lower surface of the pixel transistor 116 of the first pixel 100.

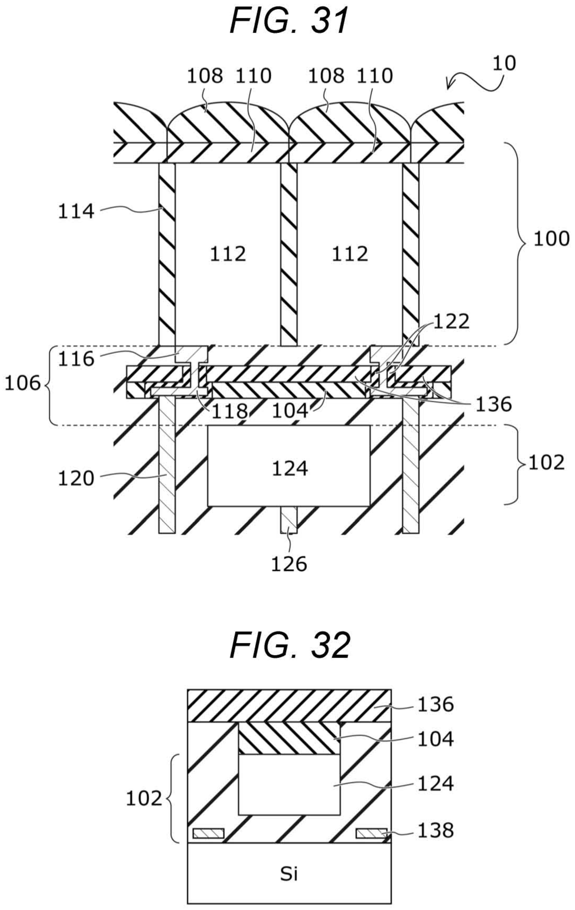

Fig. 31 is a diagram illustrating an example of the cross section of the sensor unit 10 according to one embodiment. As illustrated in Fig. 31, in the sensor unit 10, the TMD film 136 and the infrared light transmission filter 104 on the lower surface side of the TMD film 136 can be arranged in the wiring layer 106. The insulating film 122 and the like are appropriately arranged according to the situation.

The TMD film 136 can have higher attenuation of light in the visible light band than the infrared light transmission filter 104 according to the first embodiment described above. Therefore, as illustrated in Figs. 29 to 31, the TMD film 136 is desirably arranged on the incident surface side of the infrared light transmission filter 104, that is, the first pixel 100 side, but is not limited to these forms.

Also in the cases of Figs. 29 to 31, similarly to the case of using the TMD film as the infrared light transmission filter 104, it is desirable to have a thickness of 1 [nm] or more and 200 [nm] or less, but in view of the transmittance of light in the visible light band together with the infrared light transmission filter 104, the TMD film itself can be made thinner than in the case of using the TMD film alone.

### <6. Manufacturing process of sensor including chalcogenide material>

Basically, similarly to Fig. 9, the TMD film is formed with an arbitrary film thickness on the upper surface of the formed second pixel 102. Thereafter, similarly to Fig. 10, the sensor unit 10 is manufactured by bonding the first substrate 12 and the second substrate 14.

In the first embodiment described above, the first pixel 100 is formed on the first substrate 12, the second pixel 102 is formed on the second substrate 14, and these substrates are bonded to form stacked pixels. The present invention is not limited thereto, and after the second pixel 102 is formed, the first pixel 100 can be formed on the same substrate.

For example, as illustrated in Fig. 32, the TMD film 136 is formed on the upper surface of the second pixel 102. In the process of forming the second pixel 102, a wiring 138 for inputting and outputting signals of the second pixel 102 and supplying power to the second pixel 102 is formed so as to avoid the second photoelectric conversion region 124.

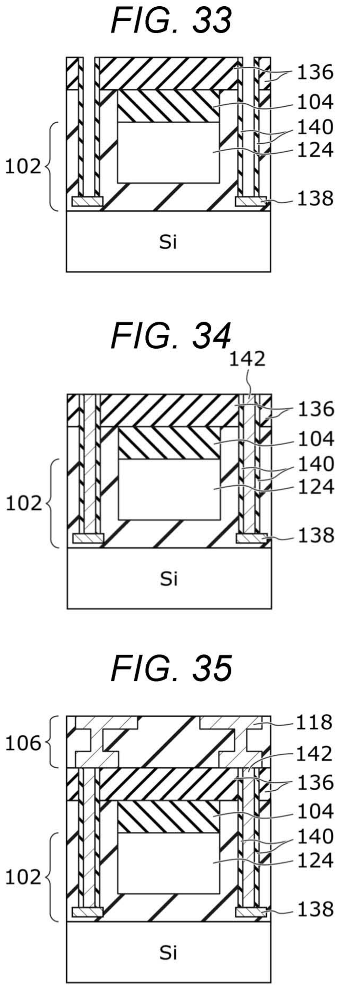

Subsequently, as illustrated in Fig. 33, a trench for forming a contact and an insulating film are formed for the wiring 138. The insulating film may be selectively formed on the side surface of the TMD film 136.

Subsequently, as illustrated in Fig. 34, the contact 142 is formed as an electrode connected to the wiring 138.

Subsequently, as illustrated in Fig. 35, the wiring layer 106 is formed on the upper surface of the layer formed in Fig. 34. Thereafter, for example, the first pixels 100 formed in the pre-process may be bonded, or a process of forming the first pixels 100 on the upper surface of the wiring layer 106 may be performed.

As described above, it is also possible to form up to the first pixel 100 in order from the substrate of the second pixel 102. Furthermore, in the above-described embodiment and the present embodiment, the back-illuminated image sensor has been described, but the present invention is not limited thereto, and also in a front-illuminated image sensor, the infrared light transmission filter 104 and/or the TMD film 136 can be formed between the visible light pixel and the infrared light pixel to be stacked.

As described above, according to the present embodiment, by arranging the transition metal dichalcogenide material having a high extinction coefficient of visible light between the visible light pixel and the infrared light pixel to be stacked, it is possible to use it in place of the infrared light transmission filter, or to configure it separately from the infrared light transmission filter to make the infrared light transmission filter thinner. By using the TMD material, in the thinned layer, visible light can be reduced, attenuation of the incident amount of infrared light can be suppressed, and oblique incidence of infrared light and the like can be suppressed.

### <7. Third embodiment: configuration of light shielding wall of pixel for receiving infrared light>

In the above-described embodiment, the infrared light transmission filter 104 between the first pixel 100 and the second pixel 102 has been described. However, by providing an infrared light shielding film on the side surface of the second pixel 102, it is also possible to suppress the influence of color mixing or the like between the second pixels 102. In the following embodiment, the description and illustration of the infrared light transmission filter 104 are omitted, but the configuration including the infrared light transmission filter 104 is not excluded similarly to the above-described embodiment, and the configuration may further include the infrared light transmission filter 104 in addition to the configuration described below.

In the following description, illustration and description of a thin film of a conductor that transfers current and voltage in a photoelectric conversion region forming a pixel, various diffusion layers, a thin film of an insulator that controls electrical conduction between conductors, and the like may be omitted. This is an omission for making the main points in the present disclosure more comprehensible, and does not mean that these necessary thin films and the like are not provided in the embodiment of the present disclosure.

For example, an electrode or the like for applying a voltage defining a potential of a body, a cathode, an anode, or the like of a pixel can be appropriately provided even if not illustrated. It should be noted that, in the present embodiment and the following embodiment, description is made with emphasis on a light shielding film (light shielding shield) for infrared light in the photoelectric conversion region of the second pixel.

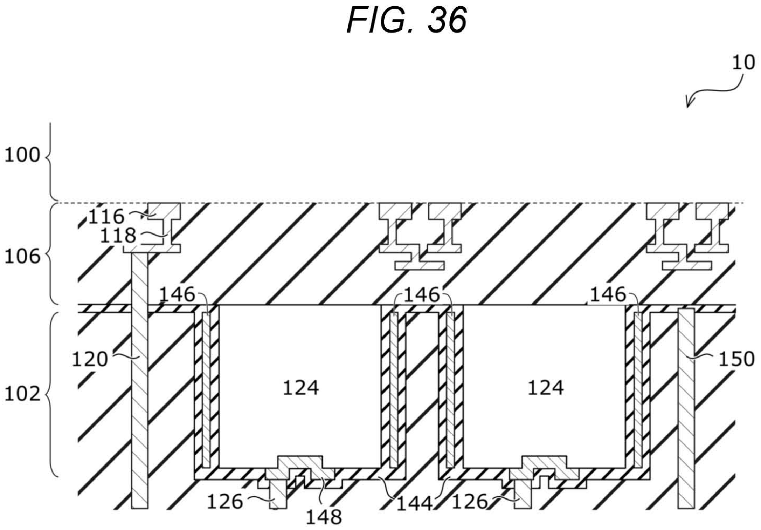

Fig. 36 is a diagram illustrating an example of the cross section of the sensor unit 10 according to one embodiment. Although the illustration of the first pixel 100 may be omitted in the following drawing, the first pixel 100 is appropriately arranged to be stacked with the second pixel 102 similarly to the above-described embodiment.

In the second pixel 102, an insulating film 144 is formed on the side surface of the second photoelectric conversion region 124 and the lower surface in the drawing. The insulating film 144 is an insulator film that prevents charges acquired by photoelectric conversion in the second photoelectric conversion region 124 from flowing out due to contact with other conductors and semiconductors.

In the present embodiment, an infrared light shielding film 146 is provided inside the insulating film 144, more specifically, in a region corresponding to the sidewall of the second photoelectric conversion region 124. The infrared light shielding film 146 includes, for example, a material that shields infrared light or a material that reflects infrared light. The infrared light shielding film 146 may be, for example, a metal.

The second photoelectric conversion region 124 is electrically connected to the contact 126 via an electrode 148. Furthermore, the incident surface of the second photoelectric conversion region 124 is electrically connected to a contact 150 via a semiconductor film or a conductor film, for example, inside the insulating film 144 or at an interface with the wiring layer 106. By applying an appropriate voltage to the contact 126 and the contact 150, a voltage is applied to the second photoelectric conversion region 124, and appropriate photoelectric conversion is realized.

As an overall configuration, the sensor unit 10 includes at least the first pixel 100, the second pixel 102, the wiring layer 106, and the infrared light shielding film 146. The first pixel 100 receives light in the visible light band and generates a pixel signal in the visible light band. The second pixel 102 is formed by being stacked with the first pixel 100, and generates a pixel signal in the infrared light band that receives the light in the infrared light band transmitted through the first pixel 100. The wiring layer 106 includes a wiring that is formed between the first pixel 100 and the second pixel 102 and propagates a signal output from the first pixel 100. Then, in the second pixel 102, the infrared light shielding film 146 is arranged on at least one side surface thereof.

The infrared light shielding film 146 may be formed on the side surface of the second photoelectric conversion region 124 of the second pixel 102 via the insulating film 144. The infrared light shielding film 146 may include, for example, the same material as the electrode for applying a voltage to the second photoelectric conversion region 124.

As described above, according to one embodiment, the infrared light shielding film 146 that shields infrared light can be arranged on the sidewall of the second photoelectric conversion region 124. As described later, the infrared light shielding film 146 and the electrode 148 can include the same material, and in this case, the infrared light shielding film 146 can be formed in the same manufacturing process as that of the electrode 148.

### <8. Modification: another example of light shielding wall>

The arrangement and the like of the infrared light shielding film 146 will be described with some different examples. Both are described as non-limiting examples, and aspects of the present embodiment are not limited thereto. Furthermore, the forms of the examples described below can be combined within a range not contradictory.

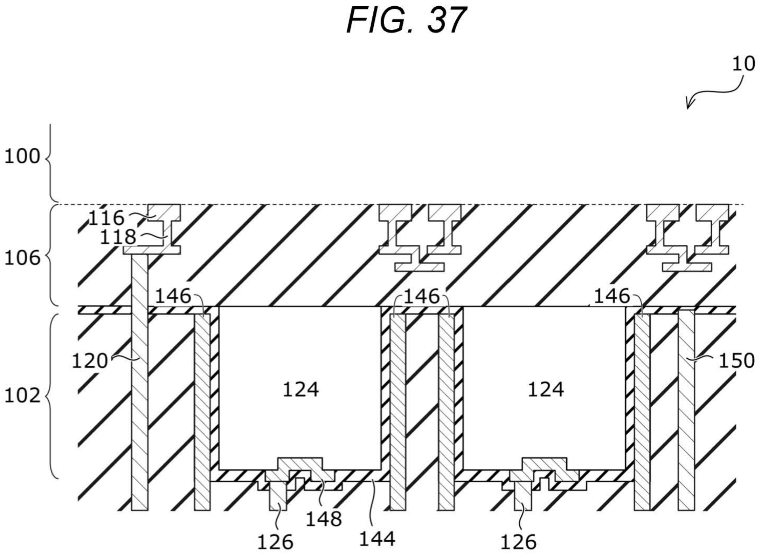

Fig. 37 is a diagram illustrating a non-limiting example of the infrared light shielding film 146. The infrared light shielding film 146 is arranged on the side surface of the second photoelectric conversion region 124 via the insulating film 144 similarly to the above.

In the example of Fig. 37, the infrared light shielding film 146 includes the same material as those of the contacts 120, 126, 150, and the like. Therefore, in the manufacturing process, the infrared light shielding film 146 can be formed in the same process as the process of forming the electrodes of these contacts. In this case, the infrared light shielding film 146 may be, for example, a metal such as Cu, Ti, Al, or W.

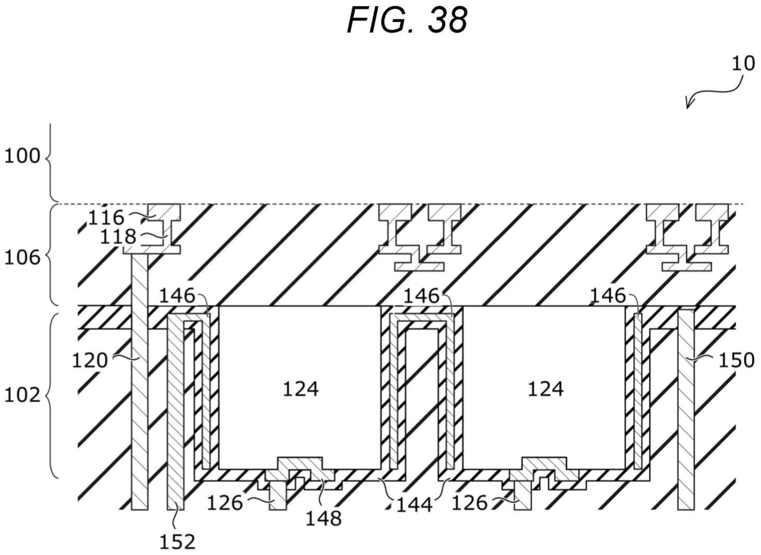

Fig. 38 is a diagram illustrating an aspect in which the infrared light shielding film 146 is arranged in the insulating film 144 on the surface on the same side as the incident surface of the second photoelectric conversion region 124. As illustrated in Fig. 38, the sensor unit 10 can have a form in which the infrared light shielding film 146 illustrated in Fig. 36 is also arranged on the incident surface side of the second photoelectric conversion region 124 in the region where the second pixel 102 is arranged.

In a case where the infrared light shielding film 146 includes a conductor or a semiconductor, the infrared light shielding film 146 is arranged on the incident surface side in a range not electrically connected to the contact 120 and the contact 150. For example, arrangement may be made as illustrated in the drawing, or the infrared light shielding film 146 may be provided on the incident surface side on the contact 150 side as long as it is not electrically connected to the contact 150.

By forming the infrared light shielding film 146 as described above, incidence of infrared light from the incident surface side of the second pixel 102 can be blocked with higher light shielding performance.

Furthermore, in this case, by providing the contact 152, the potential of the infrared light shielding film 146 can be defined, for example, set to a ground potential. The contact 152 can be formed in the same process as that of the contact 120, the contact 126, the contact 150, and the like. That is, the infrared light shielding film 146 may be in a floating state as illustrated in Fig. 36, or the infrared light shielding film 146 may be set to an arbitrary defined potential (including the ground potential) as illustrated in Fig. 38.

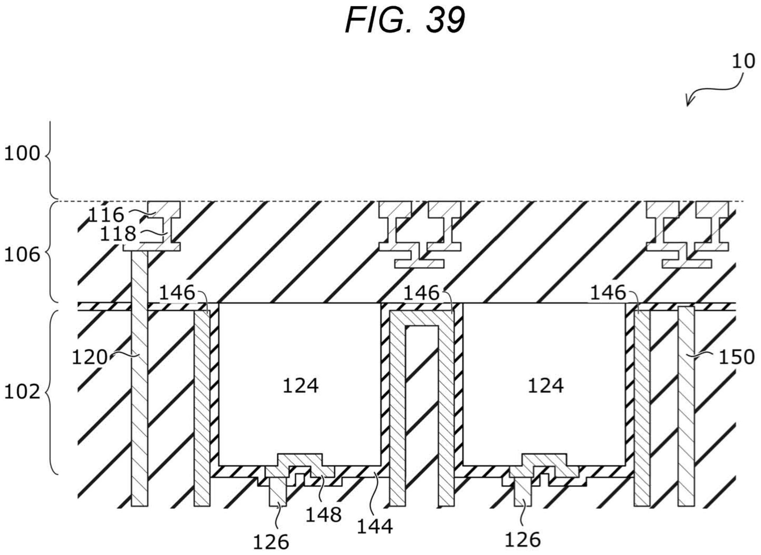

Fig. 39 illustrates an example in which the infrared light shielding film of Fig. 37 is extended to the incident surface side of the second pixel 102 similarly to Fig. 38. As illustrated in this drawing, the infrared light shielding film 146 including the same material as the contact may be arranged on the incident surface side between the second photoelectric conversion regions 124.

Similarly to the example of Fig. 38, also in the example of Fig. 39, the infrared light shielding film 146 can be arranged in a range not electrically connected to the contact. For example, although not illustrated in Fig. 39, the infrared light shielding film 146 can be arranged on the incident surface side of the second pixel 102 in a range not electrically connected to the contact 120 or in a range not electrically connected to the contact 150.

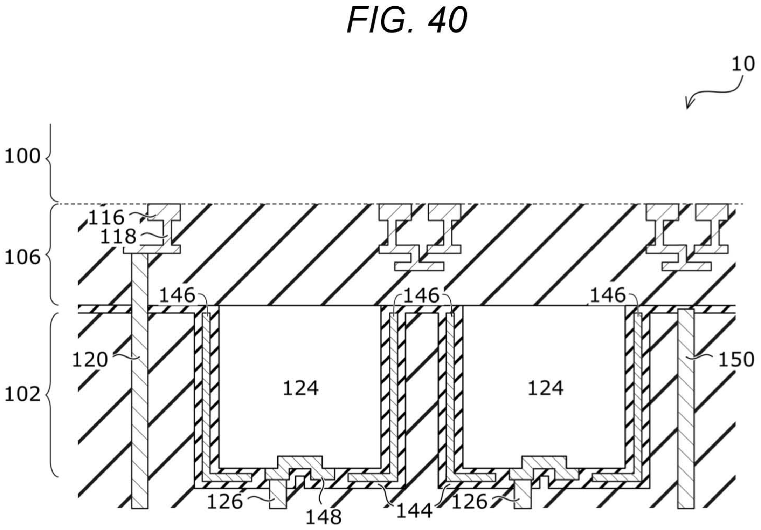

Fig. 40 is a diagram illustrating an example in which the infrared light shielding film 146 is arranged on a surface of the second photoelectric conversion region 124 of the second pixel 102 on a side opposite to the incident MEN. This example is an example in which the infrared light shielding film 146 can be formed in the same process as that of the electrode 148 in the manufacturing process. As illustrated in this drawing, for convenience of processing in the manufacturing process, an aspect different from Fig. 36 and the like can be taken.

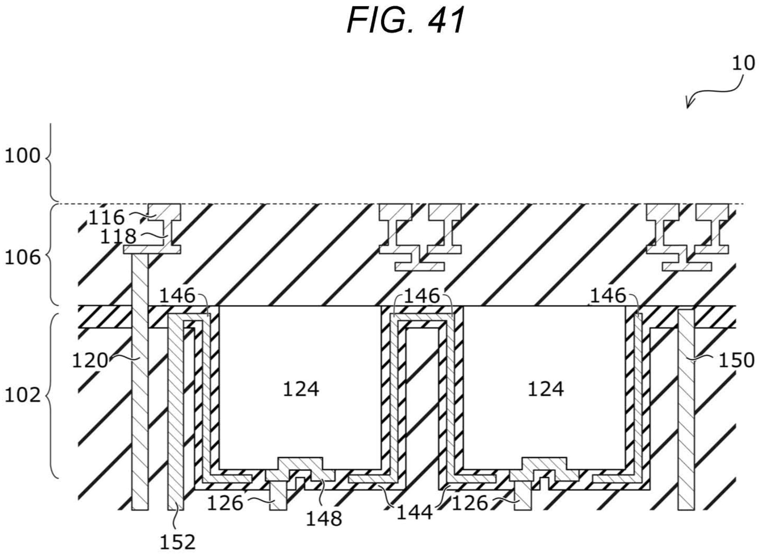

Fig. 41 illustrates a form in which the example of Fig. 38 and the example of Fig. 40 are combined. That is, in the example of Fig. 40, the infrared light shielding film 146 is also provided on the same surface side as the incident surface of the second photoelectric conversion region 124. In this case, the contact 152 may be further arranged similarly to Fig. 38. The potential of the infrared light shielding film 146 can be defined by the contact 152.

In Figs. 36 to 41, similarly to the first embodiment, for example, an example has been described in which one second pixel 102 is provided for 2×2 first pixels 100, but the ratio of the number of first pixels 100 to the number of second pixels 102 is not limited thereto. For example, one second pixel 102 may be arranged for one first pixel 100. For example, 2×2 second pixels can be arranged for 2×2 first pixels illustrated in Fig. 2.

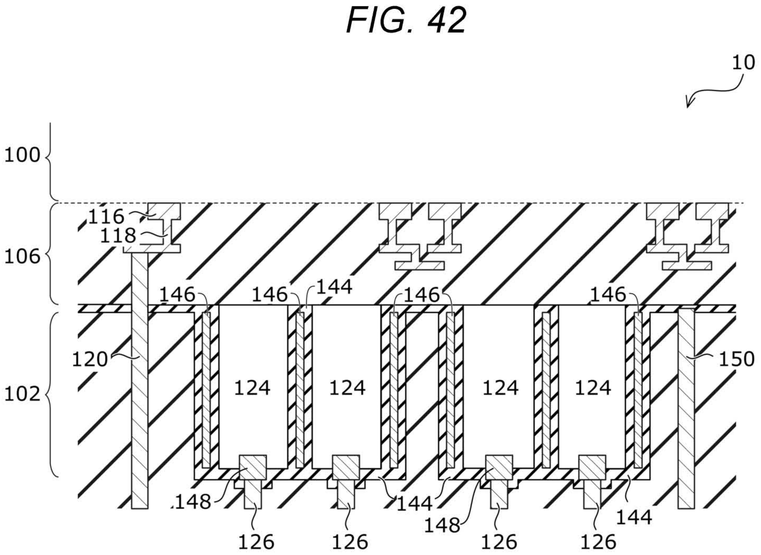

Fig. 42 is a diagram illustrating the sensor unit 10 in which one second pixel 102 is arranged for every one first pixel 100 as an example. In the sensor unit 10, the infrared light shielding film 146 can be arranged between the second photoelectric conversion regions 124 of the second pixels 102 arranged adjacent to each other, more specifically, via the insulating film 144 on side surfaces between the second pixels 102 arranged adjacent to each other. By arranging the infrared light shielding film 146 as described above, it is possible to further suppress leakage of infrared light from the adjacent second pixel 102.

As another example of the example illustrated in Fig. 42, the infrared light shielding film 146 in Fig. 42 can be formed to enable potential control rather than floating, as illustrated in Fig. 38.

Furthermore, as illustrated in Fig. 40, the infrared light shielding film 146 in Fig. 42 can also be arranged on a surface opposite to the incident surface of the second photoelectric conversion region 124.

Moreover, as illustrated in Fig. 40, the infrared light shielding film 146 in Fig. 42 can be connected to a contact so that the potential can be controlled, and can also be arranged on a surface opposite to the incident surface of the second photoelectric conversion region 124.

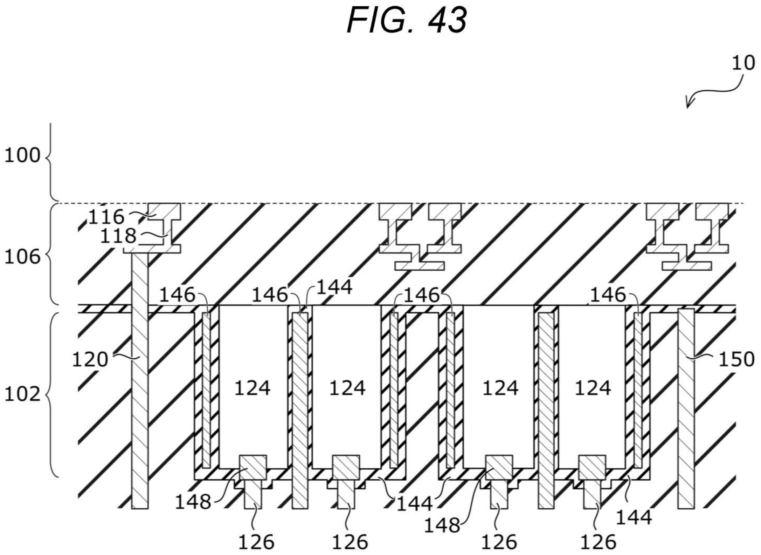

Fig. 43 illustrates an example in which the infrared light shielding film 146 between the adjacent second pixels 102 illustrated in Fig. 42 includes the same material as the contact electrode, similarly to Fig. 37 and the like. As illustrated in this example, the infrared light shielding film 146 including the same material as the contact may be arranged only between the adjacent second pixels 102, or moreover, the infrared light shielding film 146 on the sidewall of the group of the adjacent second pixels 102 may include the same material as the contact.

A transparent electrode film is formed on the incident surface side of the second photoelectric conversion region 124, and the transparent electrode film and the contact 150 are electrically connected. When the potential of the transparent electrode film and the potential of the electrode 148 are controlled by the voltage applied to the contact 150 and the voltage applied to the contact 126, the infrared light incident on the second photoelectric conversion region 124 is appropriately converted into charges to generate a signal. An example of the formation position of the contact 150 will be described.

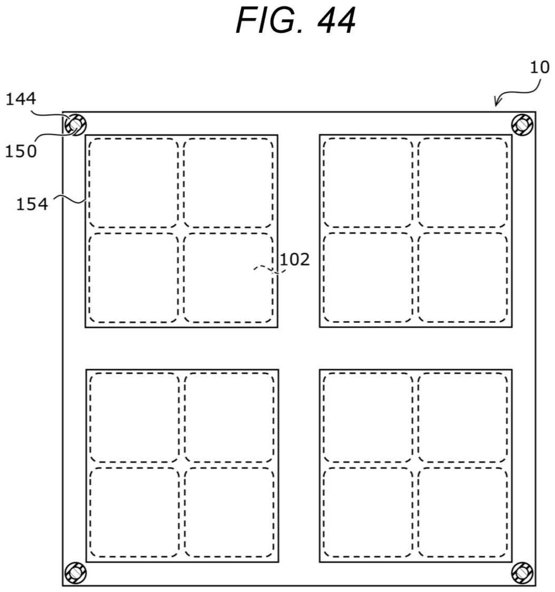

Fig. 44 is a partially transparent top view of the sensor unit 10 according to one embodiment. In the sensor unit 10, for example, as illustrated in the drawing, the second pixel 102 and a transparent electrode 154 for setting an appropriate potential on the incident surface side of the second photoelectric conversion region 124 of the second pixel 102 are arranged.

The transparent electrode 154 is an electrode having a low resistance value and having a transmission spectrum for at least infrared light. As the transparent electrode 154, indium tin oxide (ITO), indium zinc oxide (IZO), SnO₂, gallium-doped zinc oxide (GZO), aluminium-doped zinc oxide (AZO), another low-resistance transparent conductive film, or the like can be used as a non-limiting example.

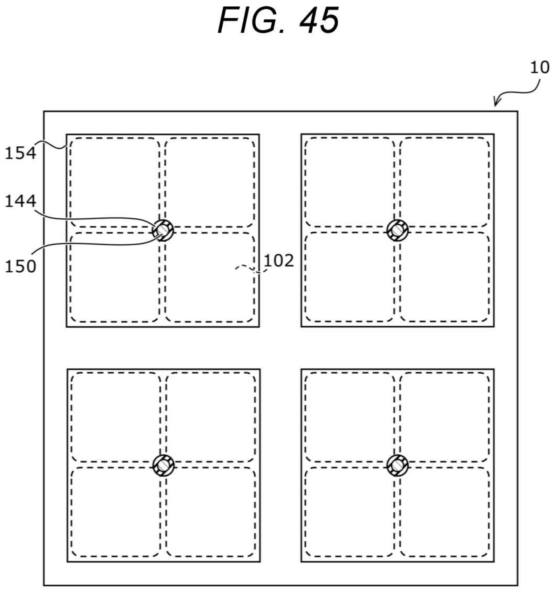

Note that in Fig. 44 and Fig. 45 to be described later, a wiring that electrically connects the contact 150 and the transparent electrode 154 is not illustrated. This is because these are diagrams for explaining the positional relationship between the contact 150 and the transparent electrode 154, and the contact 150 and the transparent electrode 154 are electrically connected by a wiring, a metal film, or a semiconductor film arranged at an appropriate position. Furthermore, the arrangement of the second pixels 102 is illustrated for easy understanding of the arrangement of the contacts 150 and the like, and for example, the second pixels 102 may be arranged at an equal pitch.

The transparent electrode 154 is formed on the incident surface side of the second photoelectric conversion region 124 of the second pixel 102. The transparent electrode 154 is controlled by a voltage applied via the contact 150.

As an example, the contact 150 that applies a voltage to the transparent electrode 154 can be arranged at a position away from the second pixel 102. Furthermore, the position may be away from the first pixel 100. Note that the insulating film 144 for appropriately cutting off electrical connection may be at least partially formed around the contact 150.

Note that the positional relationship between the contact 150, and the first pixel 100 and the second pixel 102 is not limited to the relationship illustrated in Fig. 44, and can be set to any distant position within a range that enables appropriate potential control.

Fig. 45 is a diagram illustrating another example of the arrangement of the contact 150. As illustrated in Fig. 45, the contact 150 may be arranged so as to overlap with a part of a plurality of second pixels 102. For example, the contact 150 may be arranged in the central portion of the 2×2 second pixels 102.

### <9. Manufacturing process of sensor including light shielding wall>

The infrared light shielding film 146 according to the present embodiment can be manufactured at various timings. The manufacturing process of the infrared light shielding film 146 in the drawings described above will be described with some examples.

As an example, the infrared light shielding film 146 can be formed following the process of forming the insulating film 144 at the timing of forming the second photoelectric conversion region 124. In the second substrate 14 in the above-described embodiment, the infrared light shielding film 146 may be formed together with the formation of the second photoelectric conversion region 124. In this case, the sensor unit 10 in which infrared light reaches the second pixel 102 via the first pixel 100 is manufactured by being stacked with the first pixel 100 formed on the first substrate 12.

As an example, in a case where the infrared light shielding film 146 includes the same material as that of the contact, the infrared light shielding film 146 can be formed after the first substrate 12 and the second substrate 14 are stacked.

As an example, after the second pixel 102 is formed, the first pixel 100 can be formed on the front surface side thereof. In this case, the infrared light shielding film 146 can be formed at the timing of forming the second photoelectric conversion region 124 of the second pixel 102 or the timing of forming a contact for the second photoelectric conversion region 124 of the second pixel 102.

That is, as an example, the solid-state imaging device includes the first pixel that receives light in the visible light band and generates a pixel signal in the visible light band, and the second pixel that is formed by being stacked with the first pixel and receives light in the infrared light band transmitted through the first pixel and generates a pixel signal in the infrared light band. This solid-state imaging device can be manufactured by a method including a manufacturing process of forming the photoelectric conversion region of the second pixel, then forming the sidewall of the photoelectric conversion region, and forming the infrared light shielding film on the side surface of the sidewall of the photoelectric conversion region.

As described above, the infrared light shielding film 146 according to the present embodiment can be formed by a process at any appropriate timing.

### <10. Fourth Embodiment: configuration of sensor including hole in wiring layer>

In a case where the stacked first pixel and second pixel are provided, it is desirable that the wiring layer between the first photoelectric conversion region of the first pixel and the second photoelectric conversion region of the second pixel is filled with a material that transmits at least light in the infrared band, and there are no or few other shields. Therefore, the wiring that transmits and receives the current, the voltage, and the like to and from the first pixel is formed in a region other than the upper surface of the second photoelectric conversion region in the wiring layer. On the other hand, when the metal wiring is formed in such a form, the insulating film to be filled is formed in a concave shape on the upper side of the second photoelectric conversion region due to the density difference of the metal wiring in the manufacturing process, and there arises a problem that it is difficult to planarize the upper surface in the manufacturing process.

The solid-state imaging device according to the present embodiment suppresses a decrease in incident light of infrared light to the second photoelectric conversion region, and solves this problem.

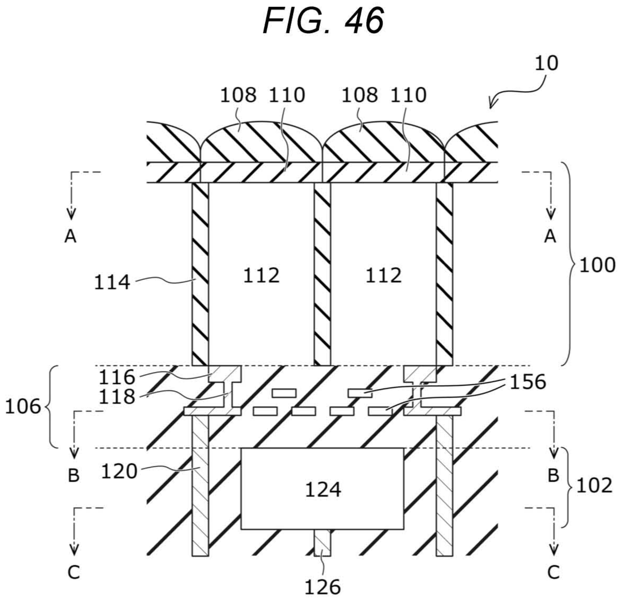

Fig. 46 is a diagram schematically illustrating the cross section of the sensor unit 10 according to one embodiment. The wiring layer 106 is provided with the wiring 118 similarly to each of the above-described embodiments, and is provided with a hole 156.

As illustrated in the drawing, the wiring 118 is not arranged on the upper portion of the second photoelectric conversion region 124 on the incident surface side, but is arranged so as to avoid the upper portion of the second photoelectric conversion region 124.

The hole 156 is arranged above the second photoelectric conversion region 124 in the wiring layer 106. The hole 156 may be filled with air, for example. Note that, although the hole 156 is illustrated as a rectangle, the present invention is not limited thereto, and the hole may be in a form of being connected to the upper, lower, left, and right, similarly to the wiring.

As will be described in detail later, in the manufacturing process, a dummy wiring is formed in the same process as that of the wiring 118, and the dummy wiring is removed in a subsequent process, whereby the hole 156 is formed so as not to shield infrared light.

The solid-state imaging device 1 according to the present embodiment includes, for example, the first pixel 100 that has the first photoelectric conversion region 112 that receives light in the visible light band and generates a pixel signal in the visible light band, the second pixel 102 that is formed by being stacked with the first pixel 100 and has the second photoelectric conversion region 124 that receives light in the infrared light band transmitted through the first photoelectric conversion region 112 and generates a pixel signal in the infrared light band, and the wiring layer 106 that is formed between the first pixel 100 and the second pixel 102 and in which the wiring 118 that propagates a signal output from the first pixel 100 is arranged. The wiring layer 106 includes, for the first pixel and the second pixel that are stacked, the above-described wiring 118 in a region that is not between the first photoelectric conversion region 112 and the second photoelectric conversion region 124.

The wiring 118 may be, for example, a metal, and more specifically, may be at least one of Cu, W, Ti, or Al, an alloy containing at least one, or the like. As another example, the wiring 118 may include a semiconductor film such as polysilicon.

Furthermore, the wiring layer 106 may not include, for the first pixel 100 and the second pixel 102 that are stacked, the wiring 118 between the first photoelectric conversion region 112 and the second photoelectric conversion region 124, and the hole 156 that transmits the light in the infrared light band transmitted through the first pixel 100 may be formed between the first photoelectric conversion region 112 and the second photoelectric conversion region 124.

### <11. Modification: another example of hole>

The cross section of the hole 156 may not be rectangular, and furthermore, a filler need not be air. The following are some non-limiting examples. Hereinafter, only the inside of the wiring layer 106 may be illustrated, but the wiring layer 106 is formed between the first pixel 100 and the second pixel 102, similarly to Fig. 46 and the like.

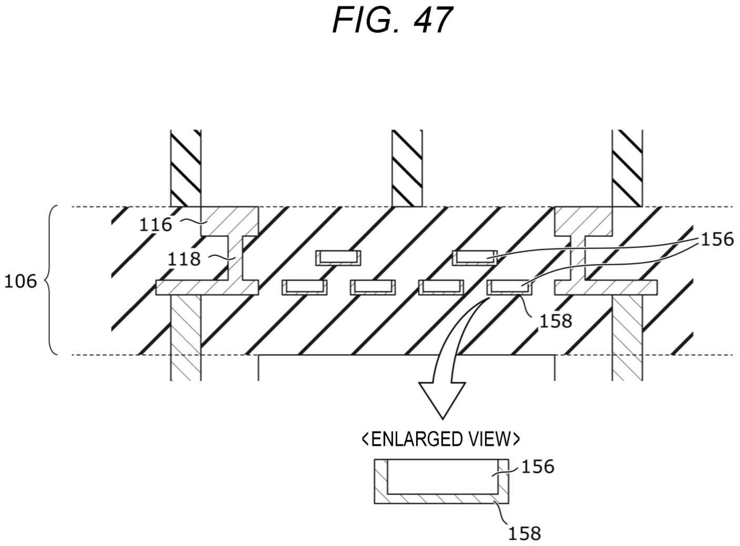

Fig. 47 is a diagram illustrating another example of the hole 156. The hole 156 may include an antireflection film 158. As illustrated in the drawing, the antireflection film 158 may be arranged below the air existing region of the hole 156. The antireflection film 158 may be a barrier metal of the wiring 118, or may include other conductors or semiconductors.

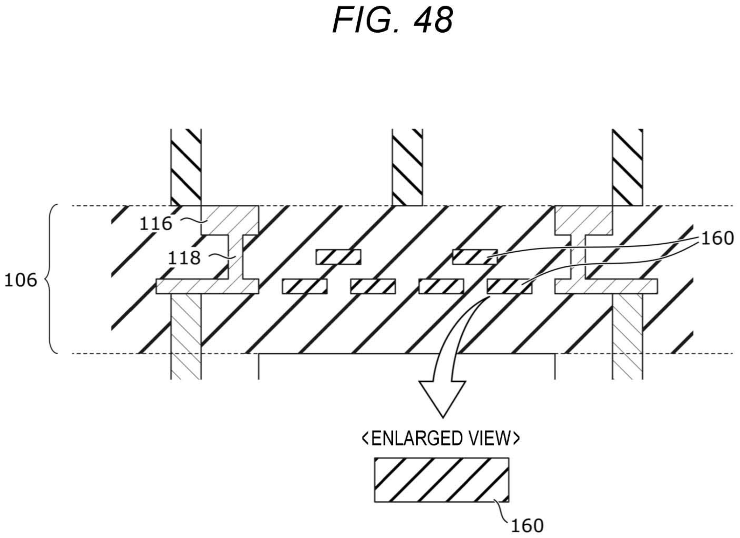

Fig. 48 is a diagram illustrating another example of the hole 156. In the above example, the hole 156 is filled with air, but the present invention is not limited thereto. An insulating film 160 may be formed in the hole 156. The insulating film 160 includes an insulating material that forms the wiring layer 106, for example, an insulating material different from silicon nitride (SiN) or SiO₂. Specifically, the insulating film 160 may include a silicon nitride carbide (SiCN) film as a non-limiting example.

Furthermore, although the insulating film 160 is used in Fig. 48, a semiconductor film having a high transmission characteristic with respect to infrared light may be used. The hole 156 may be filled with a semiconductor film such as polysilicon, for example, instead of the insulating film 160.

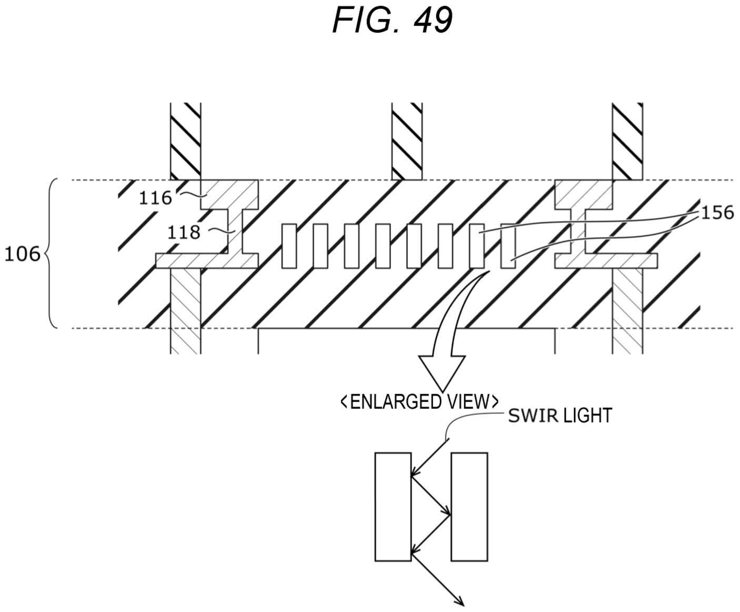

Fig. 49 is a diagram illustrating another example of the hole 156. As illustrated in this drawing, the hole 156 may be formed so as to totally reflect infrared light, particularly short-wave infrared light in relation to the insulating film forming the wiring layer 106. By totally reflecting infrared light between the hole 156 and the insulating film forming the wiring layer 106, the infrared light transmitted through the first photoelectric conversion region 112 can be more efficiently incident on the second photoelectric conversion region 124.

Furthermore, with such a configuration, it is possible to suppress incidence of infrared light on the other second pixels 102.

Also in the case of Fig. 49, the inside of the hole 156 may be filled with an insulator or a semiconductor. In this case, the insulator or the semiconductor may include a material that performs total reflection in consideration of an incident angle of the infrared light transmitted through the first photoelectric conversion region 112 and incident on the second photoelectric conversion region 124, reaching the side surface of the hole 156, at a boundary with the insulator forming the wiring layer 106.

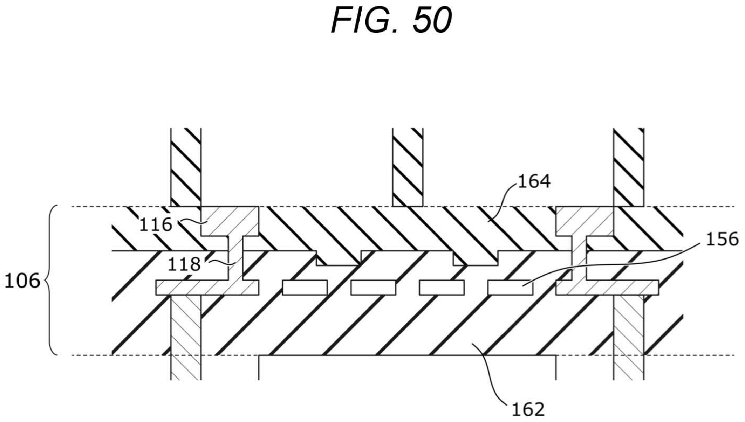

Fig. 50 is a diagram illustrating another example of the wiring layer 106. In each of the forms described above, the wiring layer 106 includes the same insulating material, but the present invention is not limited thereto. As illustrated in Fig. 50, the wiring layer 106 may include two types of insulating films 162 and 164.

An insulating film 162 forms the lower portion of the wiring layer 106, and an insulating film 164 forms the upper portion of the wiring layer 106. By forming unevenness at a boundary between the insulating film 162 and the insulating film 164, planarization can be appropriately realized in the manufacturing process similarly to the hole 156 described above.

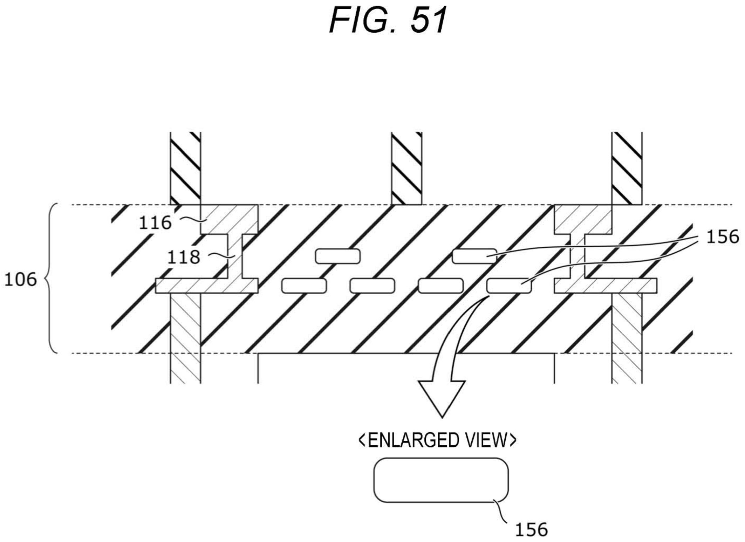

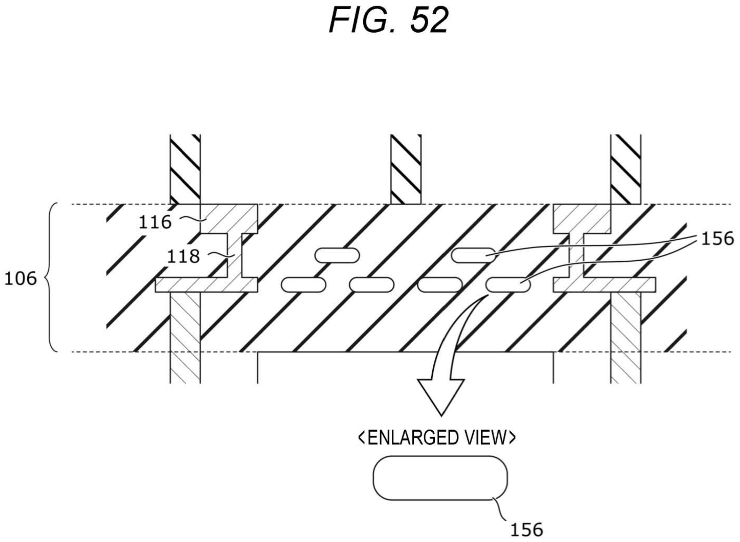

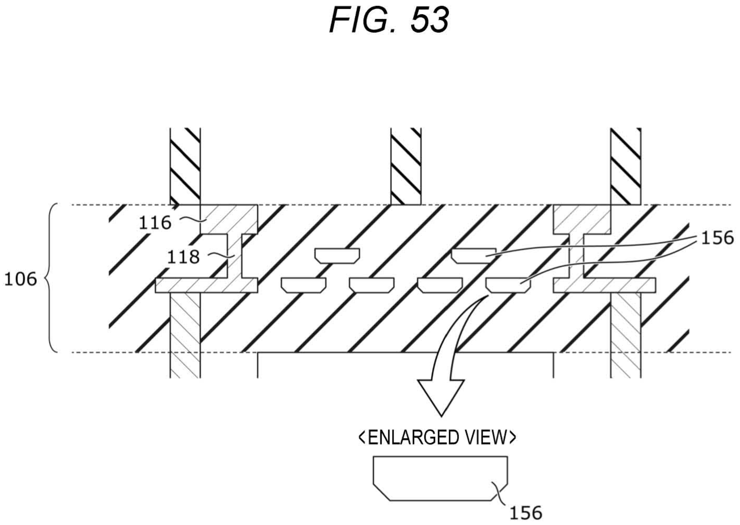

Figs. 51 to 53 are diagrams illustrating non-limiting examples of the cross-sectional shape of the hole 156. As illustrated in Fig. 51, the hole 156 may have a rounded rectangular shape. As illustrated in Fig. 52, the hole 156 may have a rectangular shape with a circular short side. As illustrated in Fig. 53, the hole 156 may have a rectangular shape in which a taper is formed.

This shape can be determined on the basis of convenience in the manufacturing process, the strength of the material, and the like.

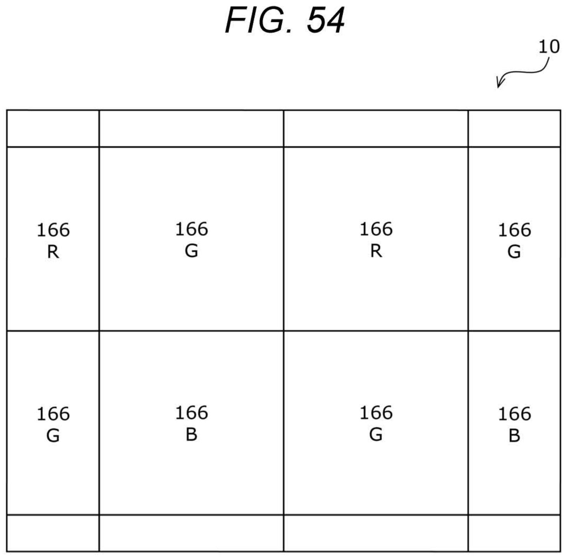

Next, a cross-sectional view from the upper surface in the example of Fig. 46 will be described. Figs. 54, 55, and 56 are a cross-sectional view taken along line A-A, a cross-sectional view taken along line B-B, and a cross-sectional view taken along line C-C in Fig. 46, respectively. Note that these drawings do not illustrate an aspect ratio or an accurate position, and do not exactly match the positional relationship with Fig. 46.

In the cross section A-A illustrated in Fig. 54, color filters 166 corresponding to R, G, and B are arranged. By acquiring incident light in the first photoelectric conversion region 112 via the color filters, the first pixel 100 can acquire information for every color in the visible light band.

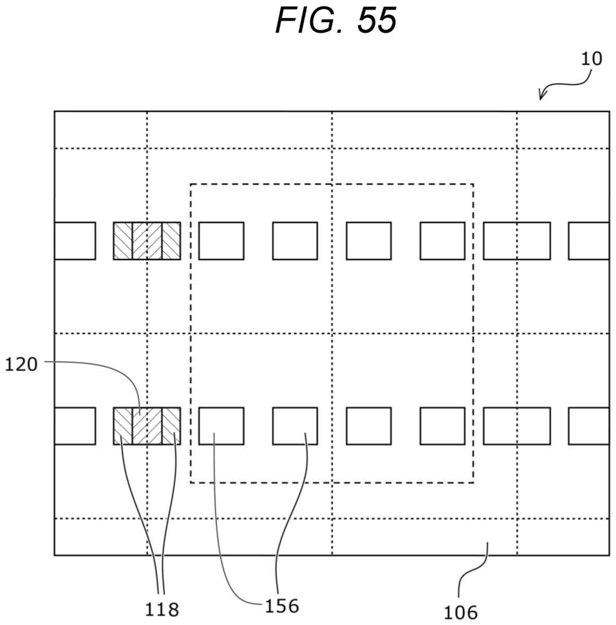

In the cross section B-B illustrated in Fig. 55, the hole 156, the contact 120, and the wiring 118 provided in the wiring layer 106 are illustrated. A dotted line indicates the projection of the boundary of the color filters 166 illustrated in Fig. 55. A broken line indicates the see-through view of the boundary of the second photoelectric conversion region 124.

As illustrated in this drawing, in the top view as viewed from the incident surface side, the wiring 118 and the contact 120 are arranged so as not to overlap with each other in the second photoelectric conversion region 124, and the hole 156 is arranged so as to overlap with the second photoelectric conversion region 124. By arranging the wiring 118 and the contact 120, it is possible to form the wiring that does not block infrared light incident on the second photoelectric conversion region 124.

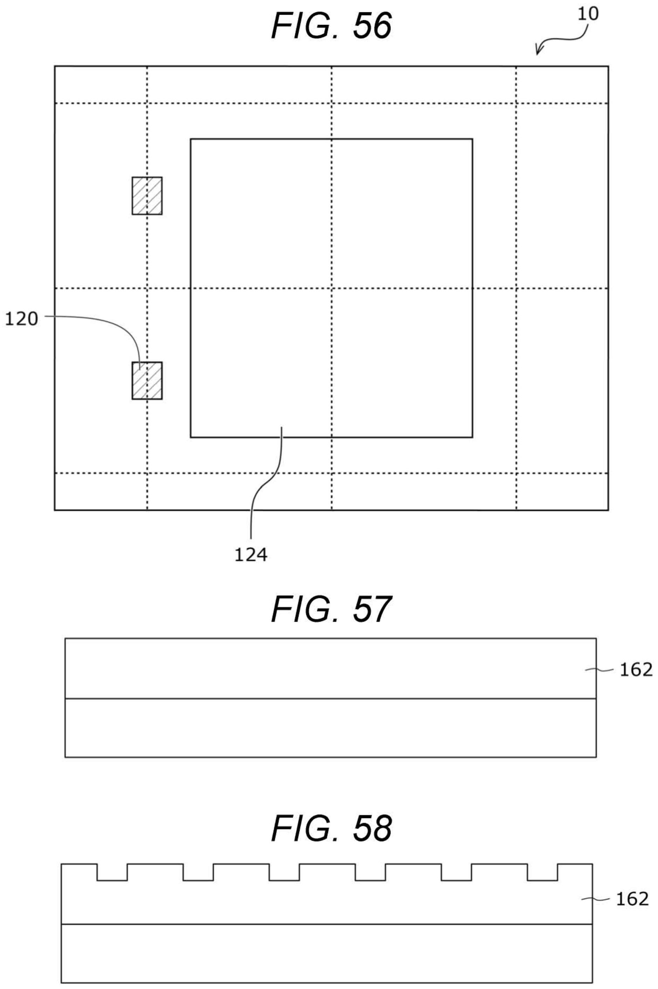

In the cross section C-C illustrated in Fig. 56, the second photoelectric conversion region 124 is arranged. A dotted line indicates the boundary of the color filters 166 in a manner similar to the above. Note that in this drawing, the configuration, such as an insulating film, around the second photoelectric conversion region 124 is not illustrated.

As illustrated in Fig. 56, the second photoelectric conversion region 124 is formed at a position away from the contact 120. As compared with Fig. 55, the infrared light transmitted through the hole 156 is appropriately incident on the second photoelectric conversion region 124.

### <12. Manufacturing process of sensor including hole>

The wiring layer 106 can be formed from either the first pixel 100 side or the second pixel 102 side. The formation of the wiring layer 106 is realized at an appropriate timing by the manufacturing process or the like. In this chapter, only the formation of the wiring 118 and the like in the wiring layer 106 is described, and illustration of configurations other than the wiring 118 and the like, for example, the pixel transistor 116, the contact 120, and the like is omitted. The omitted components are formed at an appropriate timing as in the embodiments described above.

First, as illustrated in Fig. 57, a wiring or the like connected to an appropriate pixel is formed, and then the insulating film 162 constituting the wiring layer 106 is formed.

Next, as illustrated in Fig. 58, a region for forming the wiring 118 and the hole 156 is formed. This region can be formed, for example, by selectively removing the upper surface of the insulating film 162.

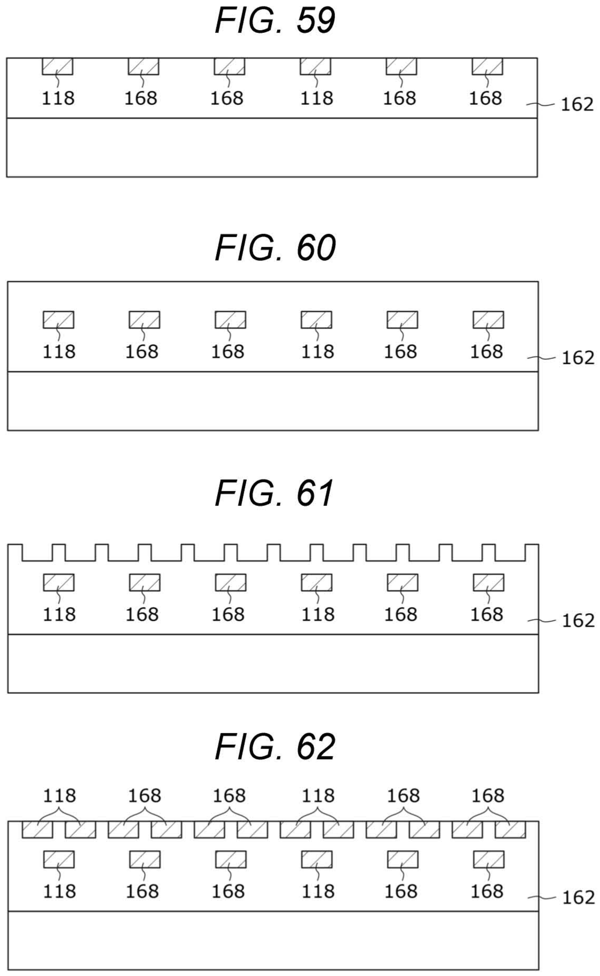

Next, as illustrated in Fig. 59, the wiring 118 and a dummy wiring 168 are formed in the selectively removed region. This formation can be realized in the same process. That is, the wiring 118 and the dummy wiring 168 may include the same material. If necessary, a process of forming a barrier metal in the removed region can be interposed as a process before forming a metal or the like as the material of these wirings.

Next, as illustrated in Fig. 60, after the upper surfaces of the wiring 118, the dummy wiring 168, and the insulating film 162 are polished or etched to be planarized, the insulating film 162 is further formed.

Next, as illustrated in Fig. 61, the insulating film 162 is selectively removed.

Next, as illustrated in Fig. 62, the wiring 118 and the dummy wiring 168 are formed.

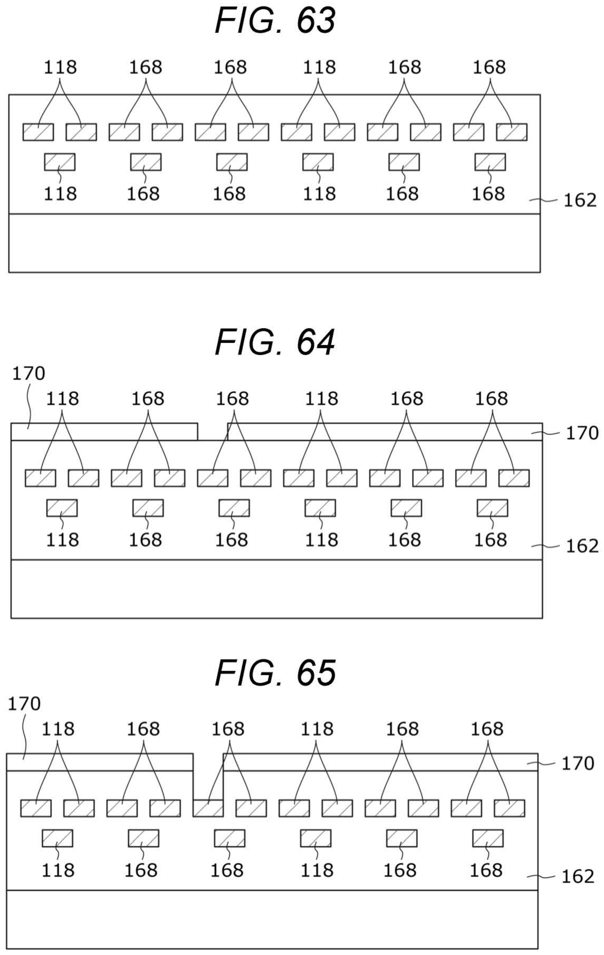

Next, as illustrated in Fig. 63, after the upper surfaces of the wiring 118 and the dummy wiring 168 are planarized, the insulating film 162 is formed on the planarized upper surface.

Next, as illustrated in Fig. 64, in order to remove the dummy wiring 168, a mask 170 is formed so that the wiring 118 is not removed.

Next, as illustrated in Fig. 65, a trench is formed up to the dummy wiring 168 in the insulating film 162. As an example, a trench reaching the dummy wiring 168 is formed by dry etching the insulating film 162.

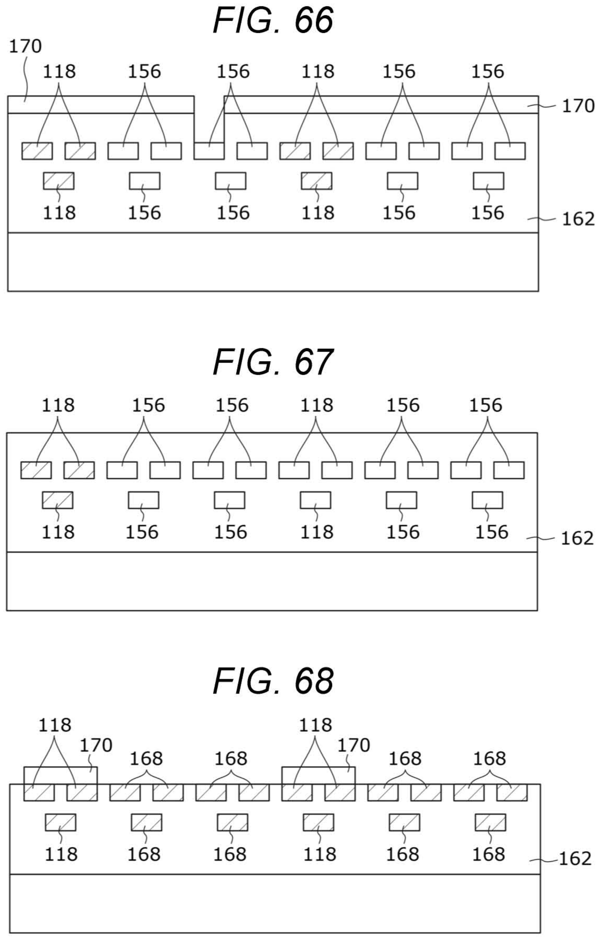

Next, as illustrated in Fig. 66, for example, the metal or the like forming the dummy wiring 168 is removed by wet etching. For example, the dummy wirings 168 in the cross-sectional view may be formed by being connected to each other, and all the connected dummy wirings 168 are removed in this process.

If necessary, the formation of the mask 170 and the trench in Figs. 64 to 65 can be executed for a plurality of dummy wirings 168, and the dummy wirings 168 can be removed from a plurality of portions by wet etching.

Next, as illustrated in Fig. 67, the wiring layer 106 can be formed by filling the trench with the insulating film 162 and planarizing the upper surface. The subsequent processes can be realized in a manner similar to the embodiment described above. Furthermore, it is also possible to form the wiring layer 106 by forming the wiring layer on both the first pixel 100 side and the second pixel 102 side and bonding the wiring layers formed on both sides as necessary.

As another example, the process of removing the dummy wiring 168 may be performed after the process of Fig. 60. That is, in a case where the hole 156 is configured in multiple stages, the process of removing the dummy wiring 168 can be performed for every configuration of one stage.

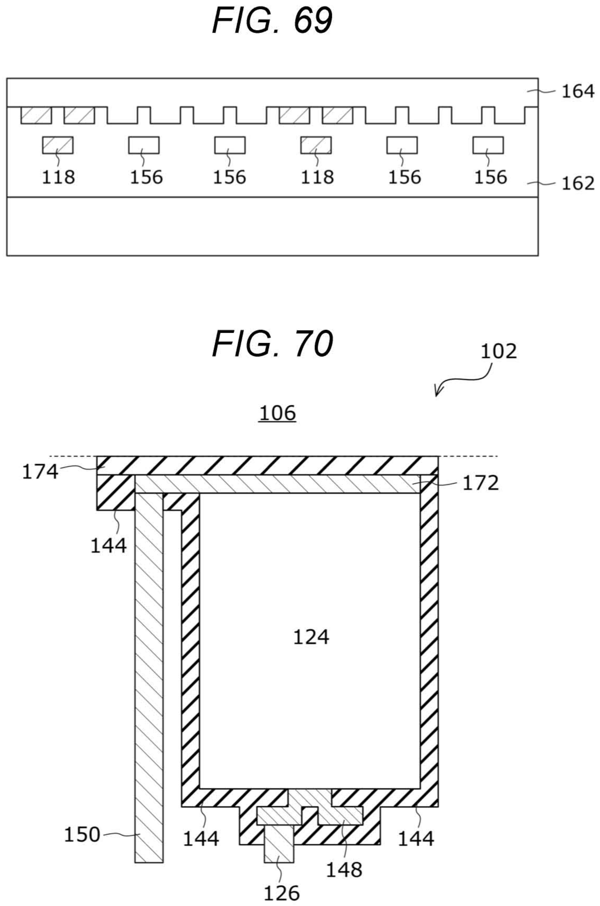

In a case where the hole 156 is filled with the insulating film 164 as in the example illustrated in Fig. 50, after the process of Fig. 62, the mask 170 is selectively formed on the upper surface of the wiring 118 as illustrated in Fig. 68, and the dummy wiring 168 is removed. Then, after the removal, as illustrated in Fig. 69, the insulating film 164, for example, a tetraethyl orthosilicate (TEOS) film is formed on the upper surface thereof, and the upper surface is planarized, whereby the wiring layer 106 of the example of Fig. 50 can be formed.

According to the wiring layer 106 of the present embodiment, a shielding structure for the infrared light sensor can be removed, and the infrared light can be more efficiently taken in. Furthermore, according to the manufacturing process according to the present embodiment, it is possible to suppress distortion due to the formation of holes and appropriately planarize the upper surface.

### <13. Fifth embodiment: configuration of electrode arrangement in second pixel>

In some embodiments described above, the aspect in which the transparent electrode is provided on the incident surface side of the second pixel 102 has been described. In the present embodiment, the transparent electrode in the second pixel 102 will be described in detail. Here, the transparency of the transparent electrode in the second pixel 102 refers to being transparent to infrared light, that is, it is sufficient if the transparent electrode transmits light in a desired band of the infrared light band, and the transparent electrode is not necessarily transparent to light in the visible light band.

Basically, in the present embodiment, a form in which a first electrode is provided on the incident surface side of the second photoelectric conversion region 124 and a second electrode is provided on the opposite side of the incident surface will be described. The first electrode of the second photoelectric conversion region 124 may be not a transparent electrode but another electrode (semiconductor film and metal electrode), and this case will also be described as a modification.

In this chapter, only the second pixel 102 is focused. First, a basic configuration of the electrode of the second pixel 102 will be described, and the positional relationship between the modification and the first pixel 100 will be described in the next chapter.

Fig. 70 is a diagram schematically illustrating an example of the configuration of the sensor unit 10 according to one embodiment, particularly, the second pixel 102. The second pixel 102 converts incident light in the second photoelectric conversion region 124 into an electric signal and outputs the electric signal. The second pixel 102 includes a transparent electrode 172 (first electrode) and a transparent insulating film 174 in addition to the second photoelectric conversion region 124.

The transparent electrode 172 is an electrode that transmits at least light in the infrared band, and is provided on the light incident surface side of the second photoelectric conversion region 124. The transparent electrode 172 is equivalent to the transparent electrode 154 in the above-described embodiment. The transparent electrode 172 can include, for example, ITO, IZO, SnO₂, GZO, AZO, or another low-resistance transparent conductive film having high transmission characteristics for infrared light.

The transparent electrode 172 is electrically connected to the contact 150, and can control the potential via the contact 150. By controlling the potential of the transparent electrode 172, charges generated by incident light in the second photoelectric conversion region 124 can be transferred to the electrode 148 via the diffusion layer formed around the electrode 148 (second electrode) of the second photoelectric conversion region 124 with higher efficiency.

The transparent insulating film 174 is formed, for example, as an interlayer insulating film between the second pixel 102 and the wiring layer 106. The transparent insulating film 174 includes, for example, a material such as TEOS. The transparent insulating film 174 may be, for example, a dielectric film of a silicon compound containing any one or more of SiO2, silicon oxynitride (SiON), SiN, silicon oxide (SiOC), SiCN, phosphorous silicate glass (PSG), boro phospho silicate glass (BPSG), or fluorine-doped silicate glass (FSG), or may be a resin such as polyimide such as Al₂O₃ or Sc203.

With such a configuration, infrared light can be incident on the second photoelectric conversion region 124 via the transparent insulating film 174 and the transparent electrode 172, and charges generated in photoelectric conversion can be appropriately propagated to the electrode 148.

### <14. Modification : another example of electrode arrangement>

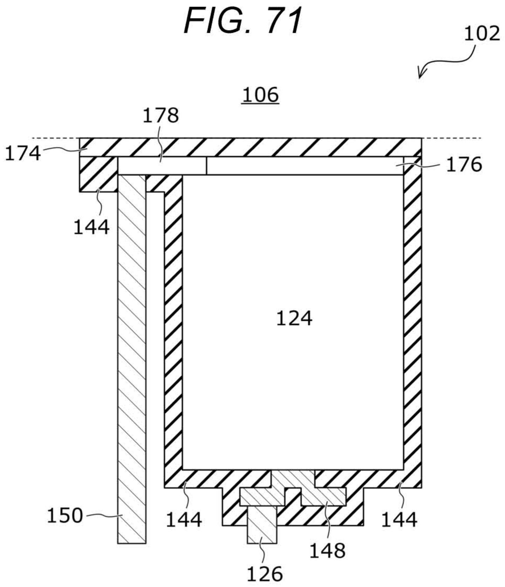

Fig. 71 is a diagram illustrating a modification in a case where the transparent electrode 172 is not provided. In this case, instead of the transparent electrode 172 as the first electrode, a diffusion layer formed on the incident surface side of the second photoelectric conversion region 124 can be used instead of the electrode.

A first diffusion layer 176 is a diffusion layer including a semiconductor formed on the incident surface side of the second photoelectric conversion region 124. The first diffusion layer 176 may be a thin film including n type InP, for example, undoped InP.

A second diffusion layer 178 is, for example, an n+ type diffusion layer formed using the same material as that of the second photoelectric conversion region 124. For example, the second diffusion layer 178 may be formed by expanding, along the incident surface, a diffusion layer formed via a thin film such as an insulating film (SiN, aluminum oxide (Al₂O₃)) formed on the side surface and the bottom surface of the second photoelectric conversion region 124.

The contact 150 is electrically connected to the second diffusion layer 178, and can control the potential of the first diffusion layer 176 via the second diffusion layer 178. The application of the voltage by the first diffusion layer 176 can achieve an effect similar to that of Fig. 70.

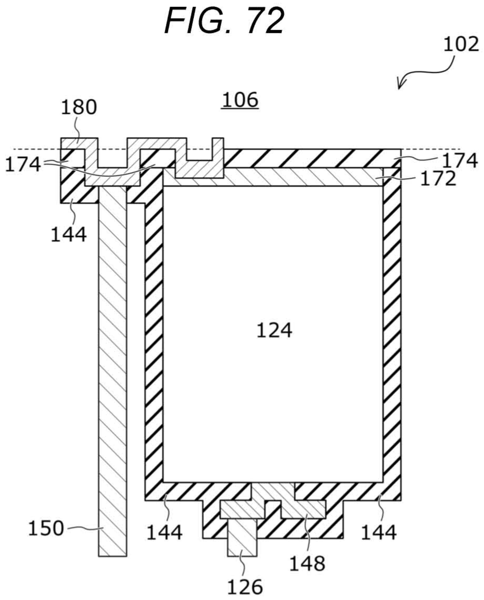

Fig. 72 is a diagram illustrating another example of a case where the transparent electrode 172 is provided. For example, in a case where it is difficult to form arrangement in which the transparent electrode 172 and the contact 150 are connected directly, the configuration of the form of Fig. 72 can be adopted.

An electrode 180 connects the transparent electrode 172 and the contact 150 on the wiring layer 106 side. The electrode 180 may be an alloy including at least one or more elements of gold (Au), nickel (Ni), palladium (Pd), W, Al, Cu, or Ti as a non-limiting example.

The contact 150 is electrically connected to the electrode 180, and applies a voltage to the transparent electrode 172 via the electrode 180. The electrode 180 selectively penetrates a part of the transparent insulating film 174 and is electrically connected to the transparent electrode 172. With this electrical connection, the potential of the transparent electrode 172 can be controlled via the contact 150. As a result, an effect similar to the above can be obtained.

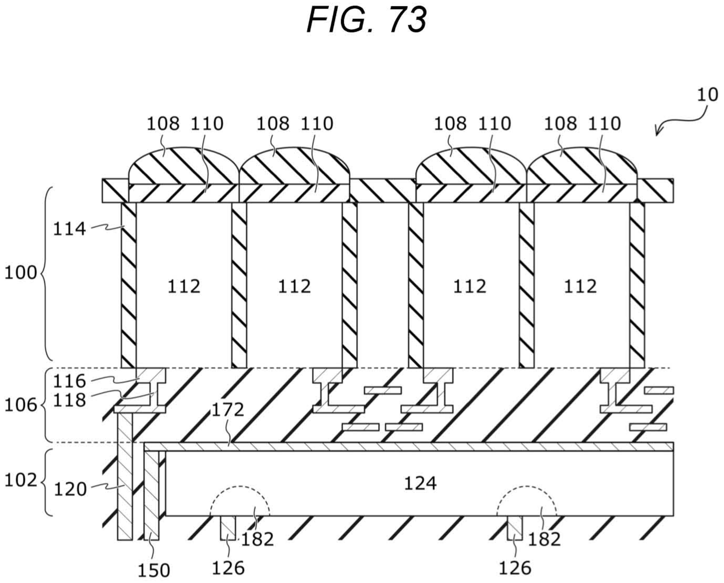

Fig. 73 is a diagram illustrating the relationship between the first pixel 100 and the second pixel 102. In the drawing, similarly to the drawings according to the above-described embodiments, it should be noted that illustration other than characteristic portions are omitted, but necessary configurations are included appropriately.

As described in each of the above-described embodiments, a form may be adopted in which the second pixel 102 stacked on the first pixel 100 and having an element isolation film is provided, or a form may be adopted in which the element isolation film is not provided and the second photoelectric conversion region 124 is shared by a plurality of second pixels 102 as illustrated in Fig. 73.

In this case, by appropriately forming a diffusion region 182 in the second photoelectric conversion region 124 that is shared, the range of pixels that acquire the signal of the second pixel 102 and the electrical connection to the contact 126 that transfers the acquired signal can be made clearer.

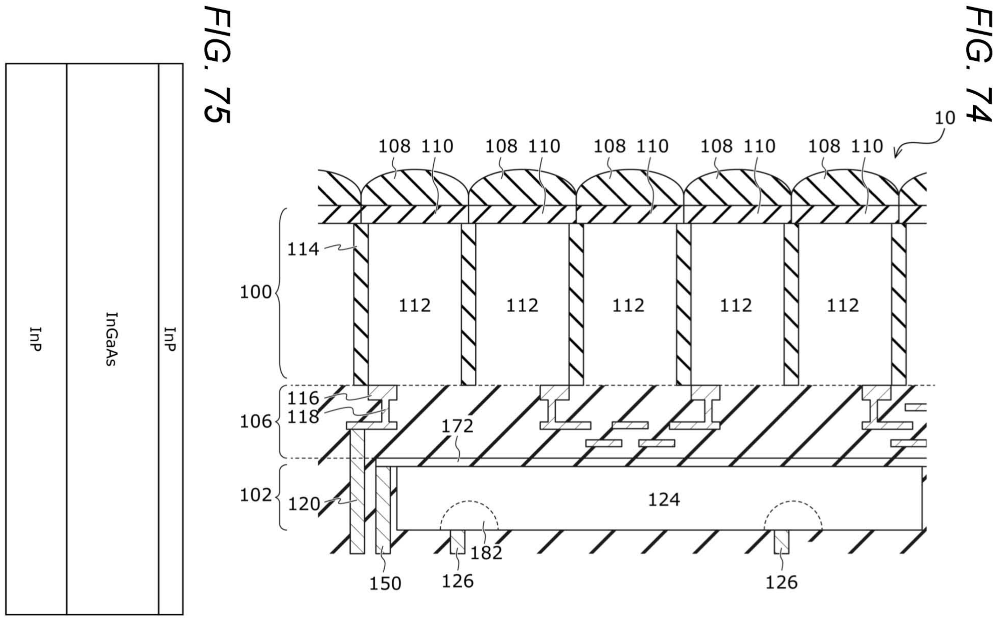

Fig. 74 is a diagram illustrating another example in which the second photoelectric conversion region 124 is shared. The present invention is not limited to a configuration in which the range of the second pixel 102 is stacked for all the first pixels 100 as illustrated in this drawing. For example, in some of the first pixels 100, the corresponding second pixel 102 may not exist.

Such a form is similar not only in a case where the second photoelectric conversion region 124 is shared, but also in cases where each second pixel 102 has the second photoelectric conversion region 124 that is element-isolated. That is, even in the case illustrated in Fig. 3 and the like, the first pixel 100 that is not stacked with the second pixel 102 may be provided.

In the case of having the element isolation film, the contact 120 electrically connected to the first pixel 100 and the contact 150 for applying a voltage to the first electrode (for example, the transparent electrode 172) on the incident surface side of the second pixel 102 may be formed in the element isolation film.

### <15. Manufacturing process of electrode in second pixel>

The manufacturing process of the second pixel 102 described above will be described. Note that the material is shown as an example, and is not limited to the following description. Furthermore, in this chapter, focusing on the manufacturing process of the second pixel 102, the manufacturing process of the first pixel 100 and the wiring layer 106 is omitted, but can be formed in a manner similar to that of each of the above-described embodiments.

First, as illustrated in Fig. 75, a material such as InGaAs for forming the second photoelectric conversion region 124 is formed on the InP substrate. If necessary, an insulating layer and a semiconductor layer are formed as layers on the upper surface or the lower surface of InGaAs. InGaAs can be formed by epitaxial growth, for example. An InP layer is formed on the upper surface of the formed InGaAs.

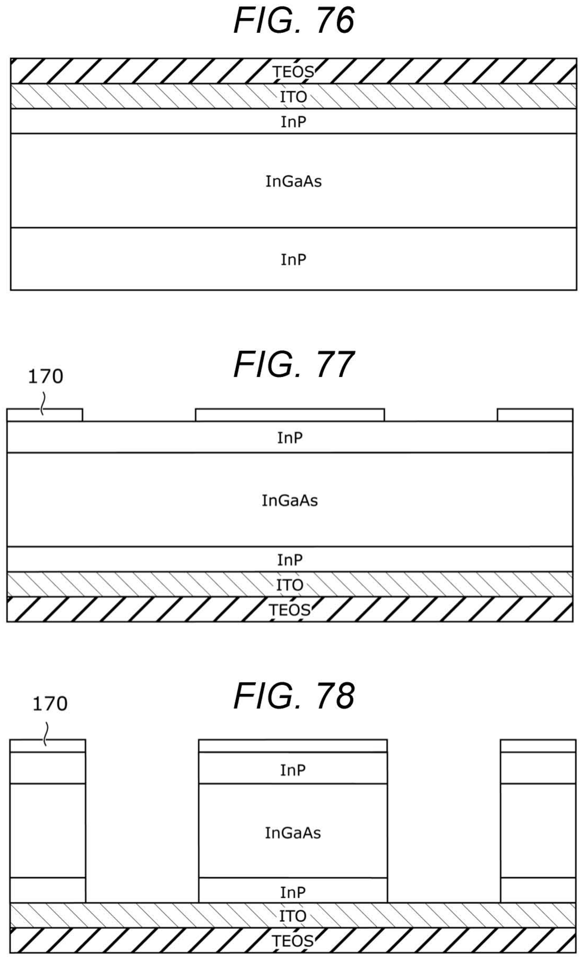

Next, as illustrated in Fig. 76, an ITO layer to be finally the transparent electrode 172 (first electrode) and TEOS to be the transparent insulating film are formed on the upper surface of the InP layer. In a form in which the second pixel 102 does not include the transparent electrode 172, the formation of the ITO layer is omitted.

Next, as illustrated in Fig. 77, the upper and lower sides are reversed, the InP substrate is removed by etching or the like as much as necessary, and preparation is made for forming a connection contact with the first pixel 100 in the wiring layer 106 and a connection contact with the transparent electrode of the second pixel 102. First, the substrate is removed as much as necessary by wet etching or the like. Subsequently, the mask 170 is formed so that the trench can be located at an appropriate position.

Note that a SiN film may be formed as an interlayer insulating film so as to be in contact with the TEOS film at timings before and after inversion. The SiN film may be formed on a substrate on a side on which the inverted second photoelectric conversion region 124 is stacked, or the SiN film may be formed on the front surface of the TEOS film and then inverted and stacked on the substrate.

For example, the first pixel 100 and the wiring layer 106 may already be formed on the substrate. In this case, the process may be configured such that the SiN film is formed on the upper surface of the wiring layer 106, and the TEOS film is stacked so as to overlap with the upper surface of the SiN film.

Next, as illustrated in Fig. 78, a trench is formed so that the ITO layer is exposed on the upper surface. The trench is formed by, for example, anisotropic etching of dry etching.

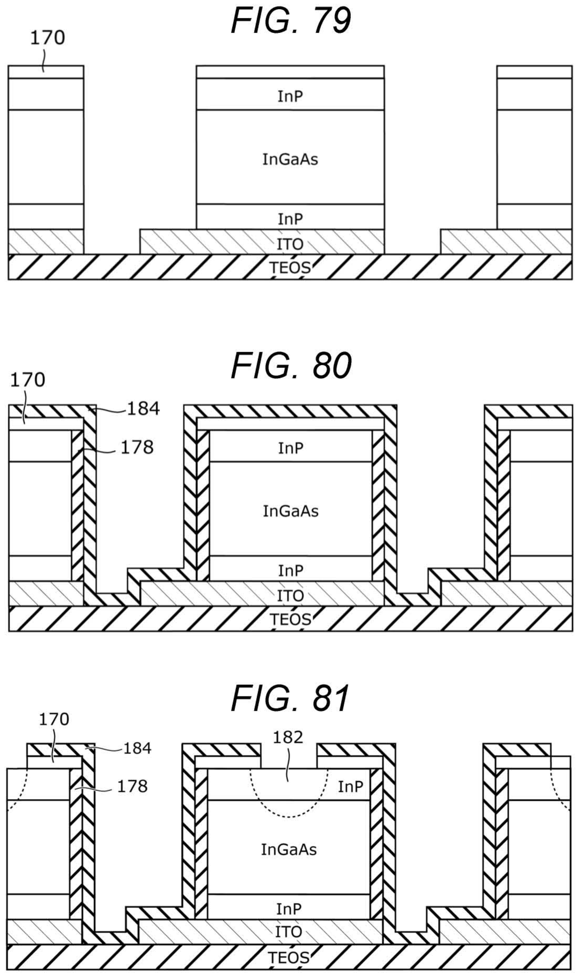

Next, as illustrated in Fig. 79, the ITO layer is selectively removed. Also in the selective removal of the ITO layer, for example, anisotropic etching is performed after a mask is formed.

Next, as illustrated in Fig. 80, a protective film 184 is formed, and the second diffusion layer 178 is formed as necessary. The second diffusion layer 178 can be formed, for example, by applying heat to activate the sidewall.

Next, as illustrated in Fig. 81, a Zn diffusion mask is formed to selectively remove the upper surface, and Zn is diffused to form the diffusion region 182.

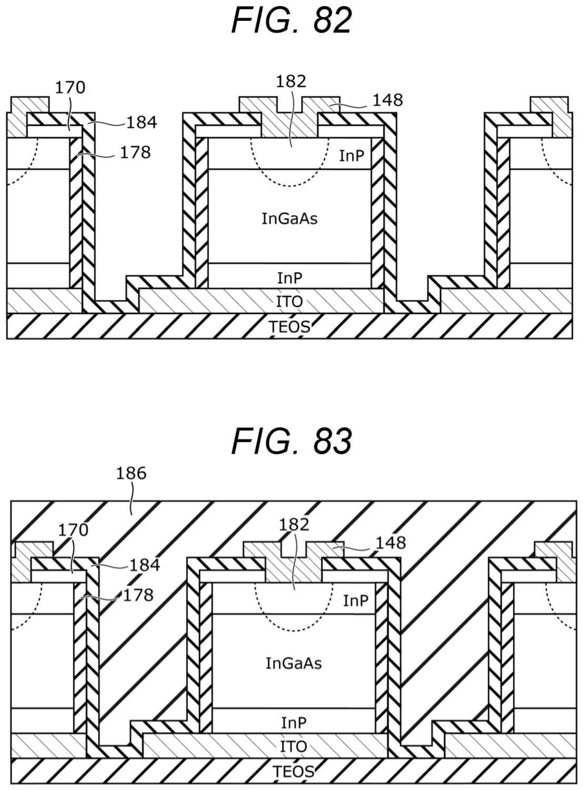

Next, as illustrated in Fig. 82, the electrode 148 to be the second electrode is formed.

Next, as illustrated in Fig. 83, an interlayer insulating film 186 is formed, and the upper surface is planarized. Note that although not illustrated in the drawings, another protective film may be formed as necessary.

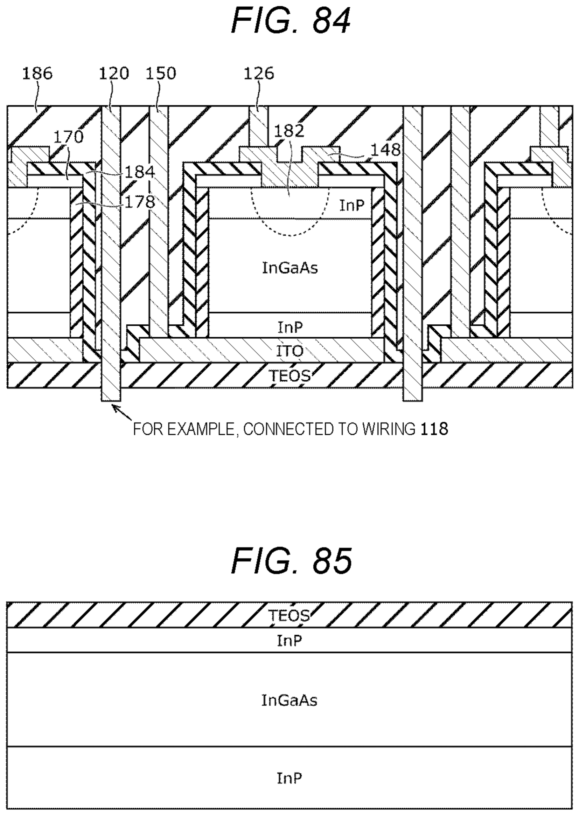

Thereafter, as illustrated in Fig. 84, the regions of the second pixel 102 and the second pixel 102 can be formed by forming a necessary contact. Note that although the contact 120 protrudes downward, the contact 120 is formed so as to be connected to the wiring 118 of the wiring layer 106 already formed below the TEOS film.

Although the case where the contact 150 is directly connected to the transparent electrode 172 has been described above, next, a case where the contact 150 is connected to the transparent electrode 172 via an electrode on the wiring layer 106 side will be described.

First, as illustrated in Fig. 85, the TEOS film is formed on the upper surface of an InP film after the process of Fig. 75.

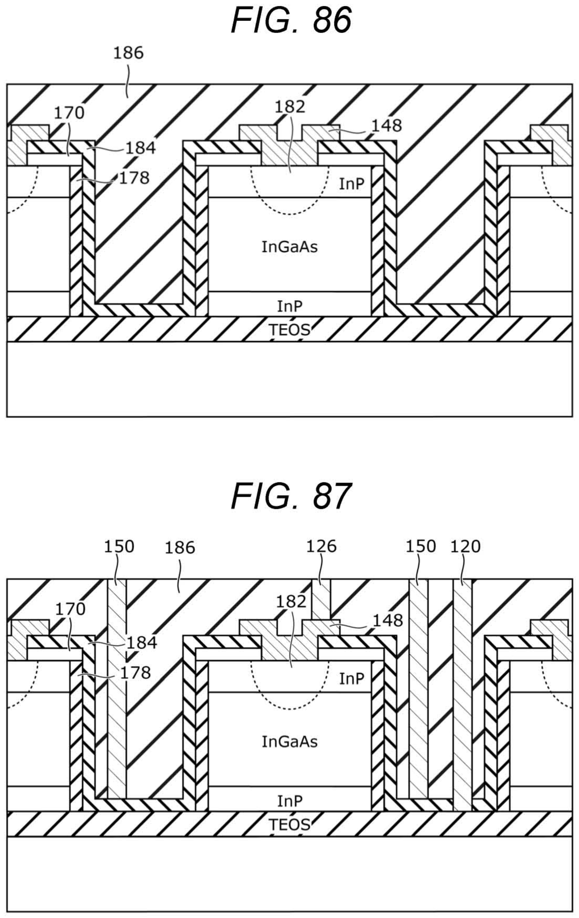

Next, the semiconductor layer of Fig. 86 is formed through the same processes as the above except for the selective removal of the ITO film. Note that at the time of inversion, the TEOS film may be stacked on a support substrate as illustrated in the drawing.

Next, as illustrated in Fig. 87, necessary contacts are formed. The depth of each contact is appropriately determined according to the position of the electrode to which each contact is connected.

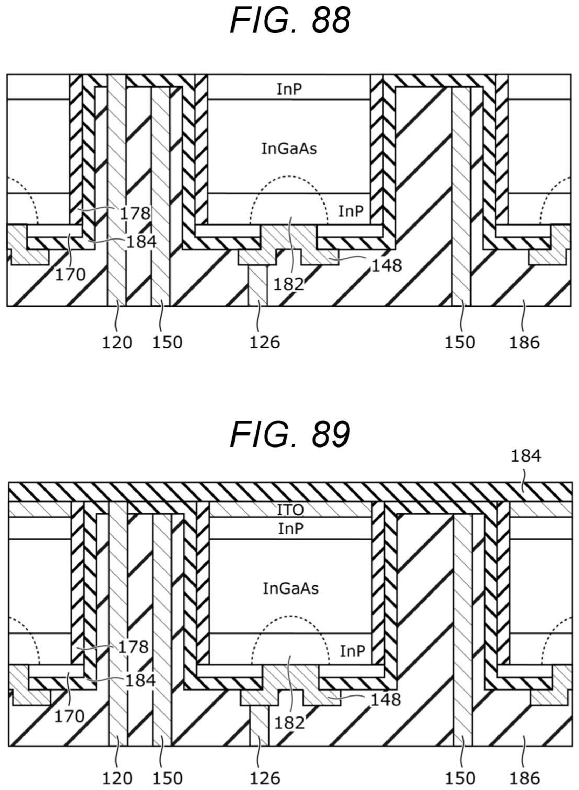

Next, as illustrated in Fig. 88, the upper and lower sides are reversed again, and processing such as peeling of the support base on the upper surface is performed.

Next, as illustrated in Fig. 89, an ITO electrode for forming the transparent electrode 172 to be the first electrode and the protective film 184 are formed.

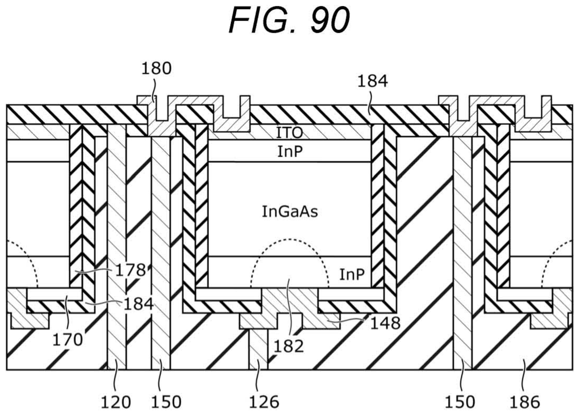

Next, as illustrated in Fig. 90, the electrode 180 to be a third electrode for electrically connecting the contact 150 and the transparent electrode 172 (ITO electrode) is formed. The electrode 180 can be formed by forming a trench at an appropriate depth on the upper side of the contact 150 and a part of the upper side of the ITO electrode and selectively forming a metal film.

After the electrode 180 is formed, the second pixel 102 of the present embodiment can be formed by forming an appropriate interlayer insulating film and extending and connecting the contact 120.

As described above, according to the present embodiment, by adopting the structure in which the electrodes are provided on the upper and lower sides in the second photoelectric conversion region 124, it is possible to make the gradient of the potential of the photoelectric conversion region uniform, and thus, it is possible to enhance the conversion efficiency and to suppress the residual charge converted at the previous pixel signal acquisition timing to suppress afterimages.

### <16. Sixth embodiment: configuration of arrangement of first pixel and wiring line>

In each of the above-described embodiments, the relationship between the second pixel 102 and the wiring 118 has been mainly described. However, in the present embodiment, a non-limiting example of the positional relationship between the first pixel 100 in the sensor unit 10 and the wiring 118 of the wiring layer 106 will be described.

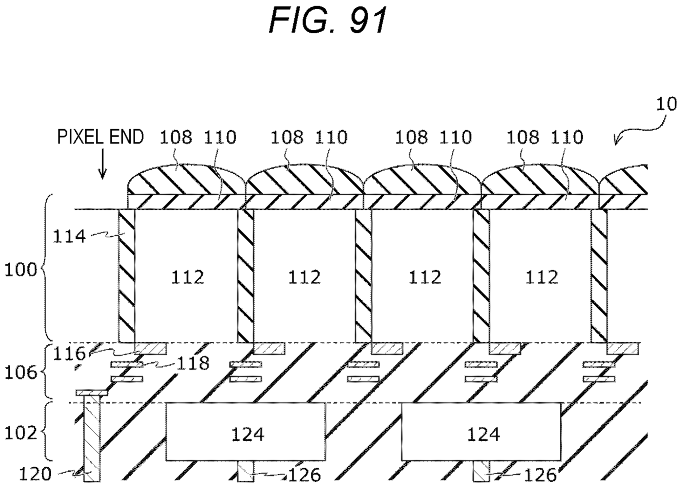

Fig. 91 is a cross-sectional view schematically illustrating an example of the sensor unit 10 of the solid-state imaging device 1 according to one embodiment. As illustrated in this drawing, in the wiring layer 106 between the first pixel 100 and the second pixel 102, the wiring 118 may be provided below the light shielding film 114 that is an element isolation portion of the first pixel 100.

By providing the wiring 118 below the element isolation portion, the infrared light transmitted through the first photoelectric conversion region 112 can be reflected by the wiring 118 and incident on the appropriate second photoelectric conversion region 124.

The wiring 118 is appropriately connected below the light shielding film 114 that is the element isolation portion of the first pixel 100, and is connected to the contact 120 at the pixel end. In the first pixel array in which the first pixels 100 are arranged in a two-dimensional array, for example, the wirings 118 along a line and a column are arranged and electrically connected to the contacts 120 arranged at the pixel ends at the end of the line and the end of the column, so that it is possible to appropriately output the signal from the first pixel 100.

Note that, as described in some embodiments described above, the contact 120 may be provided at each of the element isolation portions of the second pixel 102 or at an appropriate position. Furthermore, in Fig. 91, the second photoelectric conversion region 124 is separated by the element isolation portion for every second pixel 102, but as described in some embodiments described above, a form may be adopted such that the second photoelectric conversion region 124 is shared by a plurality of second pixels 102.

The light shielding film 114 which is the element isolation portion is an insulator including, for example, rear deep trench isolation (RDTI).

That is, the sensor unit 10 includes the first pixel 100 that has the first photoelectric conversion region that receives light in the visible light band and generates a pixel signal in the visible light band, the second pixel 102 that is formed by being stacked with the first pixel 100 and has the second photoelectric conversion region 124 that receives light in the infrared light band transmitted through the first pixel 100 and generates a pixel signal in the infrared light band, and the wiring layer that is formed between the first pixel 100 and the second pixel 102 and includes the wiring 118 that propagates a signal output from the first pixel 100. In the wiring layer 106, for the first pixel 100 and the second pixel 102 that are stacked, the wiring 118 is arranged below the element isolation portion (light shielding film 114) of the first pixel 100.

With such an arrangement, it is possible to reduce the influence of color mixing in the second pixel 102 and to suppress deterioration in image quality of the infrared light image.

### <17. Modification>

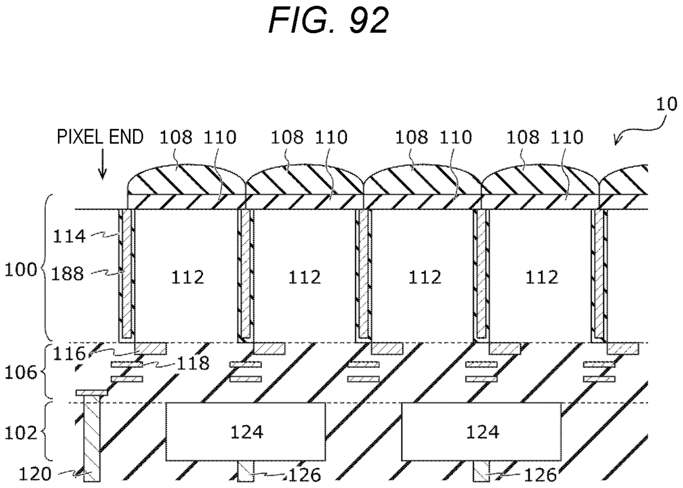

Fig. 92 is a diagram illustrating another example of the present embodiment. As illustrated in Fig. 92, a form may be adopted such that the light shielding film 114 that is the element isolation portion includes a metal film 188 therein. The metal film 188 is electrically insulated from the surroundings by an insulating film at least on the first photoelectric conversion region 112 side and the wiring layer 106 side.

As an example, the metal film 188 may be in a floating state.

As another example, a form may be adopted in which the metal film 188 is appropriately connected to a contact at an arbitrary portion, for example, at the pixel end of the first pixel 100 and is controlled to an arbitrary potential such as a ground potential.

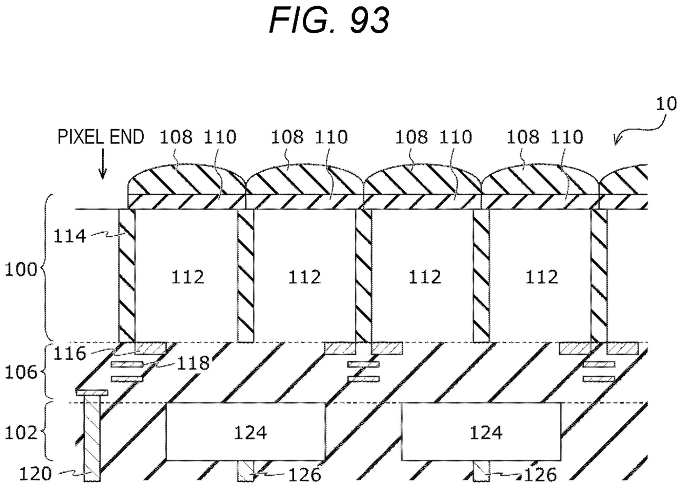

Fig. 93 is a diagram illustrating another example of the present embodiment. As illustrated in Fig. 93, in a case where one second pixel 102 is provided for two first pixels 100 in the cross section, a form can be adopted such that the wiring 118 is not arranged below the element isolation portion of the first pixel 100 on the upper side of the second photoelectric conversion region 124.

Similarly, even in a case where a larger number of first pixels 100 are stacked on the same second pixel 102, a form can be adopted such that the wiring 118 is not provided below the element isolation portion of the first pixel 100 within a range in which output of a signal from the first pixel 100 and supply of power to the first pixel 100 can be appropriately realized.

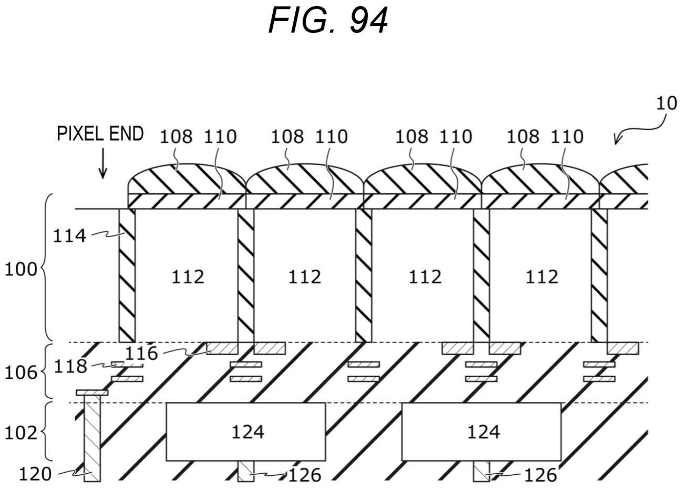

Fig. 94 is a diagram illustrating another example of the present embodiment. As illustrated in this drawing, in a case where two first pixels 100 are stacked on the upper side of one second pixel 102 in the cross section, a form may be adopted such that the pixel transistor 116 is arranged around the element isolation portions of the two first pixels 100.

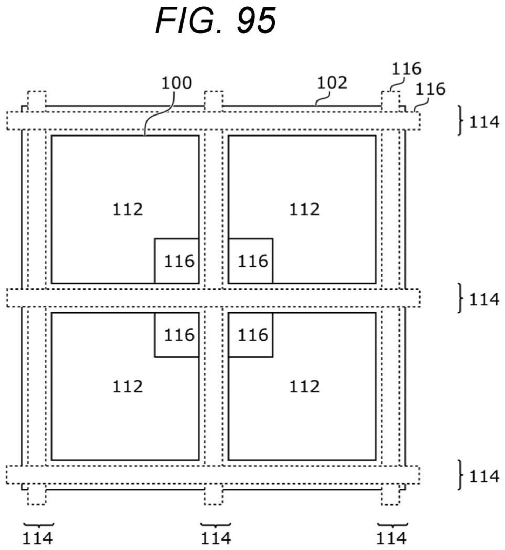

Fig. 95 is a partially transparent top view of the form of Fig. 94. A dotted line indicates the wiring 118, and parentheses indicate that a pixel isolation portion is arranged in the region in the first pixel 100.

As illustrated in this drawing, for example, in a case where 2×2 first pixels 100 are stacked on the second pixel 102, the pixel transistor 116 can be arranged close to the central portion of these first pixels 100. According to this arrangement, it is also easy to share a floating diffusion region in the first pixel 100.

### <18. Manufacturing process of first pixel and wiring>

In the manufacturing process of the embodiment described above and highly, the sensor unit 10 according to the present embodiment and the modification can be manufactured by forming the light shielding film 114 as the RDTI by the DTI or the like and appropriately controlling the arrangement of the wiring 118, the contact 120, and the like.

In all the above embodiments, as described at the beginning of the form for carrying out the invention, there are portions where the configuration in the pixel and the configuration of the wiring and the like are omitted, but this omission is intended to avoid complexity in the description, and the basic configuration of the pixel and the wiring is included. In the embodiment of the present disclosure, a configuration for functioning as a solid-state imaging device is appropriately provided even in a range not described.

Furthermore, also in the manufacturing process, for example, processes such as the formation of the electrode of the pixel and the formation of the diffusion layer in the pixel are omitted, but this omission is intended to easily describe the process of the characteristic portion in the present disclosure. Therefore, basic pixel formation, transistor formation, formation of various conductor films, semiconductor films, insulating films, and manufacturing processes of electrodes and the like are omitted, and components for functioning as the solid-state imaging device appropriately exist as manufacturing processes even in a range not described.

The device according to the above-described embodiment may have the following forms.

### (A1)

A solid-state imaging device including:
a first pixel that receives light in a visible light band and generates a pixel signal in a visible light band;
a second pixel that is formed by being stacked with the first pixel, and receives light in an infrared light band transmitted through the first pixel and generates a pixel signal in an infrared light band;
a wiring layer that is formed between the first pixel and the second pixel and includes a wiring that propagates a signal output from the first pixel; and
an infrared light transmission filter on a light incident surface of the second pixel.

### (A2)

The solid-state imaging device according to (A1), in which
the infrared light transmission filter
is formed between a bonding surface between the wiring layer and the second pixel.

### (A3)

The solid-state imaging device according to (A1), in which
the infrared light transmission filter
is formed in the wiring layer.

### (A4)

The solid-state imaging device according to (A1), in which
the infrared light transmission filter
is formed between a bonding surface between the first pixel and the wiring layer.

### (A5)

The solid-state imaging device according to any one of (A1) to (A4), in which
the infrared light transmission filter
includes a combination of a material having a characteristic of absorbing or reflecting light in a visible light band depending on a wavelength or a material having a characteristic of reflecting the light in the visible light band.

### (A6)

The solid-state imaging device according to (A5), in which
the infrared light transmission filter
is formed by alternately stacking amorphous silicon and silicon dioxide one or more times.

### (A7)

The solid-state imaging device according to any one of (A1) to (A4), in which
the infrared light transmission filter
includes a material having a characteristic of absorbing light in a visible light band.

### (A8)

The solid-state imaging device according to (A7), in which
the infrared light transmission filter
includes indium phosphorus.

### (A9)

The solid-state imaging device according to any one of (A1) to (A4), in which
the infrared light transmission filter
includes a transition metal dichalcogenide material.

### (A10)

The solid-state imaging device according to (A9), in which
the infrared light transmission filter
has a thickness of 1 [nm] or more and 200 [nm] or less.

### (A11)

The solid-state imaging device according to any one of (A1) to (A8), including:
a chalcogenide layer including a transition metal dichalcogenide material, on a light incident surface side of the infrared light transmission filter.

### (A12)

The solid-state imaging device according to (A11), in which
the chalcogenide layer
has a thickness of 1 [nm] or more and 200 [nm] or less.

### (A13)

The solid-state imaging device according to (A9) or (A11), in which
the transition metal dichalcogenide material
is molybdenum diselenide.

The above-described solid-state imaging device can be manufactured by the following manufacturing method.

### (B1)

A manufacturing method of a solid-state imaging device, in which
in a first substrate,
a first pixel that receives visible light is formed, and
a wiring layer including a wiring that propagates a signal of the first pixel is formed on an upper surface of the first pixel,
in a second substrate,
a second pixel that receives infrared light is formed, and
an infrared light transmission filter that transmits infrared light is formed on an upper surface of the second pixel, and
the first substrate and the second substrate are stacked by bonding an upper surface of the wiring layer and an upper surface of the infrared light transmission filter.

### (B2)

A manufacturing method of a solid-state imaging device, in which
in a first substrate,
a first pixel that receives visible light is formed,
a wiring layer including a wiring that propagates a signal of the first pixel is formed on an upper surface of the first pixel, and
an infrared light transmission filter that transmits infrared light is formed on an upper surface of the wiring layer,
in a second substrate,
a second pixel that receives infrared light is formed, and
the first substrate and the second substrate are stacked by bonding an upper surface of the infrared light transmission filter and an upper surface of the second pixel.

### (B3)

A manufacturing method of a solid-state imaging device, in which
in a first substrate,
a first pixel that receives visible light is formed,
a wiring layer including a wiring that propagates a signal of the first pixel is formed on an upper surface of the first pixel, and
a first infrared light transmission filter that transmits infrared light is formed on an upper surface of the wiring layer,
in a second substrate,
a second pixel that receives infrared light is formed, and
a second infrared light transmission filter that transmits infrared light is formed on an upper surface of the second pixel, and
the first substrate and the second substrate are stacked by bonding an upper surface of the first infrared light transmission filter and an upper surface of the second infrared light transmission filter.

### (B4)

A manufacturing method of a solid-state imaging device, in which
in a first substrate,
a first pixel that receives visible light is formed,
a first wiring layer including a wiring that propagates a signal of the first pixel is formed on an upper surface of the first pixel, and
an infrared light transmission filter that transmits infrared light is formed on an upper surface of the first wiring layer, and
a second wiring layer that is connected to a wiring of the first wiring layer is formed on an upper surface of the infrared light transmission filter,
in a second substrate,
a second pixel that receives infrared light is formed, and
the first substrate and the second substrate are stacked by bonding an upper surface of the second wiring layer and an upper surface of the second pixel.

### (B5)

A manufacturing method of a solid-state imaging device, in which
in a first substrate,
a first pixel that receives visible light is formed,
an infrared light transmission filter that transmits infrared light is formed on an upper surface of the first pixel, and
a wiring layer including a wiring that propagates a signal of the first pixel is formed on an upper surface of the infrared light transmission filter,
in a second substrate,
a second pixel that receives infrared light is formed, and
the first substrate and the second substrate are stacked by bonding an upper surface of the wiring layer and an upper surface of the second pixel.

### (B6)

The manufacturing method according to any one of (B1) to (B5), in which
the infrared light transmission filter
is formed by stacking amorphous silicon and silicon dioxide one or more times.

### (B7)

A manufacturing method of a solid-state imaging device, in which
in a first substrate,
a first pixel that receives visible light is formed, and
a wiring layer including a wiring that propagates a signal of the first pixel is formed on an upper surface of the first pixel,
in a second substrate,
a second pixel that receives infrared light is formed, and
an infrared light transmission filter that transmits infrared light is formed on an upper surface of the second pixel by epitaxial growth, and
the first substrate and the second substrate are stacked by bonding an upper surface of the wiring layer and an upper surface of the infrared light transmission filter.

### (B8)

The manufacturing method according to (B7), in which
the infrared light transmission filter
includes indium phosphorus.

### (B9)

The manufacturing method according to (B5) or (B7), in which
in the second pixel,
a shape of a light receiving region is formed before the first substrate and the second substrate are stacked.

### (B10)

The manufacturing method according to (B5) or (B7), in which
in the second pixel,
a shape of the light receiving region is formed after the first substrate and the second substrate are stacked.

### (B11)

A manufacturing method of a solid-state imaging device, in which
in a first substrate,
a first pixel that receives visible light is formed,
in a second substrate,
a second pixel that receives infrared light is formed,
an infrared light transmission filter that transmits infrared light is formed on an upper surface of the second pixel,
a trench is selectively formed in at least the infrared light transmission filter,
an insulating film is formed on a side surface of the infrared light transmission filter of the trench,
a contact is formed inside the insulating film, and
a wiring layer including a wiring that is connected to the contact is formed on an upper surface of the infrared light transmission filter, and
the first substrate and the second substrate are stacked by bonding an upper surface of the first pixel and the wiring layer.

### (B12)

The manufacturing method according to (B11), in which
the infrared light transmission filter
includes a transition metal chalcogenide material.

### (B13)

The manufacturing method according to (B12), in which
The infrared light transmission filter
is formed to have a thickness of 1 [nm] or more and 200 [nm] or less.

### (B14)

A manufacturing method of a solid-state imaging device, in which
in a first substrate,
a first pixel that receives visible light is formed,
in a second substrate,
a second pixel that receives infrared light is formed,
an infrared light transmission filter that transmits infrared light is formed on an upper surface of the second pixel,
a chalcogenide layer including a transition metal chalcogenide material is formed on an upper surface of the infrared light transmission filter,
a trench selectively is formed at least in the chalcogenide layer,
an insulating film is formed on a side surface of the chalcogenide layer of the trench,
a contact is formed inside the insulating film, and
a wiring layer including a wiring line that is connected to the contact is formed on an upper surface of the chalcogenide layer, and
the first substrate and the second substrate are stacked by bonding an upper surface of the first pixel and the wiring layer.

### (B15)

The manufacturing method according to (B14), in which
the infrared light transmission filter
is formed by stacking amorphous silicon and silicon dioxide one or more times.

### (B16)

The manufacturing method according to (B14), in which
the infrared light transmission filter
includes indium phosphorus.

### (B17)

The solid-state imaging device according to any one of (B14) to (B16), in which
the chalcogenide layer
is formed to have a thickness of 1 [nm] or more and 200 [nm] or less.

### (B18)

The solid-state imaging device according to (B12) or (B17), in which
the chalcogenide layer
includes a thin film of molybdenum diselenide.

Furthermore, the device according to the embodiment of the present disclosure may have the following form as another example.

### (C1)

A solid-state imaging device including:
a first pixel that receives light in a visible light band and generates a pixel signal in a visible light band;
a second pixel that is formed by being stacked with the first pixel, and receives light in an infrared light band transmitted through the first pixel and generates a pixel signal in an infrared light band;
a wiring layer that is formed between the first pixel and the second pixel and includes a wiring that propagates a signal output from the first pixel; and
an infrared light shielding film on at least one side surface of the second pixel.

### (C2)

The solid-state imaging device according to (C1), in which
the infrared light shielding film
is formed on a side surface of the photoelectric conversion region of the second pixel via an insulating film.

### (C3)

The solid-state imaging device according to (C2), in which
the infrared light shielding film
includes the same material as the contact electrode.

### (C4)

The solid-state imaging device according to (C2) or (C3), in which
the infrared light shielding film
is formed on the same surface side as the incident surface of the second pixel between the adjacent second pixels.

### (C5)

The solid-state imaging device according to any one of (C2) to (C4), in which
the infrared light shielding film
is formed on a surface of the photoelectric conversion region of the second pixel on a side opposite to the incident surface of the second pixel.

### (C6)

The solid-state imaging device according to any one of (C1) to (C5), in which
the second pixels
is formed such that at least two of the second pixels are adjacent to each other, and
includes the infrared light shielding film on adjacent side surfaces.

### (C7)

The solid-state imaging device according to any one of (C1) to (C6), in which
the second pixel
receives a voltage on an incident surface side from a transparent electrode connected to a photoelectric conversion film region of the second pixel, and
the transparent electrode
is electrically connected to a contact electrode at a position away from the second pixel.

### (C8)

The solid-state imaging device according to any one of (C1) to (C6), in which
the second pixel
receives a voltage on an incident surface side from a transparent electrode connected to a photoelectric conversion film region of the second pixel, and
the transparent electrode
is electrically connected to a contact electrode at a position in contact with a plurality of the adjacent second pixels via the infrared light shielding film.

### (C9)

The solid-state imaging device according to (C4), in which
the contact electrode
includes a material having a light shielding property.

### (C10)

The solid-state imaging device according to (C9), in which
the contact electrode
is copper, titanium, aluminum, or tungsten.

### (C11)

The solid-state imaging device according to any one (C4), (C9), or (C10), in which
the contact electrode
is shared and used by a plurality of second pixels.

### (C12)

The solid-state imaging device according to (C4) or any one of (C9) to (C11) depending on (C4), in which
at least one of the infrared light shielding films including the same material as that of the contact electrode
is in an electrically floating state.

### (C13)

The solid-state imaging device according to (C4) or any one of (C9) to (C11) depending on (C4), in which
at least one of the infrared light shielding films including the same material as that of the contact electrode
is grounded.

### (C14)

The solid-state imaging device according to any one of (C1) to (C13), further including:
at least one of the infrared light transmission filter or the chalcogenide layer according to any one of (A1) to (A13).

The above-described solid-state imaging device can be manufactured by the following manufacturing method.

### (D1)

A manufacturing method of a solid-state imaging device including
a first pixel that receives light in a visible light band and generates a pixel signal in a visible light band, and
a second pixel that is formed by being stacked with the first pixel, and receives light in an infrared light band transmitted through the first pixel and generates a pixel signal in an infrared light band, in which
the solid-state imaging device is manufactured by the manufacturing method including a process in which
after a photoelectric conversion region of the second pixel is formed,
a sidewall of the photoelectric conversion region is formed, and
an infrared light shielding film is formed on a side surface of the sidewall of the photoelectric conversion region.

### (D2)

The manufacturing method of the solid-state imaging device according to (D1), in which
after the photoelectric conversion region of the second pixel is formed,
an insulating film is formed on an upper surface and a side surface of the photoelectric conversion region,
an electrode electrically connected to the photoelectric conversion region is formed on the upper surface of the photoelectric conversion region, and a first infrared light shielding film is formed on a side surface of the insulating film on the side surface,
an insulating film is formed on an upper surface of the electrode electrically connected to the photoelectric conversion region and a side surface of the first infrared light shielding film, and
the upper surface and a sidewall of the photoelectric conversion region are formed.

### (D3)

The manufacturing method of the solid-state imaging device according to (D1) or (D2), in which
after a sidewall of the photoelectric conversion region is formed,
a metal film is formed as a second infrared light shielding film adjacent to the sidewall of the photoelectric conversion region.

### (D4)

The manufacturing method of the solid-state imaging device according to (D3), in which
the two-infrared light shielding film
is formed at the same timing as formation of an electrode that supplies power to the first pixel or the second pixel.

### (D5)

The manufacturing method of the solid-state imaging device according to any one of (D1) to (D4), in which
after a sidewall of the photoelectric conversion region is formed,
a metal film is formed as a second infrared light shielding film in a region away from the sidewall of the photoelectric conversion region by a predetermined distance.

### (D6)

The manufacturing method of the solid-state imaging device according to any one of (D1) to (D5), in which
in a process in which the sidewall of the photoelectric conversion region is formed,
an insulating film is formed on a plane of an incident surface of the photoelectric conversion region,
a first infrared light shielding film is formed on an upper surface of the insulating film on the plane, and
an insulating film is formed on an upper surface of the first infrared light shielding film.

### (D7)

The manufacturing method of the solid-state imaging device according to (D2) or any one of (D3) to (D6) depending on (D2), in which
at least two of the second pixels are formed adjacent to each other, and
the first infrared light shielding film is formed between the second pixels adjacent to each other.

The manufacturing method of the solid-state imaging device according to any one of (D3) to (D5), or (D6) or (D7) depending on any one of (D3) to (D5), in which
at least two of the second pixels are formed adjacent to each other, and
the second infrared light shielding film is formed between the second pixels adjacent to each other.

### (D8)

The manufacturing method of the solid-state imaging device according to any one of (D1) to (D7), in which
after sidewalls of the photoelectric conversion region and the photoelectric conversion region are formed,
an insulating film is formed on a surface opposite to an incident surface of the photoelectric conversion region, and
the first infrared light shielding film is formed on an upper surface of the insulating film.

### (D9)

The manufacturing method of the solid-state imaging device according to any one of (D1) to (D8), including
a process of forming at least one of the infrared light transmission filter or the chalcogenide layer according to any one of (B1) to (B18).

Furthermore, the device according to the embodiment of the present disclosure may have the following form as another example.

### (E1)

A solid-state imaging device including:
a first pixel that includes a first photoelectric conversion region that receives light in a visible light band and generates a pixel signal in a visible light band;
a second pixel that is formed by being stacked with the first pixel and includes a second photoelectric conversion region that receives light in an infrared light band transmitted through the first pixel and generates a pixel signal in an infrared light band; and
a wiring layer that is formed between the first pixel and the second pixel and includes a wiring that propagates a signal output from the first pixel, in which
the wiring layer includes
the wiring in a region that is not between the first photoelectric conversion region and the second photoelectric conversion region, for the first pixel and the second pixel that are stacked.

### (E2)

The solid-state imaging device according to (E1), in which
the wiring is metal.

### (E3)

The solid-state imaging device according to (E1) or (E2), in which
the wiring layer
does not include, for the first pixel and the second pixel that are stacked, the wiring between the first photoelectric conversion region and the second photoelectric conversion region.

### (E4)

The solid-state imaging device according to any one of (E1) to (E3), in which
the wiring layer
includes
for the first pixel and the second pixel that are stacked, a hole that transmits light in an infrared light band transmitted through the first pixel between the first photoelectric conversion region and the second photoelectric conversion region.

### (E5)

The solid-state imaging device according to (E4), in which
the hole has an antireflection film.

### (E6)

The solid-state imaging device according to (E4) or (E5), in which
the hole has a film different from an insulating film filling the wiring layer.

### (E7)

The solid-state imaging device according to (E6), in which
the film of the hole which is different from the insulating film filling the wiring layer is a semiconductor film.

### (E8)

The solid-state imaging device according to any one of (E4) to (E7), in which
the hole totally reflects infrared light at a boundary with the insulating film filling the wiring layer.

### (E9)

The solid-state imaging device according to any one of (E1) to (E8), in which
the hole has a rectangular shape in a cross section.

### (E10)

The solid-state imaging device according to any one of (E1) to (E8), in which
the hole has an elliptical shape or a rounded rectangular shape in a cross section.

### (E11)

The solid-state imaging device according to any one of (E1) to (E8), in which
the hole has a rectangular shape having a taper in a cross section.

### (E12)

The solid-state imaging device according to any one of (E1) to (E11), in which
in the wiring layer,
an uneven shape is further formed by an insulating film of a different material.

### (E13)

The solid-state imaging device according to any one of (E1) to (E12), further including:
at least one of at least one of the infrared light transmission filter or the chalcogenide layer according to any one of (A1) to (A13), or the infrared light transmission film according to any one of (C1) to (C13).

The above-described solid-state imaging device can be manufactured by the following manufacturing method.

### (F1)

A manufacturing method of a solid-state imaging device including
a first pixel that receives light in a visible light band and generate a pixel signal in a visible light band,
a second pixel that is formed by being stacked with the first pixel, and receives light in an infrared light band transmitted through the first pixel and generates a pixel signal in an infrared light band, in which
in a wiring layer that is arranged between the first pixel and the second pixel,
a wiring that propagates a signal from the first pixel is formed so as not to overlap with an incident surface of a photoelectric conversion region of the second pixel.

### (F2)

The manufacturing method of the solid-state imaging device according to (F1), in which
in the wiring layer,
a hole is formed so as to overlap with the incident surface of the photoelectric conversion region of the second pixel.

### (F3)

The manufacturing method of the solid-state imaging device according to (F2), in which
in the wiring layer,
a metal wiring is formed in a region where the wiring is to be formed, and a dummy metal wiring is formed in a region where the hole is to be formed,
an insulating film is formed on upper surfaces of the region where the wiring is to be formed and the region where the hole is to be formed, and
the dummy metal wiring is selectively removed.

### (F4)

The manufacturing method of the solid-state imaging device according to (F3), in which
the selective removal means that
the insulating film that is formed on the upper surfaces of the region where the wiring is to be formed and the region where the hole is to be formed is selectively removed in at least a partial region of the region where the hole is to be formed, and
the dummy metal wiring that is formed in the region where the hole is to be formed is removed by performing etching processing from a region where the insulating film is selectively removed.

### (F5)

The manufacturing method of the solid-state imaging device according to (F4), in which
the region where the wiring is to be formed is formed so as not to be connected to the at least partial region, and the region where the hole is to be formed is formed so as to be connected to the at least partial region.

### (F6)

The manufacturing method of the solid-state imaging device according to (F3) or (F4), in which
the wiring is formed by
selectively removing an insulating film in a region where the wiring is to be formed,
forming a barrier metal in a region of the removed insulating film, and
forming the metal wiring in the region of the removed insulating film via the barrier metal.

### (F7)

The manufacturing method of the solid-state imaging device according to (F6), in which
the hole is formed by
selectively removing an insulating film in a region where the hole is to be formed, in the process of forming the wiring,
forming the barrier metal in a region of the removed insulating film,
forming the dummy metal wiring in a region of the removed insulating film via the barrier metal, and
removing the dummy metal wiring, and
the barrier metal is an antireflection film.

### (F8)

The manufacturing method of the solid-state imaging device according to (F6), in which
the hole is formed by
selectively removing an insulating film in a region where the hole is to be formed, in the process of forming the wiring,
forming the barrier metal in a region of the removed insulating film,
forming the dummy metal wiring in a region of the removed insulating film via the barrier metal, and
removing the dummy metal wiring and the barrier metal.

### (F9)

The manufacturing method of the solid-state imaging device according to (F8), in which
an antireflection film is formed in the formed hole.

### (F10)

The manufacturing method of the solid-state imaging device according to any one of (F2) to (F9), in which
an insulating film of an insulating material different from that of the insulating film forming the wiring layer is formed in the hole.

### (F11)

The manufacturing method of the solid-state imaging device according to (F5), in which
the wiring and the hole are formed over a plurality of stages.

### (F12)

The manufacturing method of the solid-state imaging device according to (F11), in which
the hole
is removed at the same timing over a plurality of stages.

### (F13)

The manufacturing method of the solid-state imaging device according to (F11), in which
the hole
is removed at every stage.

### (F14)

The manufacturing method of the solid-state imaging device according to (F11), in which
in at least an uppermost portion in the hole formed in a plurality of stages,
an insulating film of a material different from the insulating film filling the wiring layer is formed.

### (F15)

The manufacturing method of the solid-state imaging device according to any one of (F1) to (F14), in which
the hole has a rectangular shape in a cross section.

### (F16)

The manufacturing method of the solid-state imaging device according to any one of (F1) to (F14), in which
the hole has an elliptical shape or a rounded rectangular shape in a cross section.

### (F17)

The manufacturing method of the solid-state imaging device according to any one of (F1) to (F14), in which
the hole has a rectangular shape having a taper in a cross section.

### (F18)

The manufacturing method of the solid-state imaging device according to any one of (F1) to (F17), including:
a process of manufacturing at least one of at least one of the infrared light transmission filter or the chalcogenide layer according to any one of (B1) to (B18), or the infrared light transmission film according to any one of (D1) to (D8).

Furthermore, the device according to the embodiment of the present disclosure may have the following form as another example.

### (G1)

A solid-state imaging device including:
a first pixel that receives light in a visible light band and generates a pixel signal in a visible light band;
a second pixel that is formed by being stacked with the first pixel, and receives light in an infrared light band transmitted through the first pixel and generates a pixel signal in an infrared light band; and
a wiring layer that is formed between the first pixel and the second pixel and includes a wiring that propagates a signal output from the first pixel, in which
the second pixel includes
a first electrode that is located on an incident surface side of a photoelectric conversion region, and
a second electrode that is located on a surface opposite to the incident surface of the photoelectric conversion region.

### (G2)

The solid-state imaging device according to (G1), in which
the first electrode is a transparent electrode.

### (G3)

The solid-state imaging device according to (G1) or (G2), in which
the first electrode is a semiconductor film.

### (G4)

The solid-state imaging device according to (G1), in which
the first electrode is a metal electrode.

### (G5)

The solid-state imaging device according to any one of (G1) to (G4), further including:
a first contact that is connected to the first pixel, supplies power to the first pixel, or acquires a signal from the first pixel, in which
the first contact is formed in an element isolation portion between the second photoelectric conversion regions.

### (G6)

The solid-state imaging device according to any one of (G1) to (G5), further including:
a second contact that is connected to the first electrode, in which
the second contact is formed in an element isolation portion between the second photoelectric conversion regions.

### (G7)

The solid-state imaging device according to any one of (G1) to (G6), in which
each of the second pixels includes the separate second photoelectric conversion region.

### (G8)

The solid-state imaging device according to any one of (G1) to (G4), in which
a plurality of the second pixels shares the second photoelectric conversion region, and
is formed in an element isolation portion between the second photoelectric conversion regions.

### (G9)

The solid-state imaging device according to any one of (G1) to (G8), further including:
at least one of at least one of the infrared light transmission filter or the chalcogenide layer according to any one of (A1) to (A13), the infrared light transmission film according to any one of (C1) to (C13), or a configuration of the wiring layer according to any one of (E1) to (E12).

The above-described solid-state imaging device can be manufactured by the following manufacturing method.

### (H1)

A manufacturing method of a solid-state imaging device including
a first pixel that receives light in a visible light band and generate a pixel signal in a visible light band,
a second pixel that is formed by being stacked with the first pixel, and receives light in an infrared light band transmitted through the first pixel and generates a pixel signal in an infrared light band, in which
after a photoelectric conversion region in the second pixel is formed,
a first electrode is formed on an upper surface of the photoelectric conversion region,
an insulating film is formed on an upper surface of the first electrode,
a vertical inversion is performed such that the insulating film faces downward,
the photoelectric conversion region is selectively removed,
the first electrode is selectively removed in a region from which the photoelectric conversion region has been selectively removed,
an insulator layer is formed in the photoelectric conversion region selectively removed and a region of the first electrode selectively removed, and
a contact electrically connected to the first electrode is formed in the insulator layer.

### (H2)

A manufacturing method of a solid-state imaging device including
a first pixel that receives light in a visible light band and generate a pixel signal in a visible light band,
a second pixel that is formed by being stacked with the first pixel, and receives light in an infrared light band transmitted through the first pixel and generates a pixel signal in an infrared light band, in which
after a photoelectric conversion region in the second pixel is formed,
a first electrode is formed on an upper surface of the photoelectric conversion region,
an insulating film is formed on an upper surface of the first electrode,
a vertical inversion is performed such that the insulating film faces downward,
the photoelectric conversion region and the first electrode are selectively removed,
an insulator layer is formed in a region selectively removed,
a contact is formed in the insulator layer,
a vertical inversion is performed again such that the insulating film faces upward, and
a third electrode electrically connected to the contact and the first electrode is formed.

### (H3)

The manufacturing method of the solid-state imaging device according to (H1) or (H2), in which
after the vertical inversion is performed such that the insulating film faces downward,
a second electrode is selectively formed on the upper surface of the photoelectric conversion region.

### (H4)

The manufacturing method of the solid-state imaging device according to any one of (H1) to (H3), in which
the first electrode is a transparent electrode.

### (H5)

The solid-state imaging device according to (H4), in which
the transparent electrode is a semiconductor film.

### (H6)

The solid-state imaging device according to (H4), in which
the transparent electrode is a metal electrode.

### (H7)

The manufacturing method of the solid-state imaging device according to any one of (H1) to (H6), including:
a process of manufacturing at least one of at least one of the infrared light transmission filter or the chalcogenide layer according to any one of (B1) to (B18), the infrared light transmission film according to any one of (D1) to (D8), or the wiring layer formed between the first pixel and the second pixel according to any one of (F1) to (F17).

Furthermore, the device according to the embodiment of the present disclosure may have the following form as another example.

(I1)
A solid-state imaging device including:
a first pixel that includes a first photoelectric conversion region that receives light in a visible light band and generates a pixel signal in a visible light band;
a second pixel that is formed by being stacked with the first pixel and includes a second photoelectric conversion region that receives light in an infrared light band transmitted through the first pixel and generates a pixel signal in an infrared light band; and
a wiring layer that is formed between the first pixel and the second pixel and includes a wiring that propagates a signal output from the first pixel, in which
the wiring layer includes
the wiring below an element isolation portion of the first pixel, for the first pixel and the second pixel that are stacked.

(I2)
The solid-state imaging device according to (I1), in which
the wiring that propagates the signal from the first pixel is formed above the pixel isolation portion of the second pixel.

(I3)
The solid-state imaging device according to (I1), in which
the wiring that propagates the signal from the first pixel is output via a contact formed at an end portion of a region where the second pixel is arranged.

(I4)
The solid-state imaging device according to (I2), in which
the wiring that propagates the signal from the first pixel is output via a contact formed in the pixel isolation of the second pixel.

(I5)
The solid-state imaging device according to any one of (I1) to (I4), in which
the element isolation portion of the first pixel is RDTI.

(I6)
The solid-state imaging device according to any one of (I1) to (I4), in which
the element isolation portion of the first pixel is RDTI in which metal is embedded.

(I7)
The solid-state imaging device according to any one of (I1) to (I6), in which
the number of the first pixels stacked on one of the second pixel is plural.

(I8)
The solid-state imaging device according to any one of (I1) to (I7), further including:
at least one of at least one of the infrared light transmission filter or the chalcogenide layer according to any one of (A1) to (A13), the infrared light transmission film according to any one of (C1) to (C13), a configuration of the wiring layer according to any one of (E1) to (E12), or the first electrode and the second electrode according to any one of (G1) to (G8).

The above-described solid-state imaging device can be manufactured by the following manufacturing method.

### (J1)

A manufacturing method of a solid-state imaging device including
a first pixel that receives light in a visible light band and generate a pixel signal in a visible light band,
a second pixel that is formed by being stacked with the first pixel, and receives light in an infrared light band transmitted through the first pixel and generates a pixel signal in an infrared light band, in which
in a wiring layer that is arranged between the first pixel and the second pixel,
a wiring that propagates a signal from the first pixel is formed so as to overlap with an element isolation portion of the first pixel.

### (J2)

The manufacturing method of the solid-state imaging device according to (J1), including
a process of manufacturing at least one of at least one of the infrared light transmission filter or the chalcogenide layer according to any one of (B1) to (B18), the infrared light transmission film according to any one of (D1) to (D8), the wiring layer formed between the first pixel and the second pixel according to any one of (F1) to (F17), or the first electrode and the second electrode according to any one of (H1) to (H6).

Aspects of the present disclosure are not limited to the above-described embodiments, and include various conceivable modifications. The effects of the present disclosure are not limited to the above-described contents. The components in each of the embodiments may be appropriately combined and applied. That is, various additions, modifications, and partial deletions can be made without departing from the conceptual idea and gist of the present disclosure derived from the contents defined in the claims and equivalents and the like thereof.

### REFERENCE SIGNS LIST

- 1: Solid-state imaging device
- 10: Sensor unit
- 100: First pixel
- 102: Second pixel
- 104: Infrared light transmission filter
- 106: Wiring layer
- 108: On-chip lens
- 110: Color filter
- 112: First photoelectric conversion region
- 114: Light shielding film
- 116: Pixel transistor
- 118: Wiring
- 120: Contact
- 122: Insulating film
- 124: Second photoelectric conversion region
- 126: Contact
- 128: Contact
- 130: Metal wiring layer
- 132: InGaAs layer
- 134: InP layer
- 136: TMD film
- 138: Wiring
- 140: Insulating film
- 142: Contact
- 144: Insulating film
- 146: Infrared light shielding film
- 148: Electrode
- 150: Contact
- 152: Contact
- 154: Transparent electrode
- 156: Hole
- 158: Antireflection film
- 160: Insulating film
- 162: Insulating film
- 164: Insulating film
- 166: Color filter
- 168: Dummy wiring
- 170: Mask
- 172: Transparent electrode
- 174: Transparent insulating film
- 176: First diffusion layer
- 178: Second diffusion layer
- 180: Electrode
- 182: Diffusion region
- 184: Protective film
- 186: Interlayer insulating film
- 188: Metal film
- 12: First substrate
- 14: Second substrate
- 16: Transfer substrate
- 20: Control unit
- 22: Power supply unit
- 24: Storage unit
- 26: Signal processing unit
- 28: I/F

## Claims

1. A solid-state imaging device comprising:
a first pixel that receives light in a visible light band and generates a pixel signal in a visible light band;
a second pixel that is formed by being stacked with the first pixel, and receives light in an infrared light band transmitted through the first pixel and generates a pixel signal in an infrared light band;
a wiring layer that is formed between the first pixel and the second pixel and includes a wiring that propagates a signal output from the first pixel; and
an infrared light transmission filter on a light incident surface of the second pixel.

2. The solid-state imaging device according to claim 1, wherein
the infrared light transmission filter is formed between a bonding surface between the wiring layer and the second pixel.

3. The solid-state imaging device according to claim 1, wherein
the infrared light transmission filter is formed in the wiring layer.

4. The solid-state imaging device according to claim 1, wherein
the infrared light transmission filter is formed between a bonding surface between the first pixel and the wiring layer.

5. The solid-state imaging device according to claim 1, wherein
the infrared light transmission filter includes a combination of a material having a characteristic of absorbing or reflecting light in a visible light band depending on a wavelength or a material having a characteristic of reflecting the light in the visible light band.

6. The solid-state imaging device according to claim 5, wherein
the infrared light transmission filter is formed by alternately stacking amorphous silicon and silicon dioxide one or more times.

7. The solid-state imaging device according to claim 1, wherein
the infrared light transmission filter includes a material having a characteristic of absorbing light in a visible light band.

8. The solid-state imaging device according to claim 7, wherein
the infrared light transmission filter includes indium phosphorus.

9. The solid-state imaging device according to claim 1, wherein
the infrared light transmission filter includes a transition metal dichalcogenide material.

10. The solid-state imaging device according to claim 9, wherein
the infrared light transmission filter has a thickness of 1 [nm] or more and 200 [nm] or less.

11. The solid-state imaging device according to claim 1, comprising:
a chalcogenide layer including a transition metal dichalcogenide material, on a light incident surface side of the infrared light transmission filter.

12. The solid-state imaging device according to claim 11, wherein
the chalcogenide layer has a thickness of 1 [nm] or more and 200 [nm] or less.

13. The solid-state imaging device according to claim 9, wherein
the transition metal dichalcogenide material is molybdenum diselenide.

14. A solid-state imaging device comprising:
a first pixel that receives light in a visible light band and generates a pixel signal in a visible light band;
a second pixel that is formed by being stacked with the first pixel, and receives light in an infrared light band transmitted through the first pixel and generates a pixel signal in an infrared light band;
a wiring layer that is formed between the first pixel and the second pixel and includes a wiring that propagates a signal output from the first pixel; and
an infrared light shielding film on at least one side surface of the second pixel.

15. A solid-state imaging device comprising:
a first pixel that includes a first photoelectric conversion region that receives light in a visible light band and generates a pixel signal in a visible light band;
a second pixel that is formed by being stacked with the first pixel and includes a second photoelectric conversion region that receives light in an infrared light band transmitted through the first pixel and generates a pixel signal in an infrared light band; and
a wiring layer that is formed between the first pixel and the second pixel and includes a wiring that propagates a signal output from the first pixel, wherein
the wiring layer includes
the wiring in a region that is not between the first photoelectric conversion region and the second photoelectric conversion region, for the first pixel and the second pixel that are stacked.

16. A solid-state imaging device comprising:
a first pixel that receives light in a visible light band and generates a pixel signal in a visible light band;
a second pixel that is formed by being stacked with the first pixel, and receives light in an infrared light band transmitted through the first pixel and generates a pixel signal in an infrared light band; and
a wiring layer that is formed between the first pixel and the second pixel and includes a wiring that propagates a signal output from the first pixel, wherein
the second pixel includes
a first electrode that is located on an incident surface side of a photoelectric conversion region, and
a second electrode that is located on a surface opposite to the incident surface of the photoelectric conversion region.

17. A solid-state imaging device comprising:
a first pixel that receives light in a visible light band and generates a pixel signal in a visible light band; and
a second pixel that is formed by being stacked with the first pixel, and receives light in an infrared light band transmitted through the first pixel and generates a pixel signal in an infrared light band, wherein
in a wiring layer arranged between the first pixel and the second pixel,
a wiring that propagates a signal from the first pixel is formed below a pixel isolation portion of the first pixel.
